# EUROPEAN PATENT APPLICATION

(11) **EP 4 529 382 A1**
(43) Date of publication of application: **26.03.2025**
(21) Application number: 24199611.5
(22) Date of filing: 10.09.2024
(51) Int. Cl.: H10B 12/00, H10D 30/67

(54) **SEMICONDUCTOR DEVICES**

(30) Priority: 19.09.2023 KR 20230124616
(71) Applicant: Samsung Electronics Co., Ltd., Gyeonggi-do, 16677 (KR)
(72) Inventor: LEE, Hongjun, 16677 Suwon-si (KR); LEE, Kiseok, 16677 Suwon-si (KR); KIM, Huijung, 16677 Suwon-si (KR); SONG, Younggeun, 16677 Suwon-si (KR); LEE, Yongjin, 16677 Suwon-si (KR)
(74) Representative: Marks & Clerk LLP

(57) **Abstract**

A semiconductor device includes bit lines, channels, a first capping pattern, a gate insulation pattern, a gate electrode and capacitors. The bit lines are on a substrate, and each of the bit lines extends in a first direction. The bit lines are spaced apart from each other in a second direction. The channels are spaced apart from each other in the first direction. The first capping pattern is on a sidewall of each of the channels. The gate insulation pattern is on a sidewall of the first capping pattern. The gate electrode is on a sidewall of the gate insulation pattern. The capacitors are electrically connected to respective ones of the channels.

## Description

### BACKGROUND

Example embodiments of the present disclosure relate to a semiconductor device. More particularly, example embodiments of the present disclosure relate to a memory device including a vertical channel.

A memory device including a vertical channel transistor has been developed in order to increase the integration degree of a semiconductor device. The vertical channel transistor includes a channel containing an oxide semiconductor material, and when the semiconductor device is manufactured, the channel may be damaged.

### SUMMARY

Example embodiments provide a semiconductor device having improved electrical characteristics.

According to example embodiments, there is provided a semiconductor device. The semiconductor device may include bit lines, channels, a first capping pattern, a gate insulation pattern, a gate electrode and capacitors. The bit lines may be on a substrate, and each of the bit lines may extend in a first direction substantially parallel to an upper surface of the substrate. The bit lines may be spaced apart from each other in a second direction substantially parallel to the upper surface of the substrate and intersecting the first direction. The channels are on each of the bit lines, and the channels may be spaced apart from each other . The first capping pattern may be on a sidewall of each of the channels. The gate insulation pattern may be on a sidewall of the first capping pattern. The gate electrode may be on a sidewall of the gate insulation pattern. The capacitors may be electrically connected to respective ones of the channels.

According to example embodiments, there is provided a semiconductor device. The semiconductor device may include bit lines, channels, a gate insulation pattern, a gate electrode, capacitors, molds and a first capping pattern. The bit lines may be on a substrate, and each of the bit lines may extend in a first direction substantially parallel to an upper surface of the substrate. The bit lines may be spaced apart from each other in a second direction substantially parallel to the upper surface of the substrate and intersecting the first direction. The channels on each of the bit lines may be spaced apart from each other in the first direction. The gate insulation pattern may be on a first sidewall of each of the channels. The gate electrode may be on a sidewall of the gate insulation pattern. The capacitors may be electrically connected to respective ones of the channels. The molds may be between ones of the channels, and the molds may contact a respective second sidewall of respective ones of the channels. The first capping pattern may contact sidewalls of each of the molds and sidewalls of each of the channels may contact respective ones of the molds.

According to example embodiments, there is provided a semiconductor device. The semiconductor device may include bit lines, bit line shields, channels, a first capping pattern, a gate insulation pattern, a gate electrode, capacitors, molds, second insulation patterns and a second capping pattern. The bit lines may be on a substrate, and each of the bit lines may extend in a first direction substantially parallel to an upper surface of the substrate. The bit lines may be spaced apart from each other in a second direction substantially parallel to the upper surface of the substrate and intersecting the first direction. The bit line shields may be between the bit lines, and each of the bit line shields may extend in the first direction. The channels on each of the bit lines may be spaced apart from each other. The first capping pattern may be on a first sidewall of each of the channels. The gate insulation pattern may be on a sidewall of the first capping pattern. The gate electrode may be on a sidewall of the gate insulation pattern. The capacitors may be electrically connected to respective ones of the channels. The molds may be between ones of the channels on each of the bit lines, and each of the molds may contact a second sidewall of respective ones of the channels. The second insulation patterns may be on each of the bit line shields, and each of the second insulation patterns may be between adjacent ones of the molds . The second capping pattern may be on sidewalls of each of the molds and sidewalls of each of the channels contact adjacent ones of the molds.

In the semiconductor device in accordance with example embodiments, a first capping layer and a mold layer may be sequentially formed on a channel layer, an anisotropic etching process may be performed to divide the channel layer into a plurality of channels, a second capping layer may be formed on the channel, an insulating interlayer may be formed on the second capping layer, and an isotropic etching process may be performed to transform the insulating interlayer into an insulating interlayer pattern. Thus, the channel may be protected by the first and second capping layers during the formation of the channel and subsequent processes, so that the semiconductor device including the channel may have enhanced electrical characteristics.

At least some of the above and other features of the invention are set out in the claims.

### BRIEF DESCRIPTION OF THE DRAWINGS

FIGS. 1 to 4 are a perspective view, a horizontal cross-sectional view and vertical cross-sectional views illustrating a semiconductor device in accordance with example embodiments.
FIGS. 5 to 68 are perspective views, plan views, horizontal cross-sectional views and vertical cross-sectional views illustrating a method of manufacturing a semiconductor device in accordance with example embodiments.
FIGS. 69 to 72 are a perspective view, a horizontal cross-sectional view and vertical cross-sectional views illustrating a semiconductor device in accordance with example embodiments.
FIGS. 73 to 76 are a perspective view, a horizontal cross-sectional view and vertical cross-sectional views illustrating a method of manufacturing a semiconductor device in accordance with example embodiments.
FIGS. 77 to 80 are a perspective view, a horizontal cross-sectional view and vertical cross-sectional views illustrating a semiconductor device in accordance with example embodiments.
FIGS. 81 to 88 are a perspective view, a horizontal cross-sectional view and vertical cross-sectional views illustrating a method of manufacturing a semiconductor device in accordance with example embodiments.
FIGS. 89 to 92 are a perspective view, a horizontal cross-sectional view and vertical cross-sectional views illustrating a semiconductor device in accordance with example embodiments.
FIG. 93 is a perspective view illustrating a semiconductor device in accordance with example embodiments.
FIGS. 94 to 98 are perspective views illustrating a method of manufacturing a semiconductor device in accordance with example embodiments.
FIGS. 99 and 100 are a perspective view and a vertical cross-sectional view illustrating a semiconductor device in accordance with example embodiments.
FIGS. 101 and 102 are a perspective view and a vertical cross-sectional view illustrating a semiconductor device in accordance with example embodiments.

### DETAILED DESCRIPTION

The above and other aspects and features of the semiconductor devices and the methods of manufacturing the same in accordance with example embodiments will become readily understood from detail descriptions that follow, with reference to the accompanying drawings. It will be understood that, although the terms "first," "second," and/or "third", etc. may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third", etc. may be used selectively or interchangeably for each material, layer, region, electrode, pad, pattern, structure or process respectively. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Hereinafter, two directions among horizontal directions that are substantially parallel to an upper surface of a substrate, which may intersect each other, may be referred to as first and second directions D1 and D2, respectively, and a direction substantially perpendicular to the upper surface of the substrate may be referred to as a third direction D3 (e.g. a vertical direction). The third direction D3 may define a height direction. Accordingly, relative height positions (e.g. upper, lower, above, below, etc.) may relate to relative positions along the third direction D3 (e.g. relative distances from the upper surface of the substrate in the third direction D3). In example embodiments, the first and second directions D1 and D2 may be substantially perpendicular to each other. Each of the first to third directions D1, D2 and D3 may include not only a direction shown in the drawing but also a direction that is inverse to the shown direction.

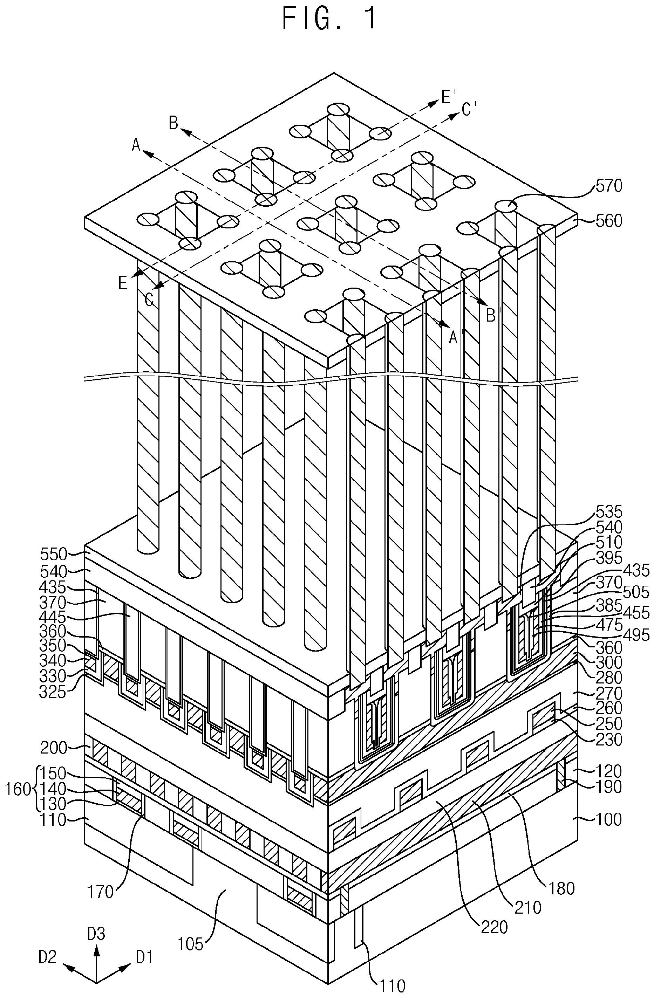

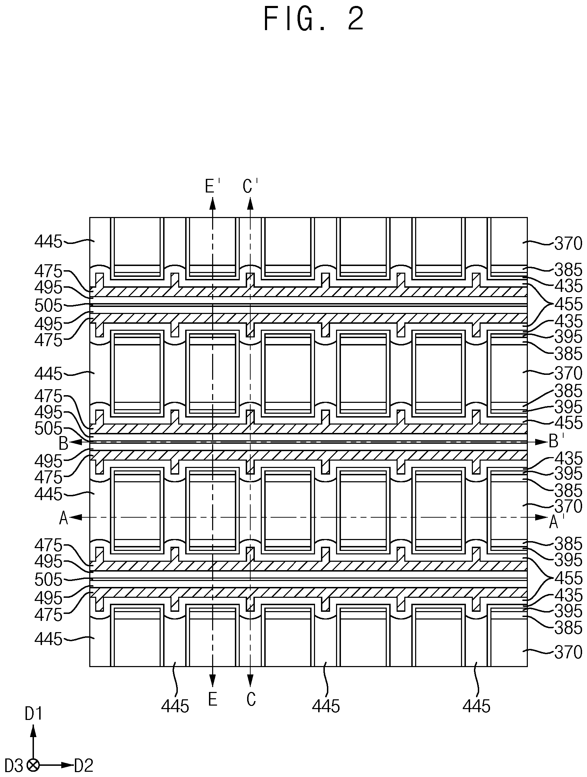

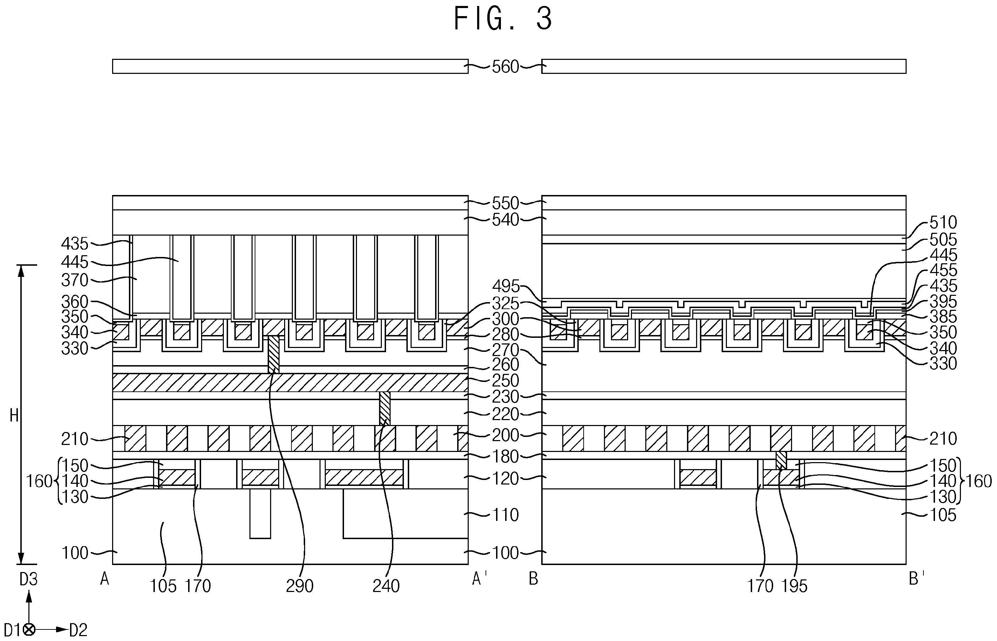

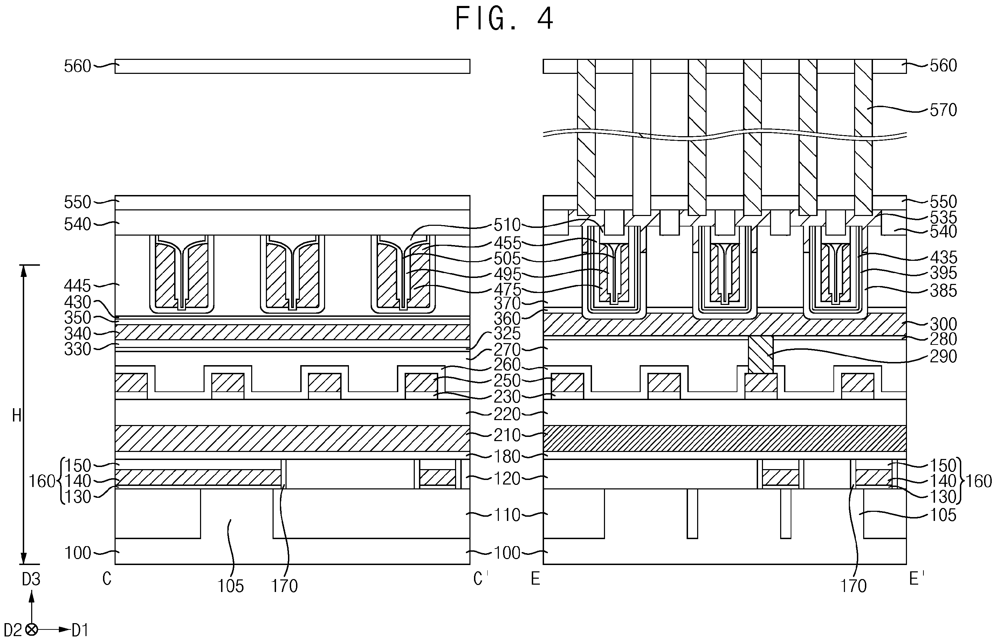

FIGS. 1 to 4 are a perspective view, a horizontal cross-sectional view and vertical cross-sectional views illustrating a semiconductor device in accordance with example embodiments. Specifically, FIG. 1 is the perspective view, FIG. 2 is the horizontal cross-sectional view, FIG. 3 includes cross-sectional views taken along lines A-A' and B-B', respectively, of FIG. 2, and FIG. 4 includes cross-sectional views taken along lines C-C' and E-E', respectively, of FIG. 2. FIG. 2 is the horizontal cross-sectional view at a height H of FIGS. 3 and 4.

Referring to FIGS. 1 to 4, the semiconductor device may include a second gate electrode 475, a second gate insulation pattern 455, a channel 385, first, second and fourth capping patterns 395, 435 and 510, a landing pad 535 and a capacitor 570 on a substrate 100.

The semiconductor device may further include an isolation layer 110, a first gate structure 160, a gate spacer 170, first, second, and third contact plugs 190, 195 and 240, first, second, third, and fourth wirings 210, 250, 300 and 340, a first insulation pattern 230, a second insulation layer 260, a third insulation pattern 280, fifth, sixth, seventh, and eighth insulation patterns 325, 330, 350 and 360, a first mold 370, first, second, third, fourth, and fifth insulating interlayers 120, 180, 200, 220 and 270, sixth, seventh, and eighth insulating interlayer patterns 445, 505 and 540, an etch stop pattern 495, and first and second support layers 550 and 560.

The substrate 100 may include silicon, germanium, silicon-germanium, or a III-V group compound semiconductor, e.g., GaP, GaAs, GaSb, etc. In example embodiments, the substrate 100 may be a silicon-on-insulator (SOI) substrate or a germanium-on-insulator (GOI) substrate.

The isolation layer 110 may be disposed on the substrate 100, and the active region 105 may be defined by the isolation layer 110. The isolation layer 110 may include an oxide, e.g., silicon oxide.

The first gate structure 160 may be disposed on the substrate 100, and may include a first gate insulation pattern 130, a first gate electrode 140 and a gate mask 150 sequentially stacked in the third direction D3, and the gate spacer 170 may be disposed on a sidewall of the first gate structure 160. A plurality of first gate structures 160 may be spaced apart from each other in each of the first and second directions D1 and D2. Each of the first gate structures 160 together with source/drain regions at upper portions of the active region 105 may form a transistor. In example embodiments, the transistor may be a part of a sense amplifier (S/A).

The first gate insulation pattern 130 may include an oxide, e.g., silicon oxide, the first gate electrode 140 may include a conductive material, e.g., a metal, a metal nitride, a metal silicide, doped polysilicon, etc., and each of the gate mask 150 and the gate spacer 170 may include an insulating nitride, e.g., silicon nitride.

The first insulating interlayer 120 may be disposed on the active region 105 and the isolation layer 110, and may cover, overlap, or be on a sidewall of gate spacer 170 on the sidewall of the first gate structure 160.

The second insulating interlayer 180 may be disposed on the first insulating interlayer 120, the first gate structure 160 and the gate spacer 170, the first contact plug 190 may extend through the first and second insulating interlayers 120 and 180 to contact an upper surface of the active region 105, e.g., the source/drain region, and the second contact plug 195 may extend through the second insulating interlayer 180 and the gate mask 150 to contact an upper surface of the first gate electrode 140.

The third insulating interlayer 200 may be disposed on the second insulating interlayer 180 and the first and second contact plugs 190 and 195, and the first wiring 210 may extend through the third insulating interlayer 200. In example embodiments, the first wiring 210 may extend in the first direction D1, and a plurality of first wirings 210 may be spaced apart from each other in the second direction D2. Each of the first wirings 210 may contact an upper surface of a corresponding one of the first and second contact plugs 190 and 195.

The fourth insulating interlayer 220 may be disposed on the third insulating interlayer 200 and the first wiring 210, and the first insulation pattern 230 and the second wiring 250 may be sequentially stacked on the fourth insulating interlayer 220. In example embodiments, each of the first insulation pattern 230 and the second wiring 250 may extend in the second direction D2. A plurality of first insulation patterns 230 may be spaced apart from each other in the first direction D1, and a plurality of second wirings 250 may be spaced apart from each other in the first direction D1.

The third contact plug 240 may extend through the first insulation pattern 230 and the fourth insulating interlayer 220, and may contact an upper surface of a corresponding one of the first wirings 210 and a lower surface of a corresponding one of the second wirings 250.

The second insulation layer 260 may be disposed on the fourth insulating interlayer 220, and may cover, overlap, or be on a sidewall and an upper surface of the second wiring 250 and a sidewall of the first insulation pattern 230.

The fifth insulating interlayer 270 may be disposed on the second insulation layer 260, and may fill a space between neighboring ones of the second wirings 250 in the first direction D1.

The third insulation pattern 280 and the third wiring 300 may be sequentially stacked on the fifth insulating interlayer 270. In example embodiments, each of the third insulation pattern 280 and the third wiring 300 may extend in the first direction D1. A plurality of third insulation patterns 280 may be spaced apart from each other in the second direction D2, and a plurality of third wirings 300 may be spaced apart from each other in the second direction D2. In example embodiments, each of the third wirings 300 may serve as a bit line of the semiconductor device.

The fourth contact plug 290 may extend through the third insulation pattern 280, and upper portion of the fifth insulating interlayer 270 and the second insulation layer 260, and may contact a lower surface of a corresponding one of the third wirings 300 and an upper surface of a corresponding one of the second wirings 250.

The fifth insulation pattern 325 may extend in the first direction D1 between neighboring ones of the third wirings 300 in the second direction D2 and between neighboring ones of the third insulation patterns 280 in the second direction D2, and may contact sidewalls of the third wirings 300 and the third insulation patterns 280. In example embodiments, the fifth insulation pattern 325 may extend through an upper portion of the fifth insulating interlayer 270, and thus a lower surface of the fifth insulation pattern 325 may be lower than a lower surface of the third insulation pattern 280. In example embodiments, a cross-sectional view of the fifth insulation pattern 325 in the second direction D2 may have a shape of a cup, with a lower surface and sidewalls, or a U-shape.

The sixth insulation pattern 330 may be disposed on the fifth insulation pattern 325, and a sidewall and a lower surface of the sixth insulation pattern 330 may be covered, overlapped by, or be on the fifth insulation pattern 325. A cross-sectional view in the second direction D2 of the sixth insulation pattern 330 may have a shape of a cup, with a lower surface and sidewalls, or a U-shape.

The fourth wiring 340 may be disposed on the sixth insulation pattern 330, and a sidewall and a lower surface of the fourth wiring 340 may be covered or overlapped by the sixth insulation pattern 330. The seventh insulation pattern 350 may be disposed on the fourth wiring 340, and a sidewall of the seventh insulation pattern 350 may be covered or overlapped by the sixth insulation pattern 330. In example embodiments, each of the fourth wiring 340 and the seventh insulation pattern 350 may extend in the first direction D1. A plurality of fourth wirings 340 may be spaced apart from each other in the second direction D2, and a plurality of seventh insulation patterns 350 may be spaced apart from each other in the second direction D2.

In example embodiments, the fourth wiring 340 may be disposed between the third wirings 300 serving as the bit lines, and may serve as a bit line shield.

The eighth insulation pattern 360 and the first mold 370 may be sequentially stacked on the third wiring 300, the fifth insulation pattern 325 and the sixth insulation pattern 330. A plurality of eighth insulation patterns 360 may be spaced apart from each other in each of the first and second directions D1 and D2, and a plurality of first molds 370 may be spaced apart from each other in each of the first and second directions D1 and D2.

The sixth insulating interlayer pattern 445 may be disposed on the seventh insulation pattern 350, and may extend in the first direction D1. A plurality of sixth insulation patterns 445 may be spaced apart from each other in the second direction D2 between neighboring ones of the first molds 370 in the second direction D2. A sidewall in the second direction D2 and a lower surface of the sixth insulating interlayer pattern 445 may be covered or overlapped by the second capping pattern 435.

The channel 385 be disposed between neighboring ones of the first molds 370 in the first direction D1 on the third wiring 300 extending in the first direction D1, and a plurality of channels 385 may be spaced apart from each other in the first direction D1. A sidewall of the channel 385 that is opposite to the first mold 370 and an upper surface of a portion of the channel 385 on the third wiring 300 may be covered or overlapped by the first capping pattern 395. In example embodiments, a cross-section in the first direction D1 of each of the channel 385 and the first capping pattern 395 may have a shape of a cup, with a lower surface and sidewalls, or a U-shape.

In example embodiments, the channel 385 may include an oxide semiconductor material. The oxide semiconductor material may include at least one of zinc tin oxide (ZTO), indium zinc oxide (IZO), zinc oxide (ZnOₓ), indium gallium zinc oxide (IGZO), indium gallium silicon oxide (IGSO), Indium oxide (InOₓ, In₂O₃), tin oxide (SnO₂), titanium oxide (TiOₓ), zinc oxide nitride (ZnₓOyN_{z}), magnesium zincoxide (MgₓZn_{y}O_{z}), indium zinc oxide (InₓZn_{y}Oₐ), indium gallium zinc oxide (InₓGa_{y}Zn_{z}Oₐ), zirconium indium zinc oxide (ZrₓIn_{y}Zn_{z}Oₐ), hafnium indium zinc oxide (HfₓIn_{y}Zn_{z}Oₐ), tin indium zinc oxide (SnₓIn_{y}Zn_{z}Oₐ), aluminum tin indium zinc oxide (AlₓSn_{y}In_{z}ZnₐO_{d}), silicon indiumzinc oxide (SiₓIn_{y}Zn_{z}Oₐ), zinc tin oxide (ZnₓSn_{y}O_{z}), aluminum zinc tin oxide (AlₓZn_{y}Sn_{z}Oₐ), gallium zinc tin oxide (GaₓZn_{y}Sn_{z}Oₐ), zirconium zinc tin oxide (ZrₓZn_{y}Sn_{z}Oₐ) and/or indium gallium silicon oxide (InGaSiO).

The second capping pattern 435 may be disposed on the first capping pattern 395. In example embodiments, the second capping pattern 435 may cover, overlap, or be on opposite sidewalls in the second direction D2 of the first mold 370, opposite sidewalls in the second direction D2 of the channel 385 on each of opposite sidewalls in the first direction D1 of the first mold 370, and a sidewall in the first direction D1 of the first capping pattern 395 on a sidewall in the first direction D1 of the channel 385.

Each of the first and second capping patterns 395 and 435 may include an insulating material, e.g., silicon nitride, silicon oxide, silicon oxycarbide, silicon oxycarbonitride, aluminum oxide, etc. In example embodiments, the first and second capping patterns 395 and 435 may include a substantially same material, and in some cases, may be merged with each other.

The second gate insulation pattern 455 may extend in the second direction D2 on the second capping pattern 435 and the sixth insulating interlayer pattern 445, and a plurality of second gate insulation patterns 455 may be spaced apart from each other in the first direction D1. In example embodiments, a cross-section in the first direction D1 of the second gate insulation pattern 455 may have a shape of a cup, with a lower surface and sidewalls, or a U-shape.

In example embodiments, in a plan view, a first sidewall of the second gate insulation pattern 455 facing the sixth insulating interlayer pattern 445 in the first direction D1 may have a convex shape toward (e.g. protruding toward) the sixth insulating interlayer pattern 445, and a groove may be formed on a second sidewall of the second gate insulation pattern 455 that is opposite to the first sidewall thereof.

The second gate insulation pattern 455 may include an oxide, e.g., silicon oxide.

The second gate electrode 475 may be disposed on an inner sidewall of the second gate insulation pattern 455, and may extend in the second direction D2. A plurality of second gate electrodes 475 may be spaced apart from each other in the first direction D1. The second gate electrodes 475 may be disposed on inner sidewalls, respectively, opposite to each other, and may face each other in the first direction D1. Each of the second gate electrodes 475 may serve as a word line. Each second gate electrode 475 may include protruding portions that protrude in a direction parallel to the first direction D1 into the grooves formed in the second sidewall of the corresponding second gate insulation pattern 455.

The second gate electrode 475 and the second gate insulation pattern 455 may collectively form a second gate structure.

The etch stop pattern 495 may be disposed between neighboring ones of the second gate electrodes 475 in the first direction D1, and may extend in the second direction D2. A lower surface of the etch stop pattern 495 may contact an upper surface of the second gate insulation pattern 455. The etch stop pattern 495 may include an insulating nitride, e.g., silicon nitride.

The seventh insulating interlayer pattern 505 may be disposed on the etch stop pattern 495, and may extend in the second direction D2. The second insulating interlayer pattern 505 may fill a space defined by the etch stop pattern 495.

In example embodiments, uppermost surfaces of the seventh insulating interlayer pattern 505, the etch stop pattern 495 and the second gate electrode 475 may be lower than an uppermost surface of the second gate insulation pattern 455.

The fourth capping pattern 510 may be disposed on the etch stop pattern 495, the second gate electrode 475 and the second gate insulation pattern 455, and may extend in the second direction D2.

The landing pad 535 may include a lower portion contacting an upper surface of the channel 385 and an upper portion on the lower portion. A plurality of landing pads 535 may be spaced apart from each other in each of the first and second directions D1 and D2. The landing pad 535 may have a shape of, e.g., a circle, an ellipse, a polygon, a polygon with rounded corners, etc.

In example embodiments, a lower surface of the landing pad 535 and an uppermost surface of the channel 385 may be lower than uppermost surfaces of the first and second capping patterns 395 and 435 and the second gate insulation pattern 455. In example embodiments, a lower surface of the landing pad 535 may be lower than the uppermost surfaces of the seventh insulating interlayer pattern 505, the etch stop pattern 495 and the second gate electrode 475, however, the inventive concept may not be limited thereto.

The eighth insulating interlayer pattern 540 may be disposed on the first mold 370, the sixth insulating interlayer pattern 445, the second and fourth capping patterns 435 and 510 and the second gate insulation pattern 455, and may cover, overlap, or be on sidewalls of the landing pads 535. A lower surface of the eighth insulating interlayer pattern 540 may be lower than the lower surface of the landing pad 535. In example embodiments, the lower surface of the eighth insulating interlayer pattern 540 may be lower than the uppermost surface of the second gate insulation pattern 455 and higher than a lower surface of the fourth capping pattern 510.

The first support layer 550 may be disposed on the eighth insulating interlayer pattern 540 and the landing pad 535. The second support layer 560 may be disposed on the first support layer 550, and may be spaced apart from the first support layer 550 in the third direction D3. One or more layers (not shown in FIG. 4) may be located between the first support layer 550 and the second support layer 560. Each of the first and second support layers 550 and 560 may include an insulating nitride, e.g., silicon nitride.

The capacitor 570 may be disposed on the landing pad 535, and at least a portion of a lower end and an upper end of the capacitor 570 may be covered or overlapped by the first and second support layers 550 to be supported by the first and second support layers 550. The capacitor 570 may include a lower electrode, a dielectric layer and an upper electrode, and a plurality of capacitors 570 may be disposed in each of the first and second directions D1 and D2. Each of the lower and upper electrodes may include a conductive material, and the dielectric layer may include a metal oxide having a high dielectric constant, e.g., hafnium oxide, zirconium oxide, etc. The capacitor 570 may have a shape of, e.g., a circle, an ellipse, a polygon, a polygon with rounded corners, etc.

Each of the second gate electrode 475, the first to third contact plugs 190, 195 and 240, the first to fourth wirings 210, 250, 300 and 340 and the landing pad 535 may include a conductive material, e.g., a metal, a metal nitride, a metal silicide, etc.

Each of the first, third, fifth and eighth insulation patterns 230, 280, 325 and 360, the second insulation pattern 260, the second and third insulating interlayers 180 and 200, the fourth capping pattern 510 and the eighth insulating interlayer pattern 540 may include an insulating nitride, e.g., silicon nitride, and each of the first, fourth and fifth insulating interlayers 120, 220 and 270, the sixth and seventh insulation patterns 330 and 350, the first mold 370 and the sixth to eighth insulating interlayer patterns 445, 505 and 540 may include an oxide, e.g., silicon oxide.

The semiconductor device may include the first capping pattern 395 covering or overlapping the sidewall in the first direction D1 of the channel 385 and the second capping pattern 435 covering or overlapping the sidewalls in the second direction D2 of the channel 385, and as illustrated below, when the semiconductor device is manufactured, the channel 385 may be protected by the first and second capping patterns 395 and 435 and therefore may not be damaged, so that the semiconductor device may have enhanced electrical characteristics.

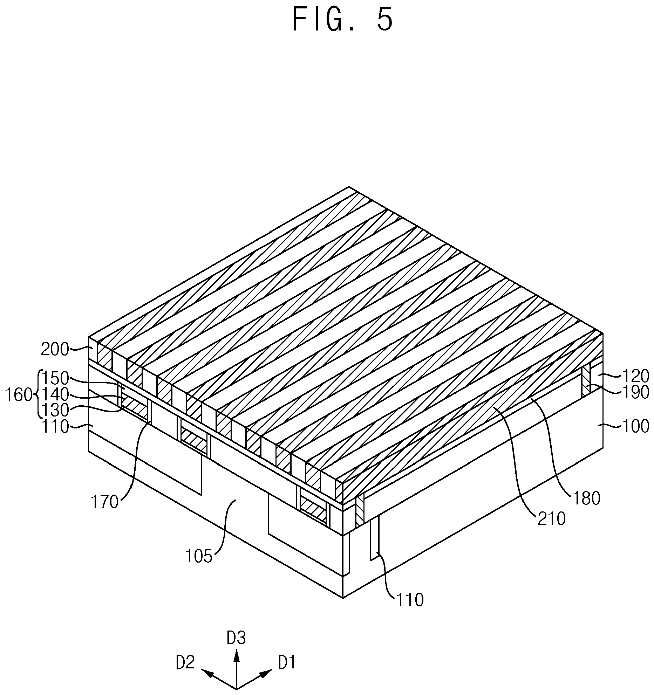

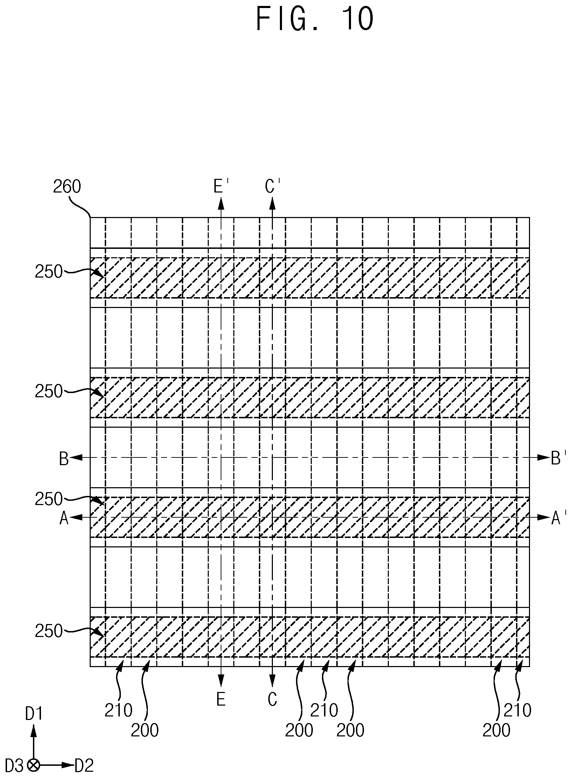

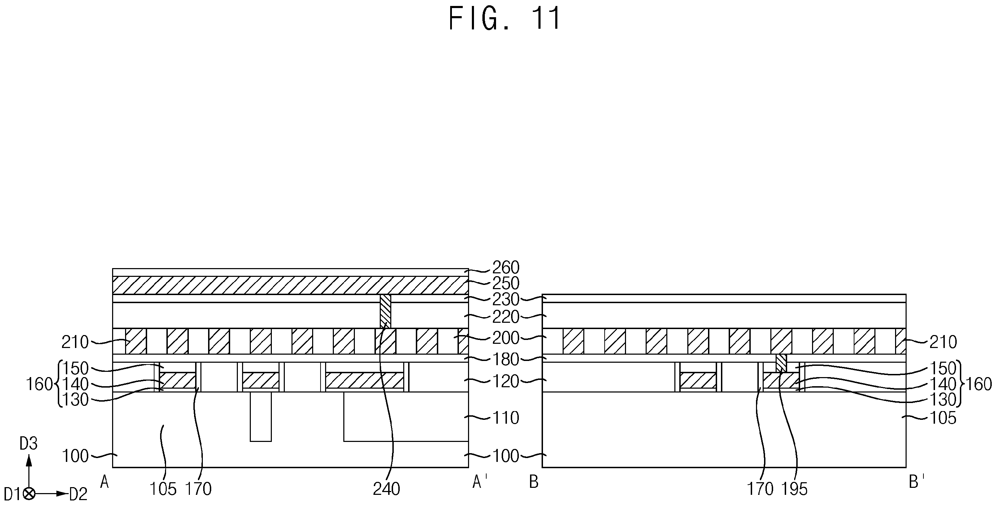

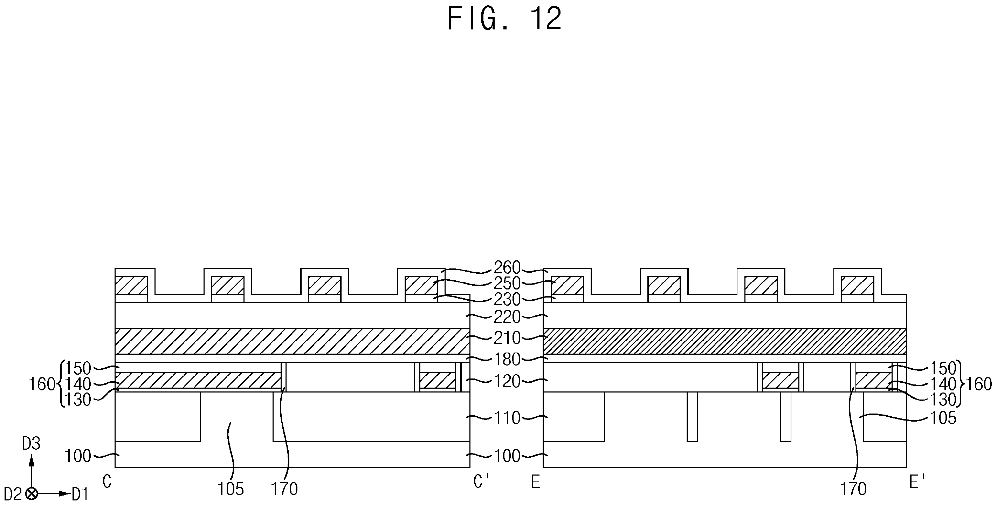

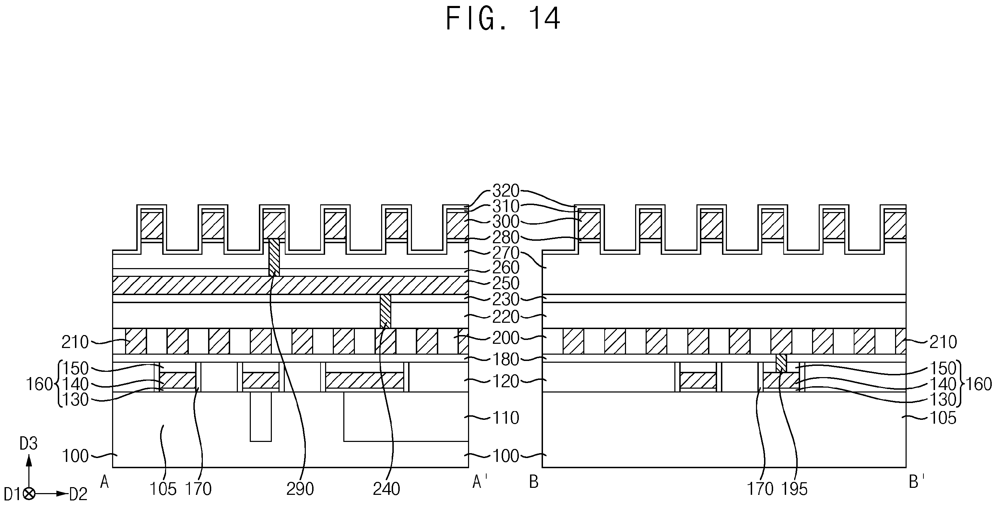

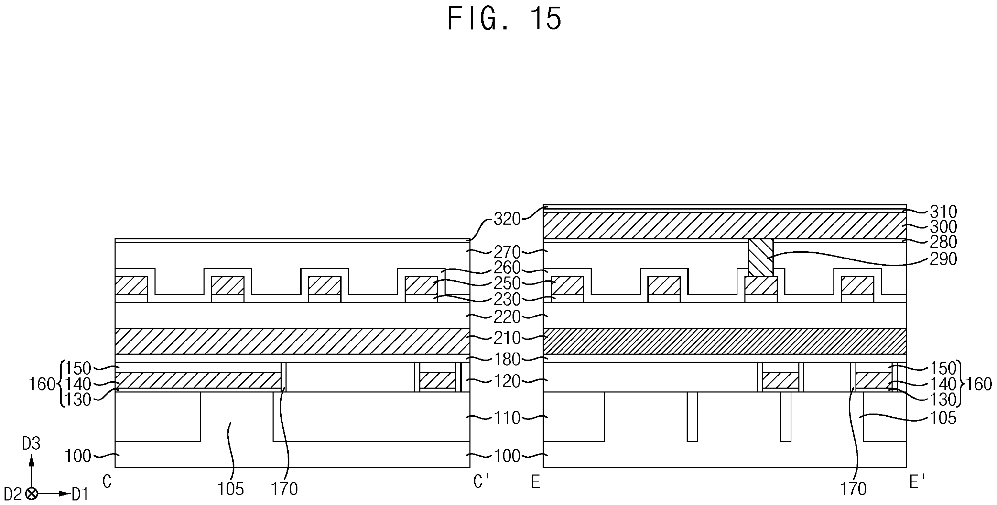

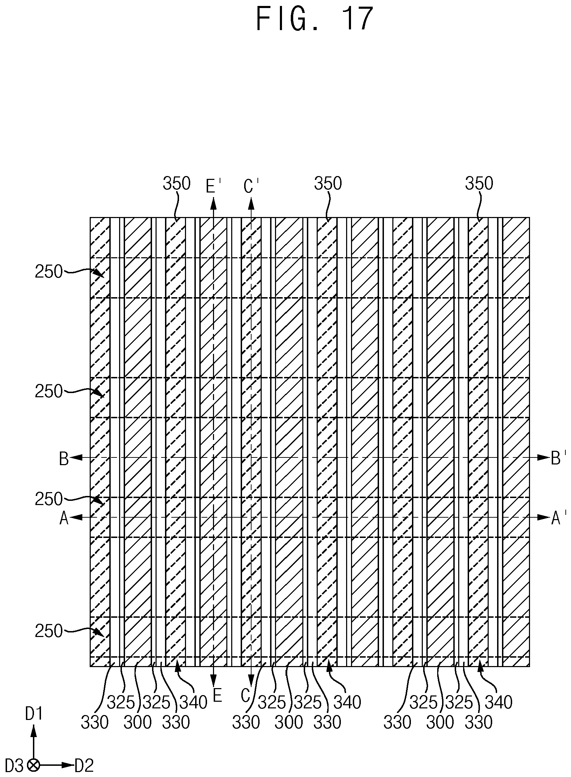

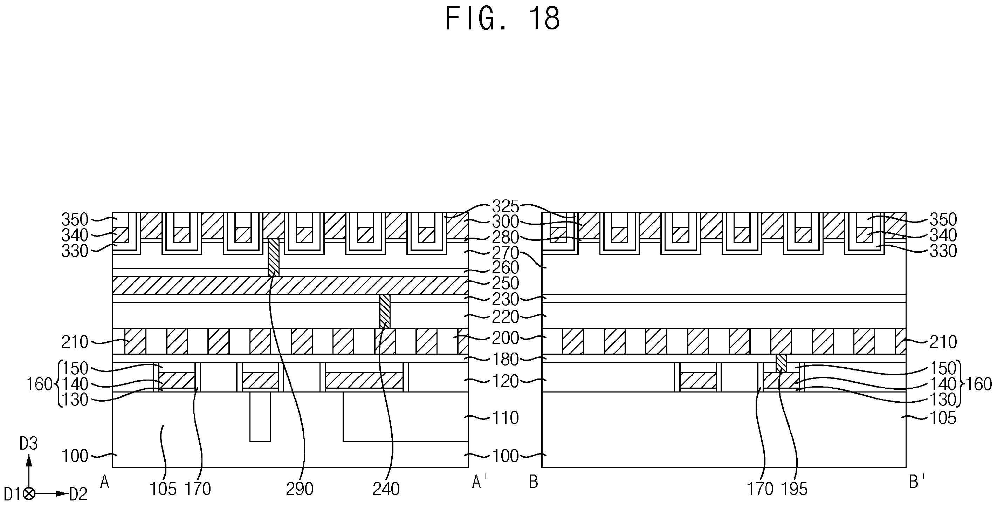

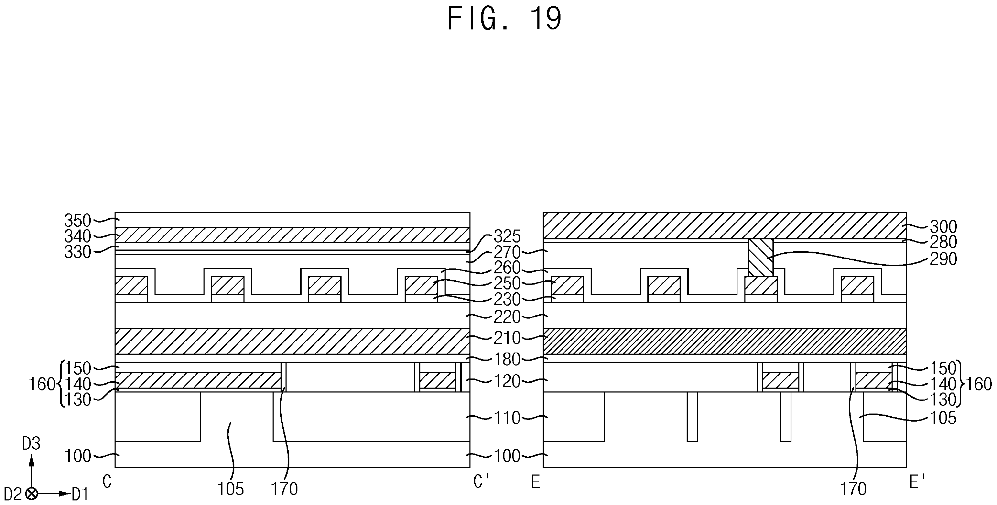

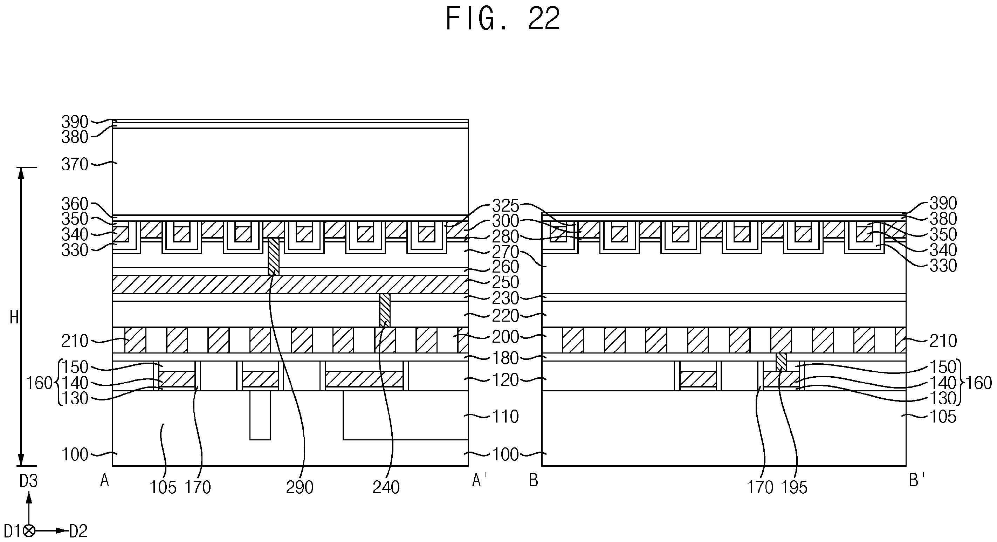

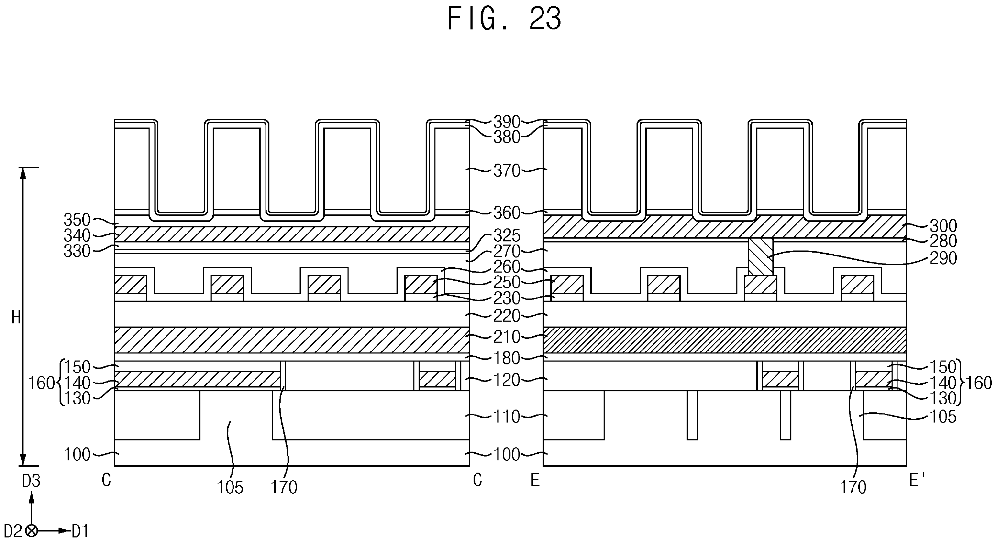

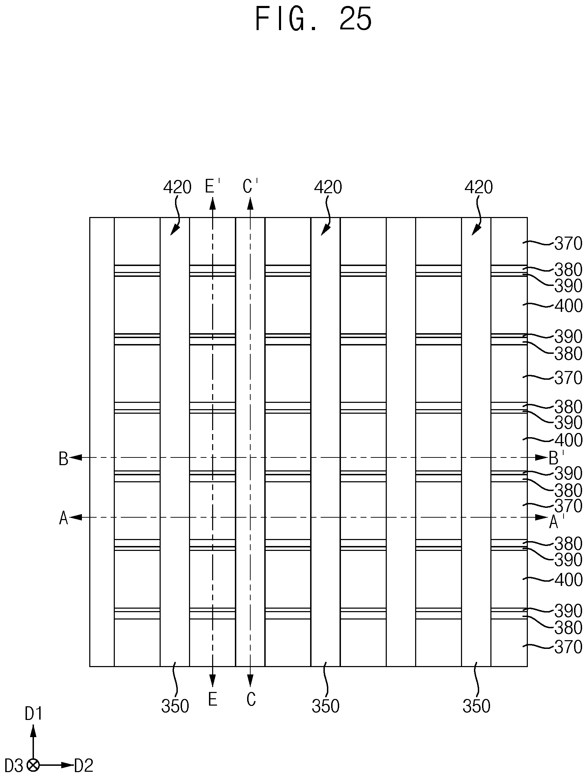

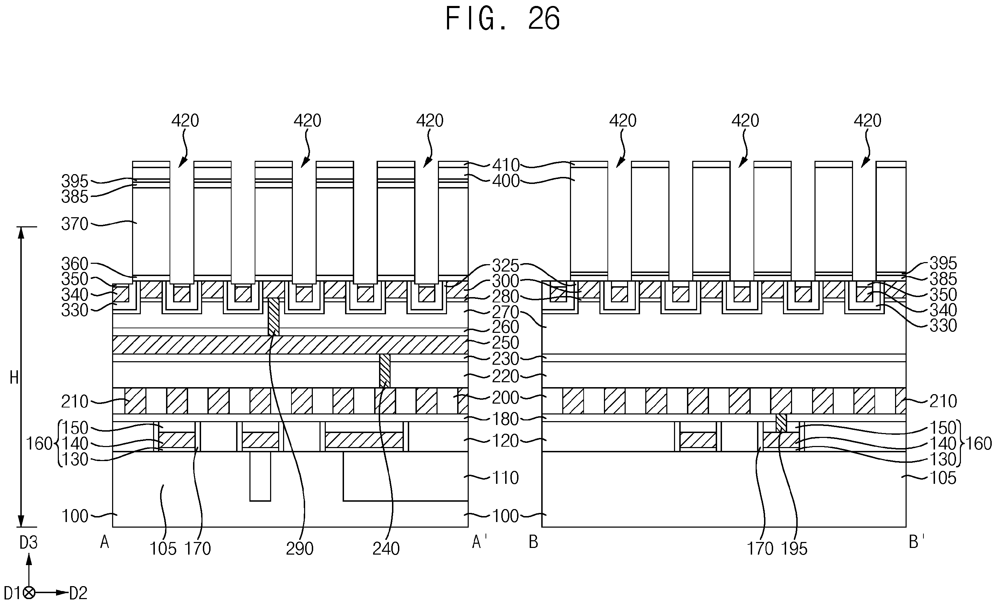

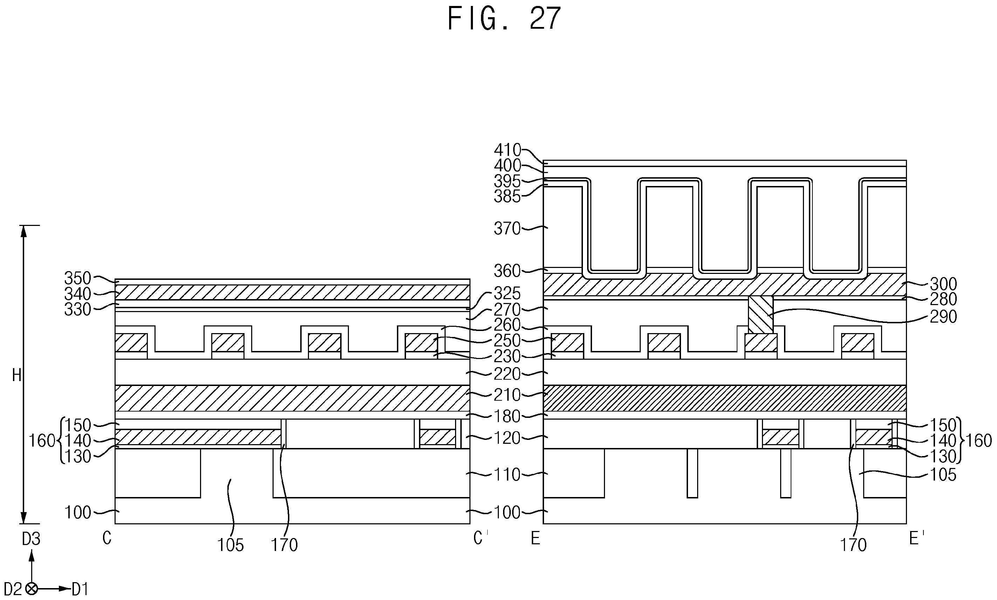

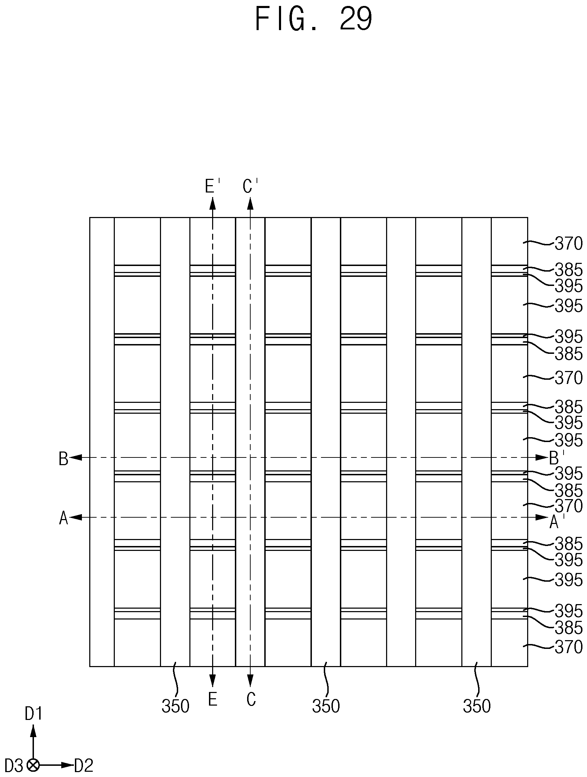

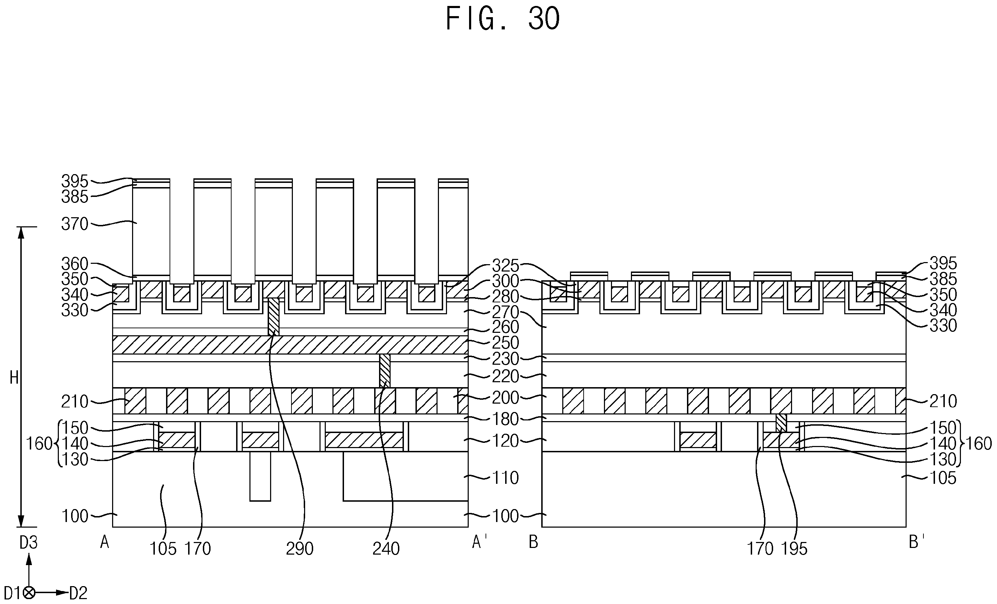

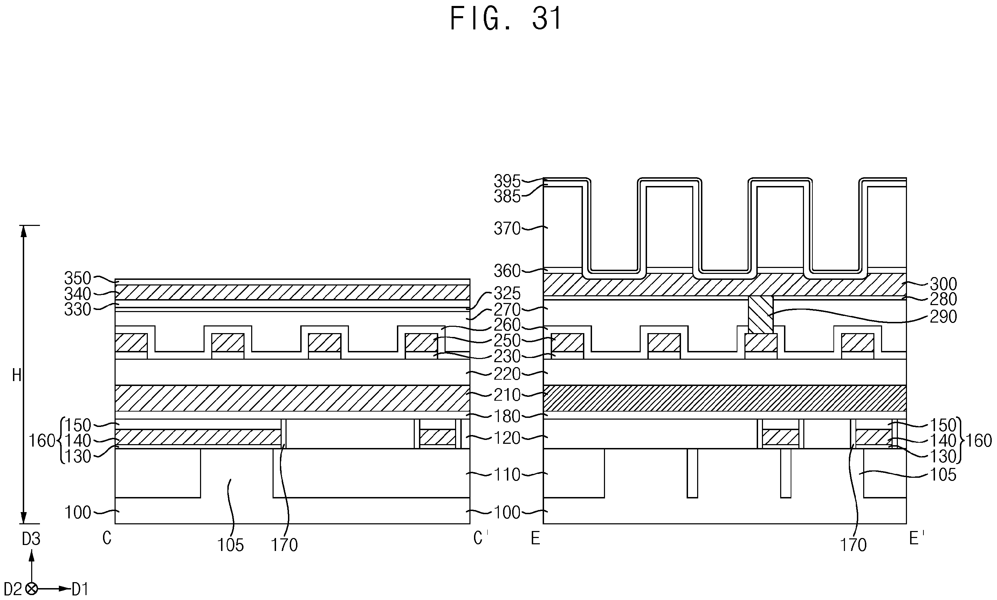

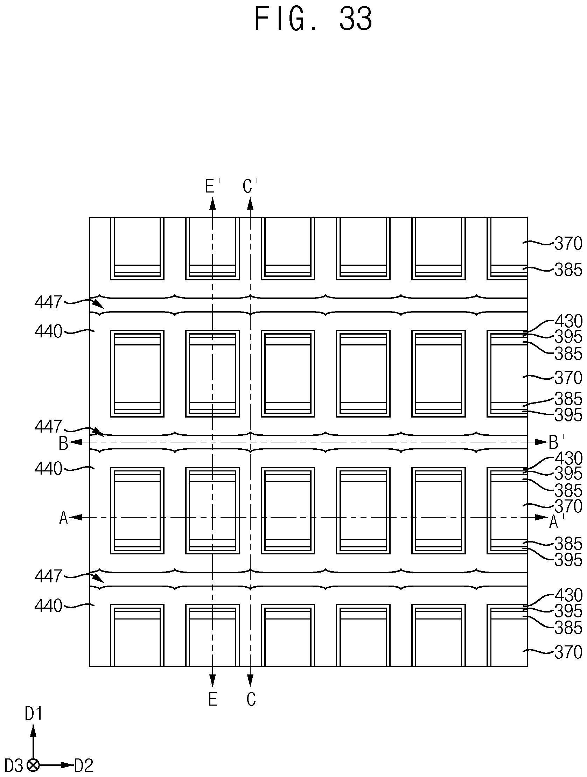

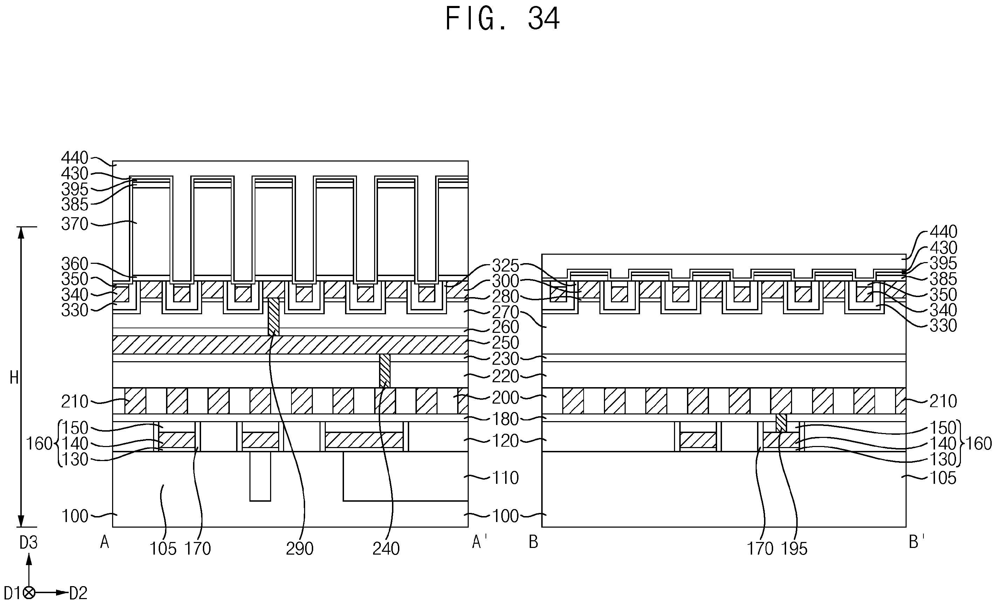

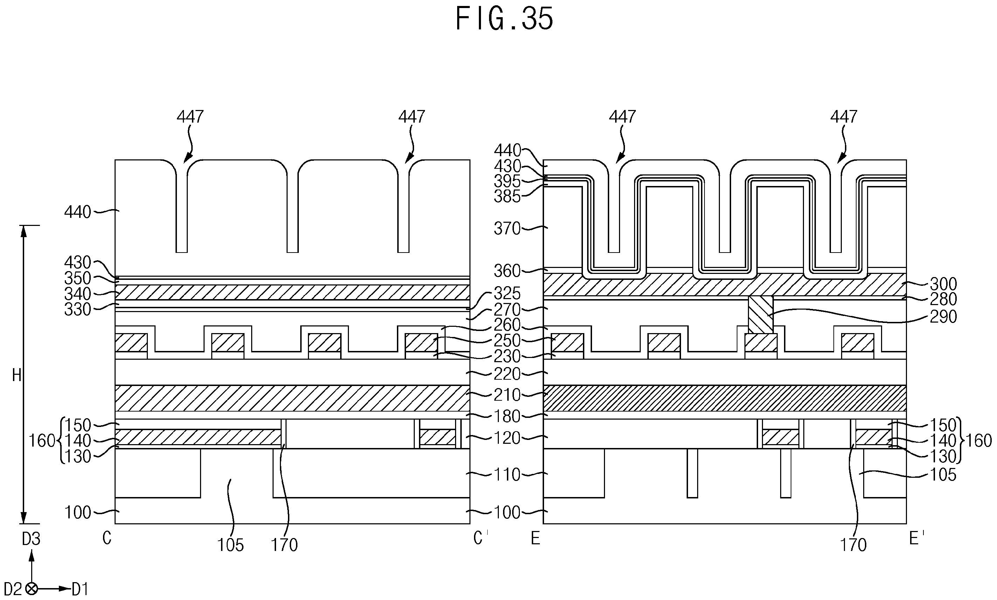

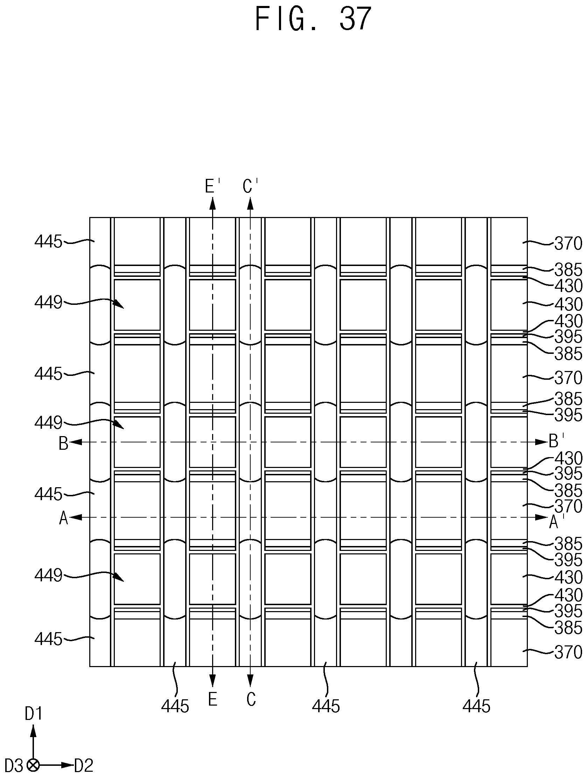

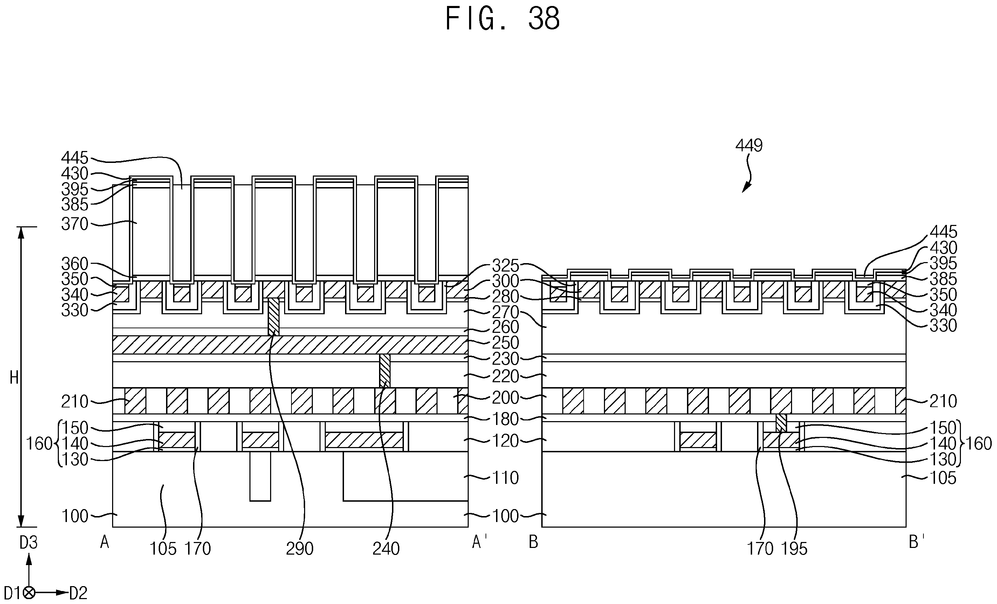

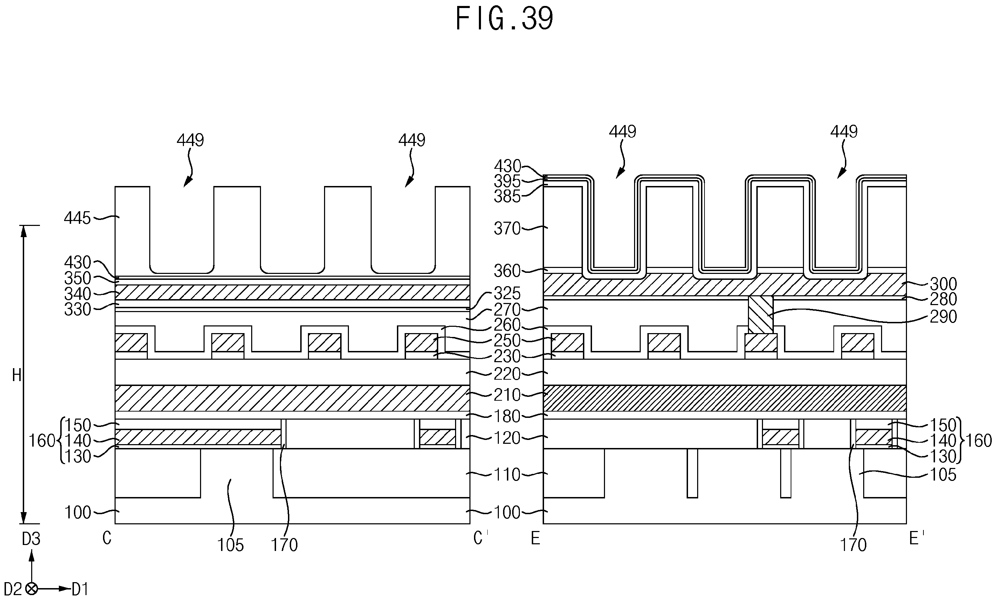

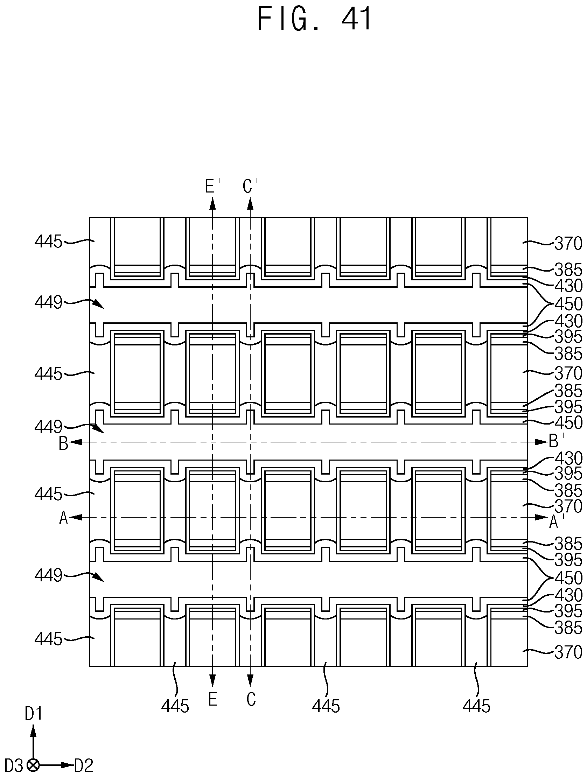

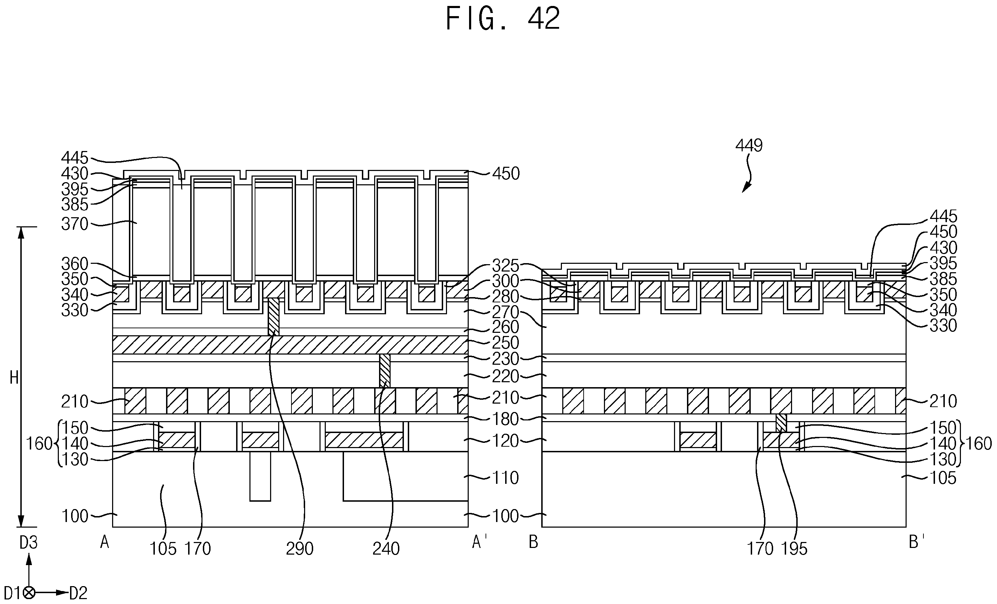

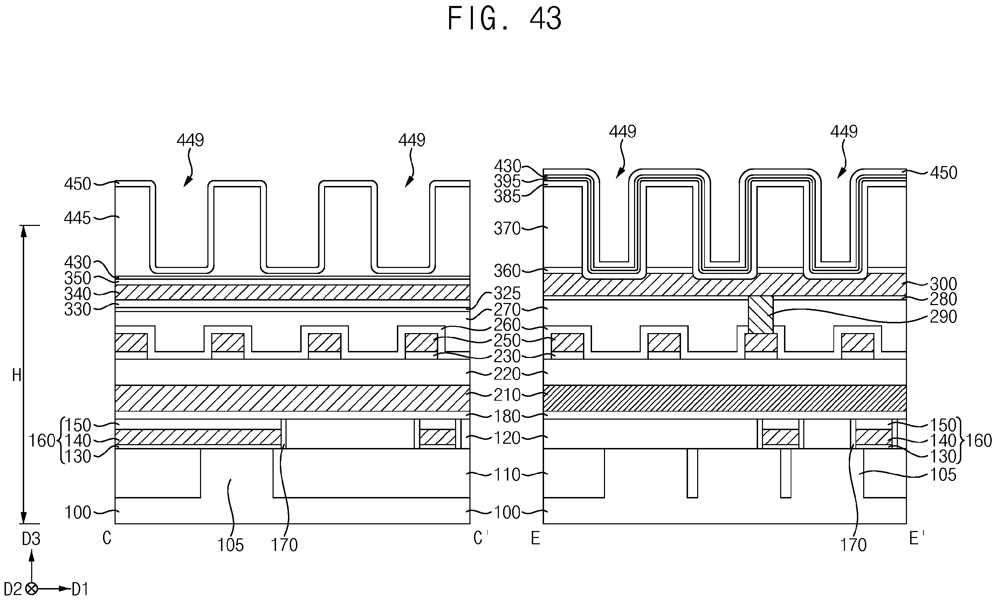

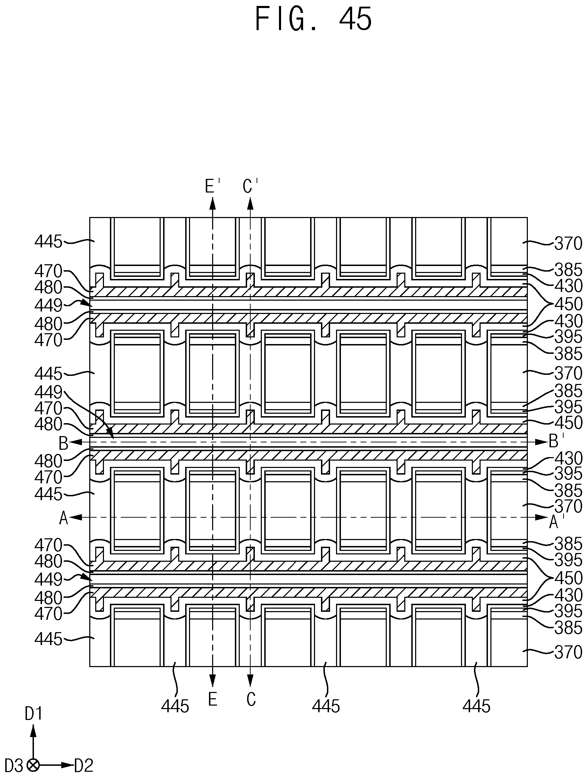

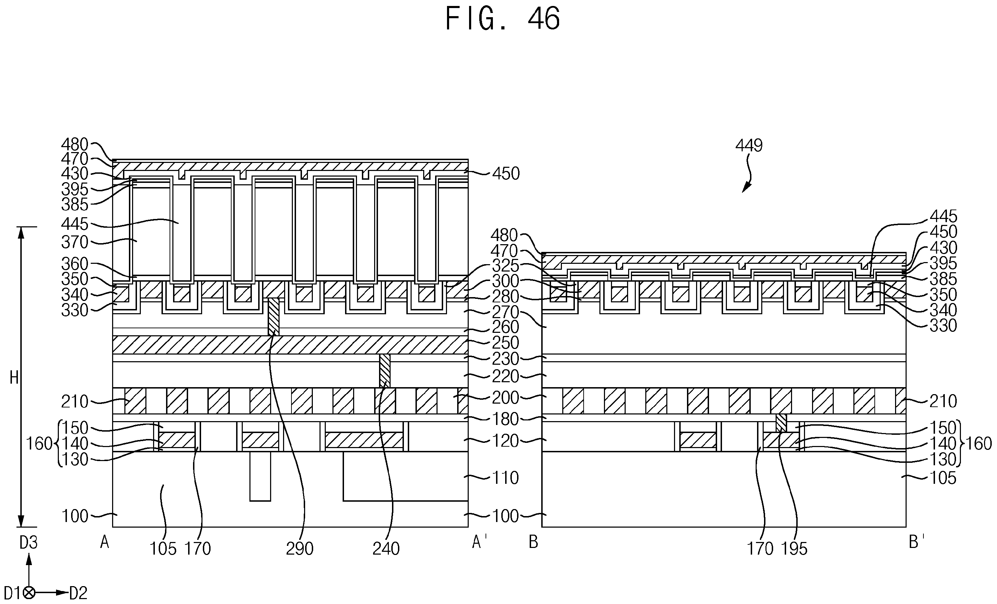

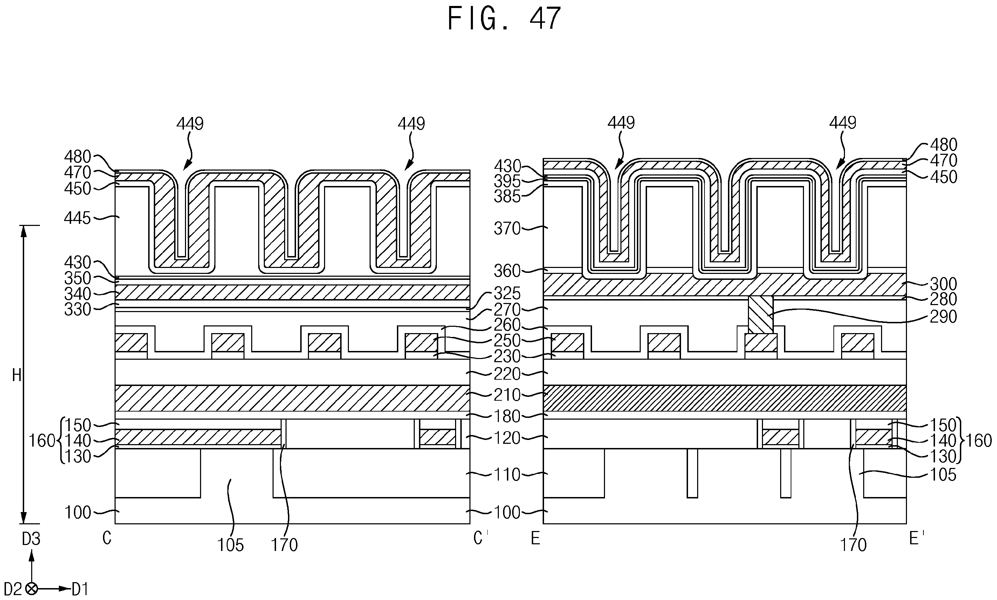

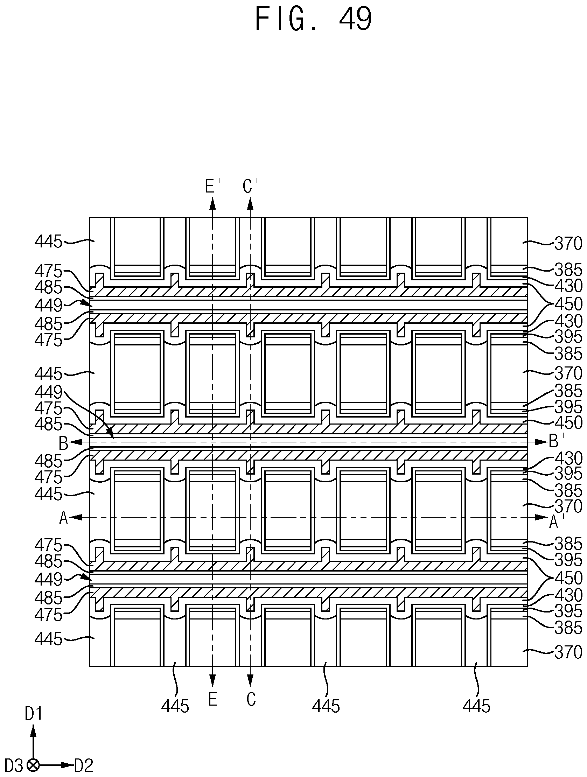

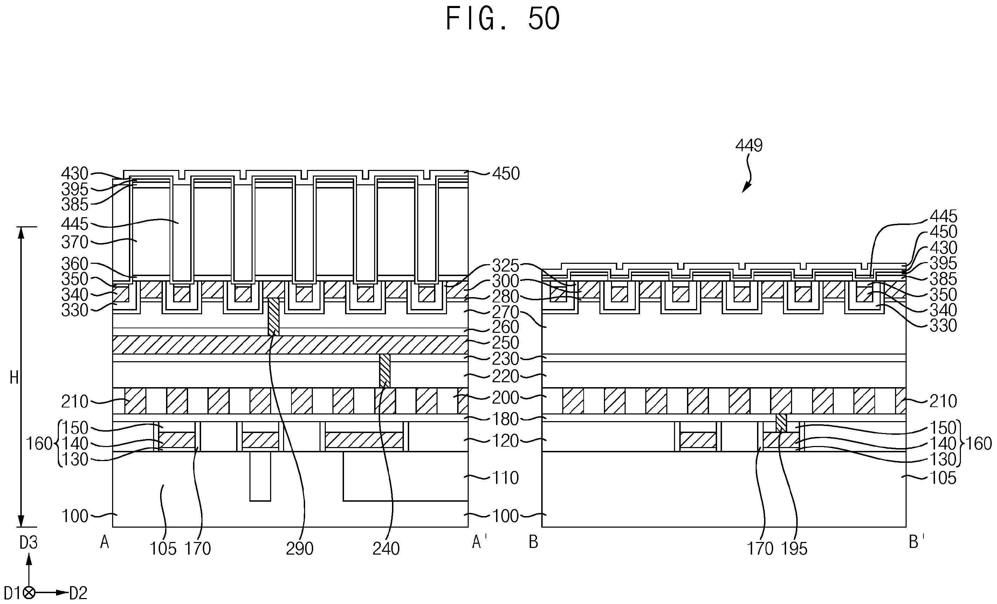

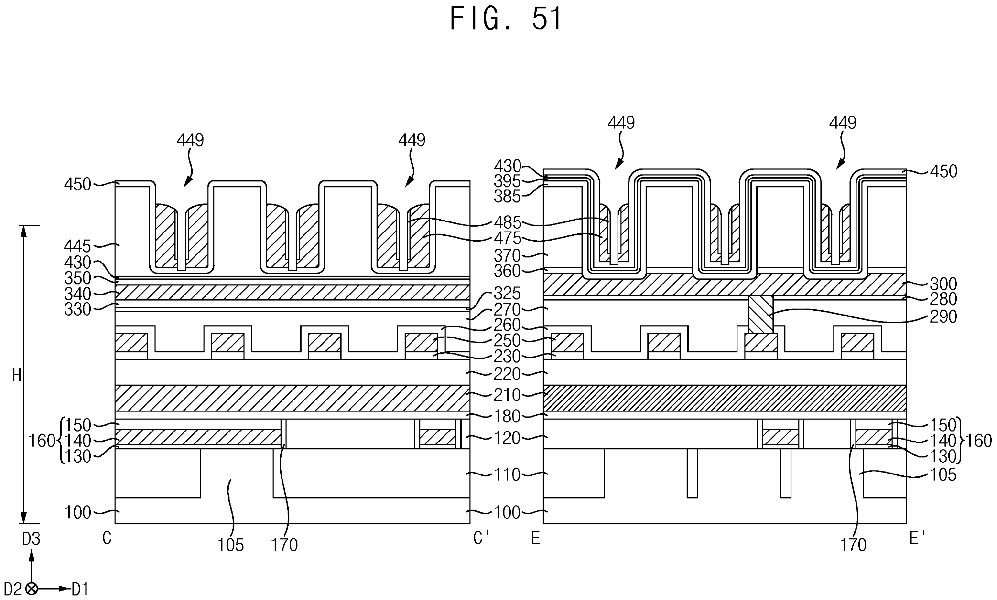

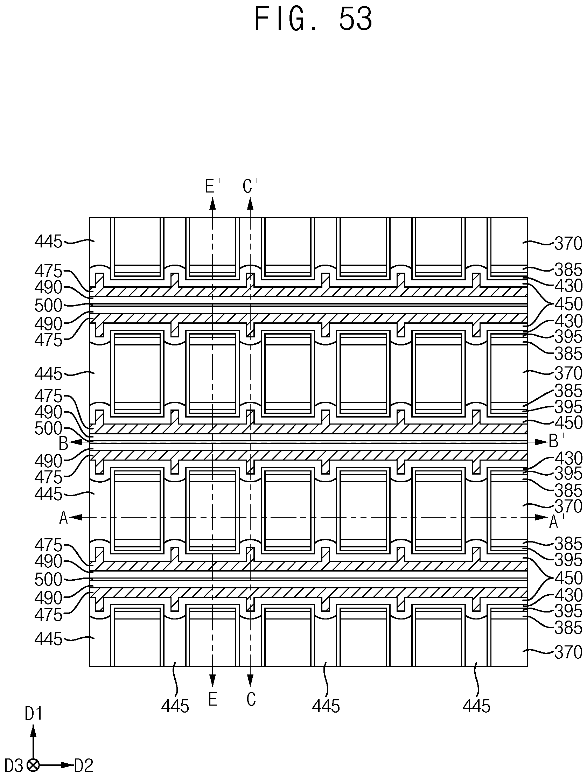

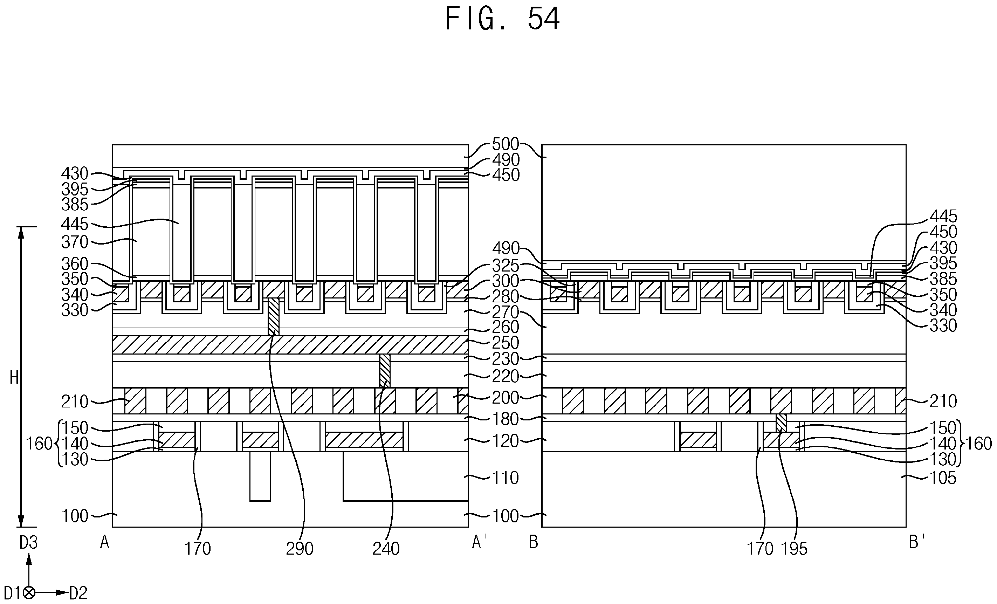

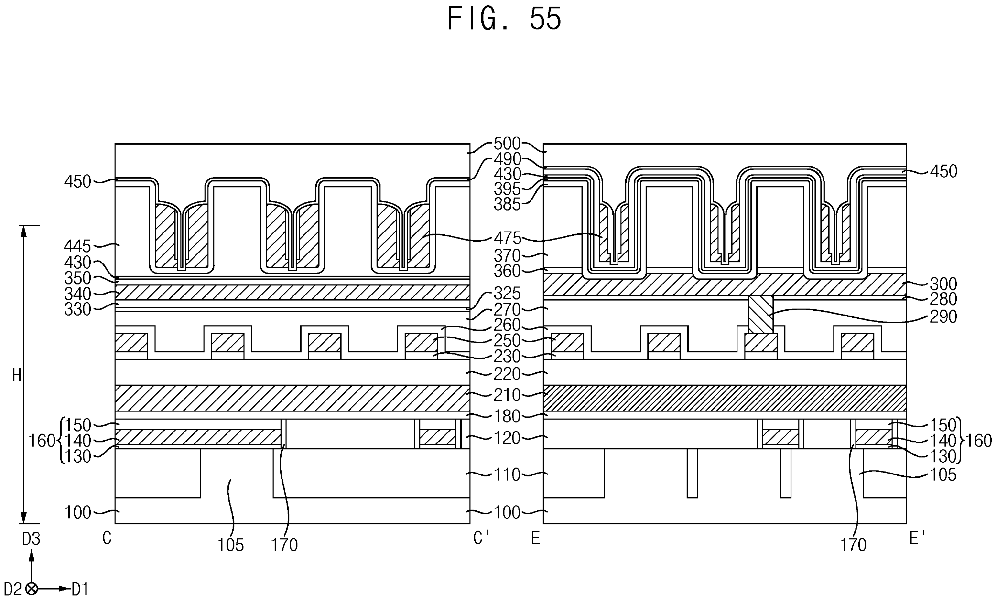

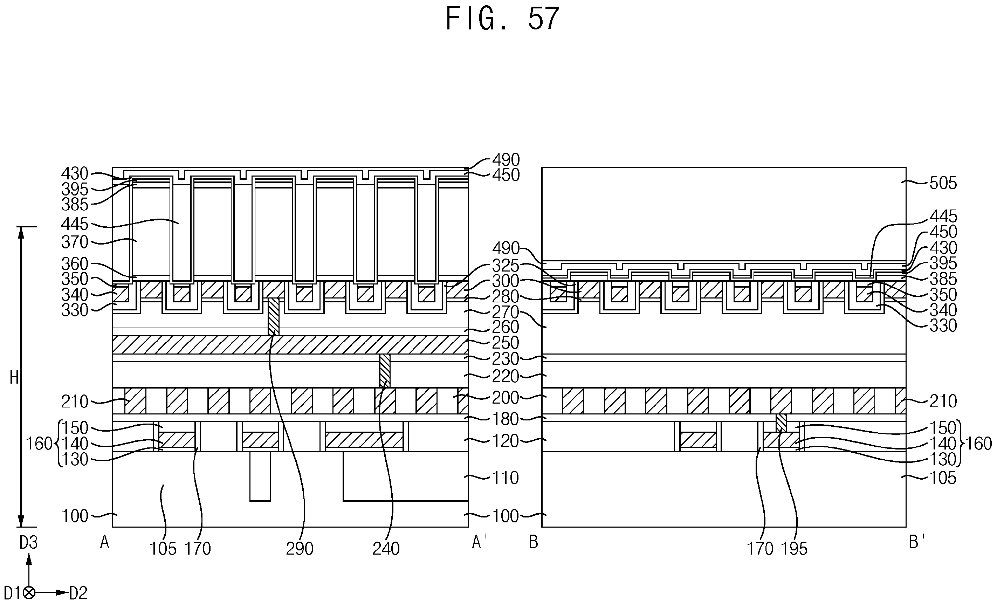

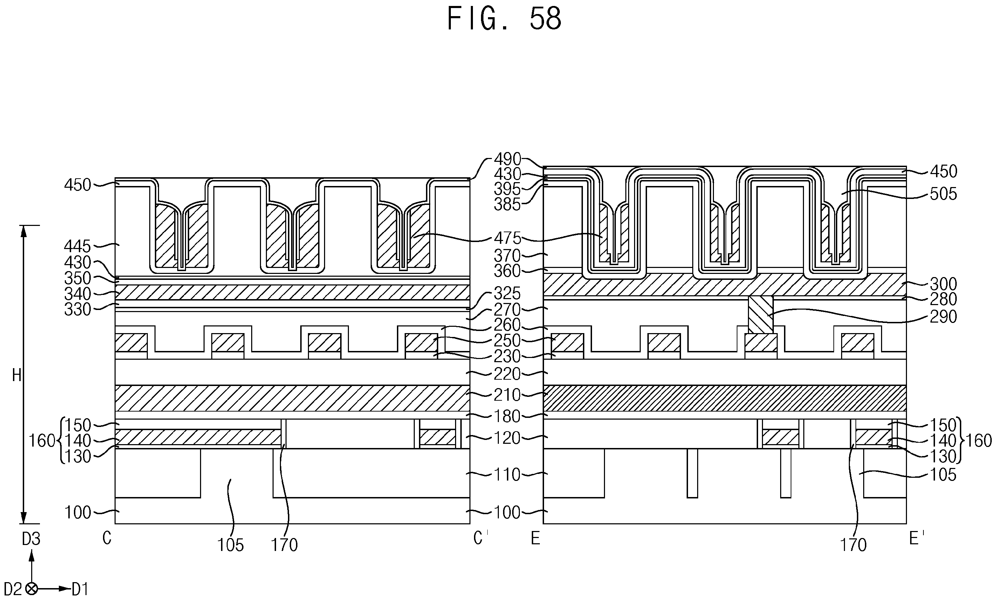

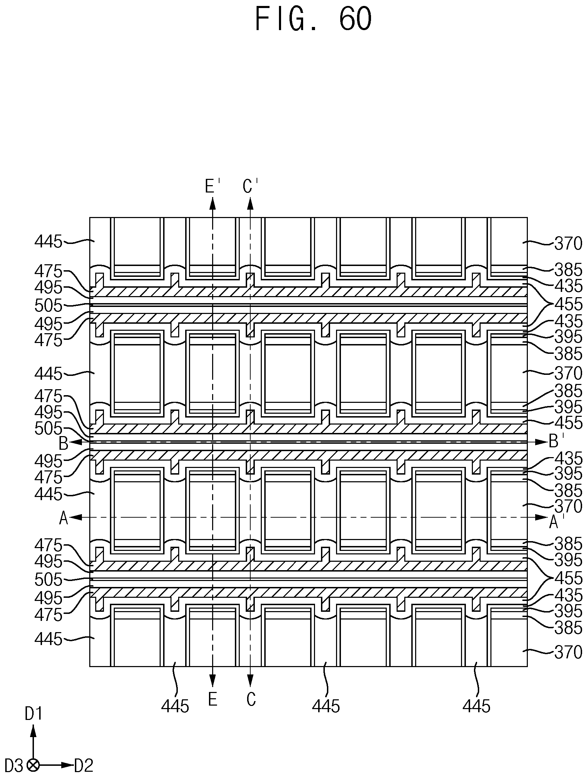

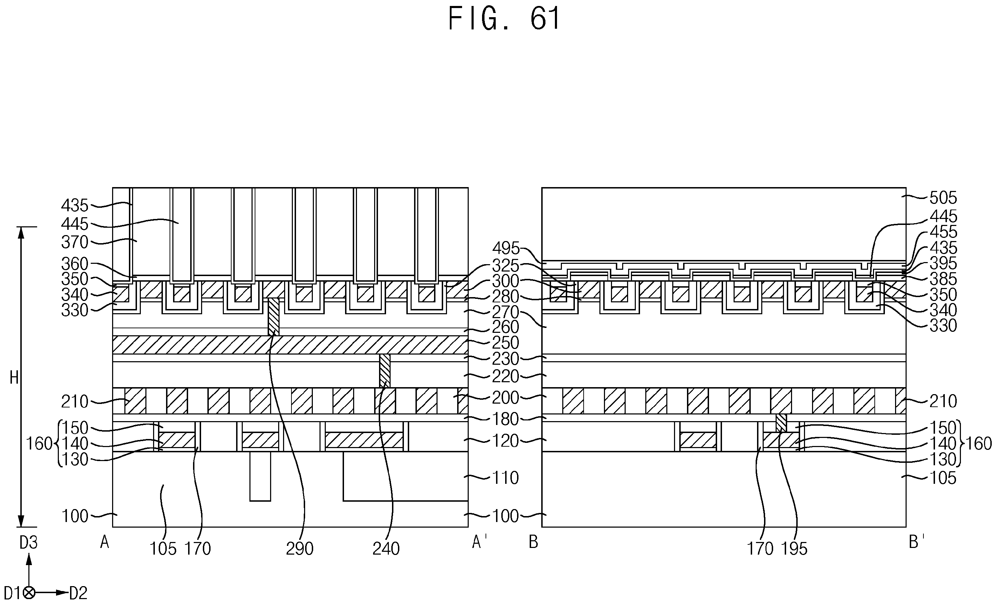

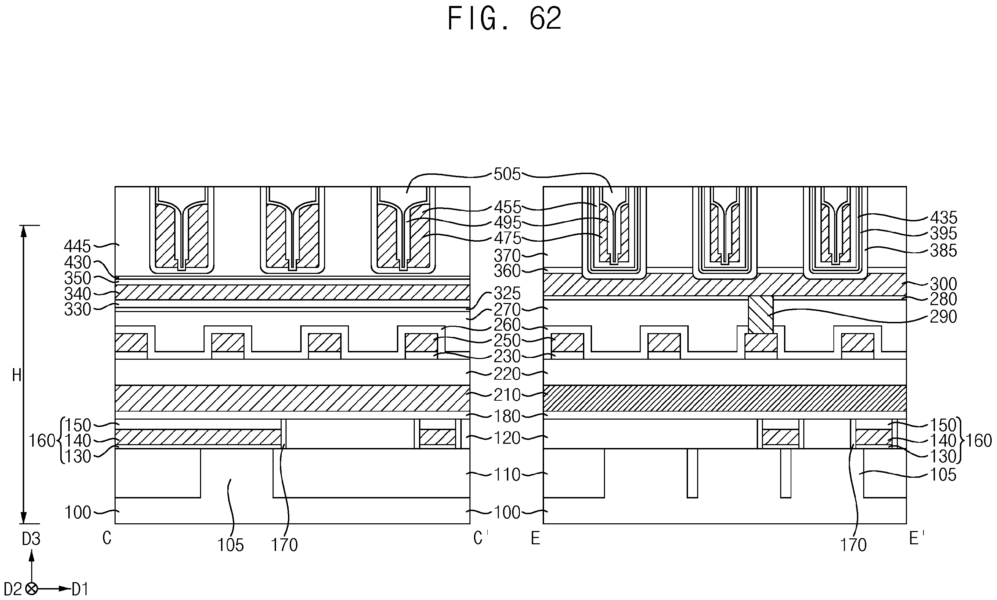

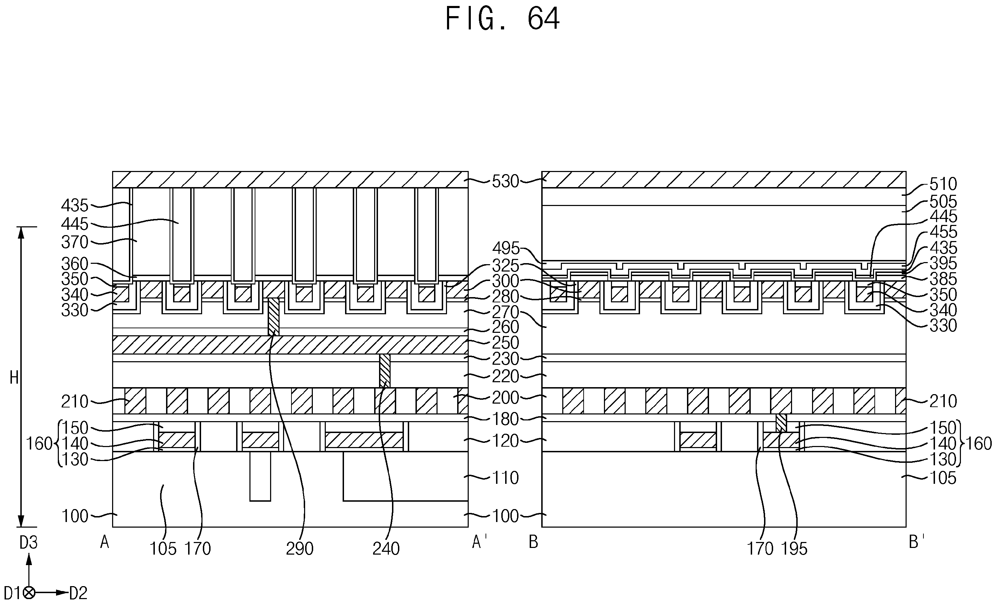

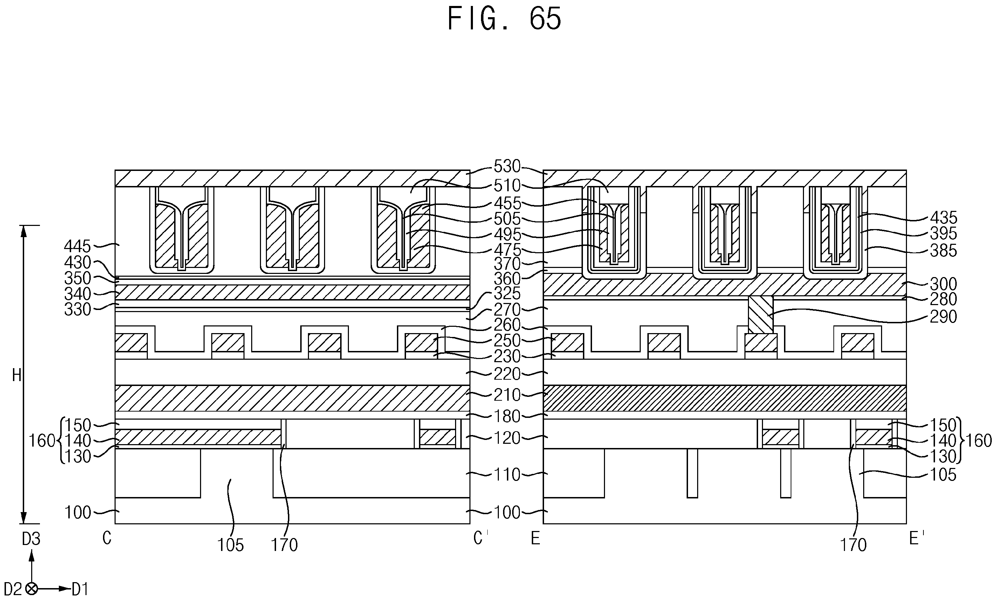

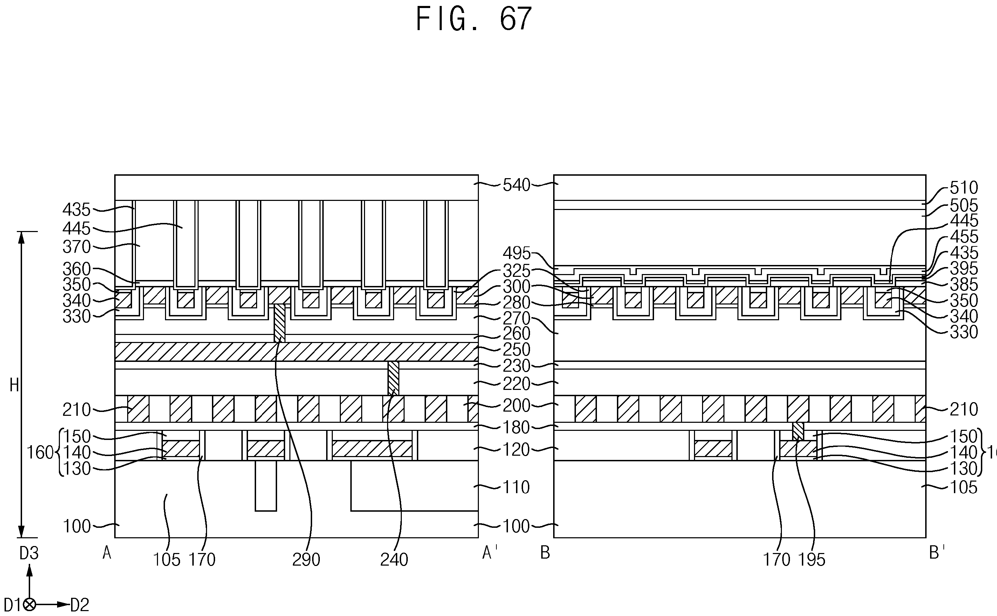

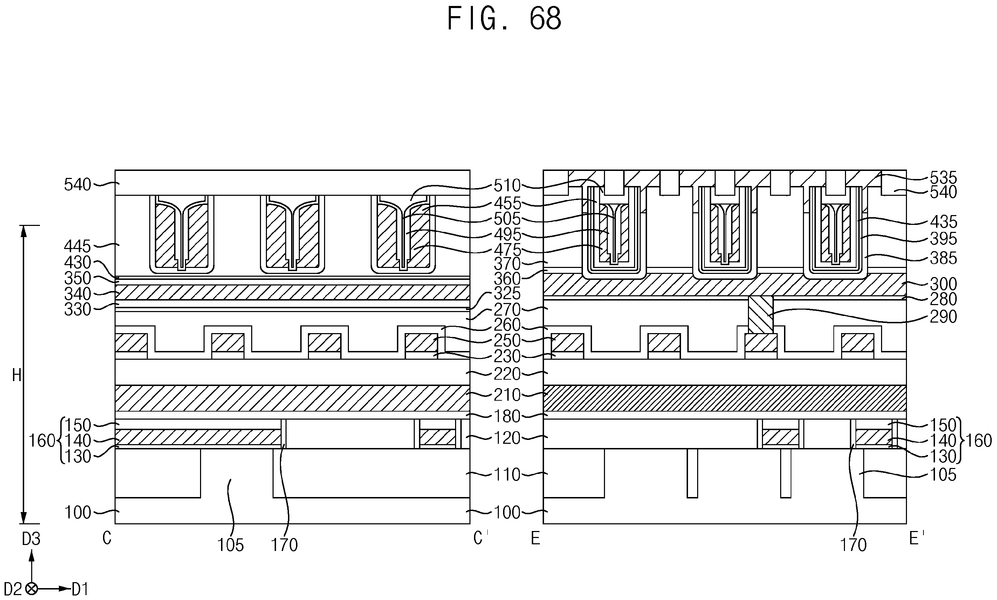

FIGS. 5 to 68 are perspective views, plan views, horizontal cross-sectional views and vertical cross-sectional views illustrating a method of manufacturing a semiconductor device in accordance with example embodiments.

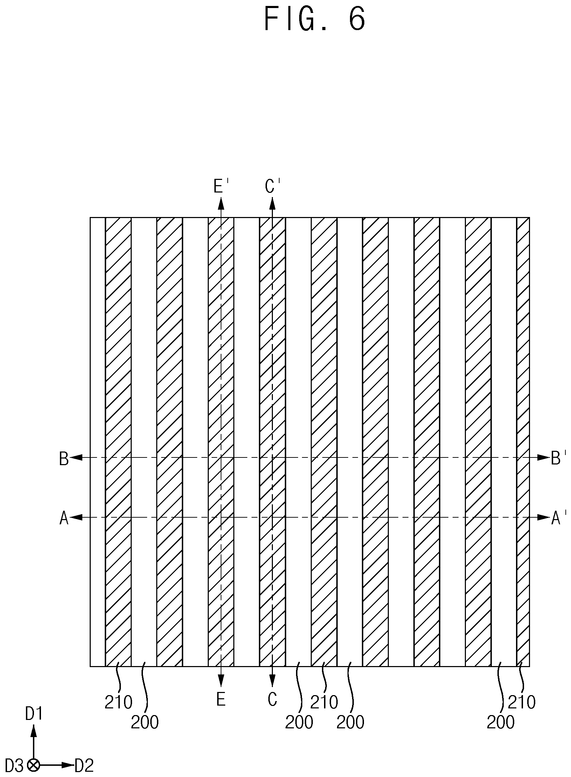

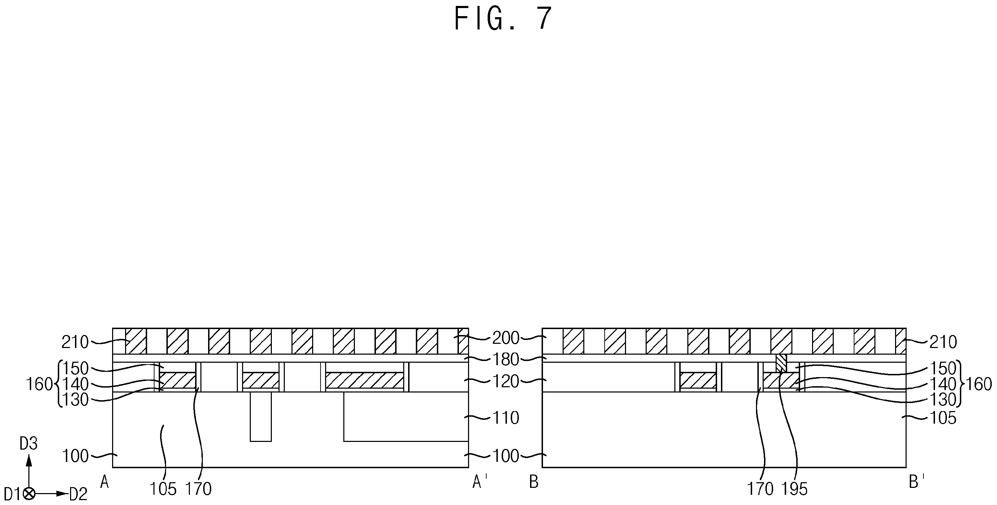

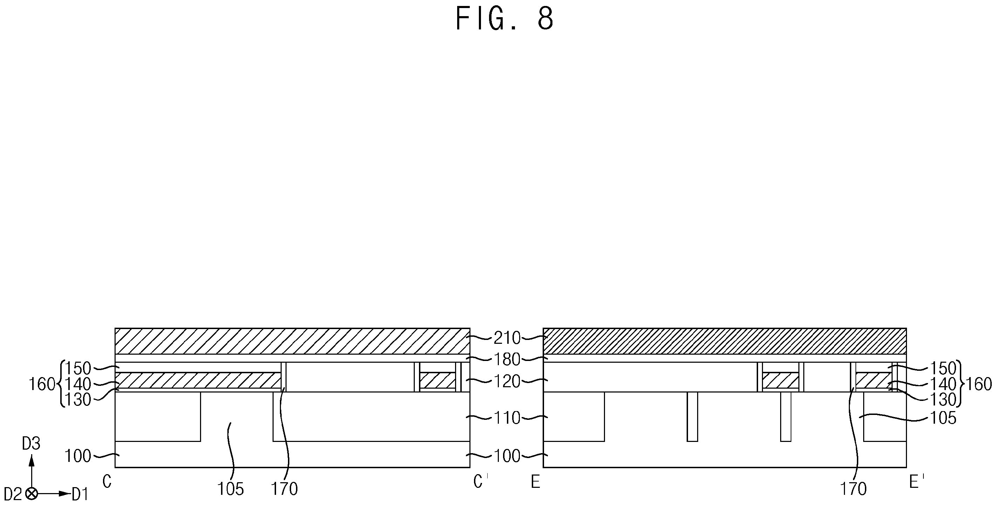

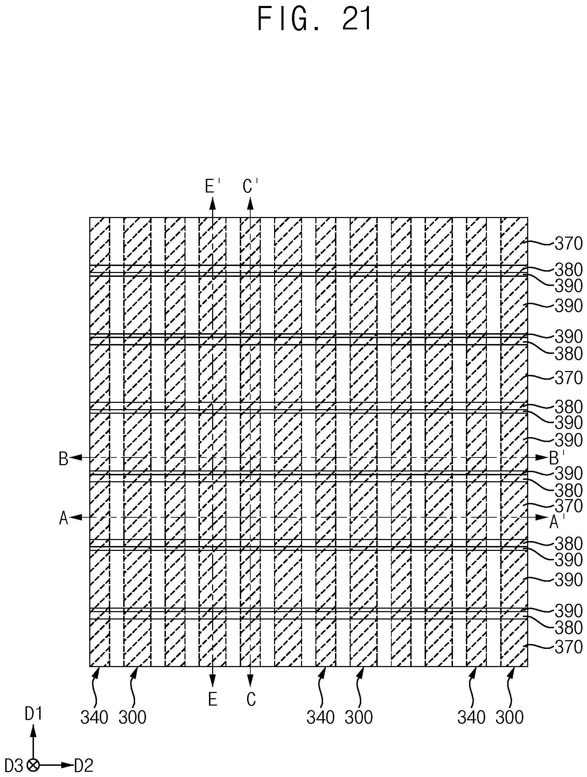

Specifically, FIGS. 5, 9, 13, 16, 20, 24, 28, 32, 36, 40, 44, 48, 52, 56, 59, 63 and 66 are the perspective views, FIGS. 6, 10 and 17 are the plan views, FIGS. 21, 25, 29, 33, 37, 41, 45, 49, 53 and 60 are the horizontal cross-sectional views, each of FIGS. 7, 11, 14, 18, 22, 26, 30, 34, 38, 42, 46, 50, 54, 57, 61, 64 and 67 includes cross-sectional views taken along lines A-A' and B-B', respectively, of a corresponding plan view or horizontal cross-sectional view, and each of FIGS. 8, 12, 15, 19, 23, 27, 31, 35, 39, 43, 47, 51, 55, 58, 62, 65 and 68 includes cross-sectional views taken along lines C-C' and E-E', respectively, of a corresponding plan view or horizontal cross-sectional view.

The horizontal cross-sectional views are drawings at a height H of corresponding vertical cross-sectional views, respectively. However, when an empty space exists at the height H, the horizontal cross-sectional view shows an element under the empty space.

Referring to FIGS. 5 to 8, an upper portion of a substrate 100 may be removed to form a first recess so that an active region 105 may be defined, and an isolation layer 110 may be formed to partially or completely fill the first recess so that a sidewall of the active region may be covered or overlapped by the isolation layer 110.

A first gate structure 160 may be formed on the active region 105 and the isolation layer 110, and a gate spacer 170 may be formed on a sidewall of the first gate structure 160. In example embodiments, the first gate structure 160 may include a first gate insulation pattern 130, a first gate electrode 140 and a gate mask 150 sequentially stacked in the third direction D3.

Impurities may be implanted into an upper portion of the active region 105 adjacent to the first gate structure 160 to form a source/drain layer, and the first gate structure 160 and the source/drain layer may collectively form a transistor. In example embodiments, the transistor may be a part of a sense amplifier (S/A).

A first insulating interlayer 120 may be formed on the active region 105 and the isolation layer 110 to cover, overlap, or be on a sidewall of the gate spacer 170, a second insulating interlayer 180 may be formed on the first insulating interlayer 120, the first gate structure 160 and the gate spacer 170, and a first contact plug 190 extending through the first and second insulating interlayers 120 and 180 to contact an upper surface of the source/drain layer and a second contact plug 195 extending through the second insulating interlayer 180 and the gate mask 150 to contact an upper surface of the first gate electrode 140 may be formed.

In example embodiments, the first insulating interlayer 120 may include an oxide, e.g., silicon oxide, and the second insulating interlayer 180 may include an insulating nitride, e.g., silicon nitride.

A third insulating interlayer 200 may be formed on the second insulating interlayer 180 and the first and second contact plugs 190 and 195, and a first wiring 210 may be formed through the third insulating interlayer 200. In example embodiments, the first wiring 210 may extend in the first direction D1, and a plurality of first wirings 210 may be spaced apart from each other in the second direction D2. Each of the first wirings 210 may contact an upper surface of a corresponding one of the first and second contact plugs 190 and 195. In example embodiments, the third insulating interlayer 200 may include an insulating nitride, e.g., silicon nitride, and thus, in some cases, may be merged with the second insulating interlayer 180.

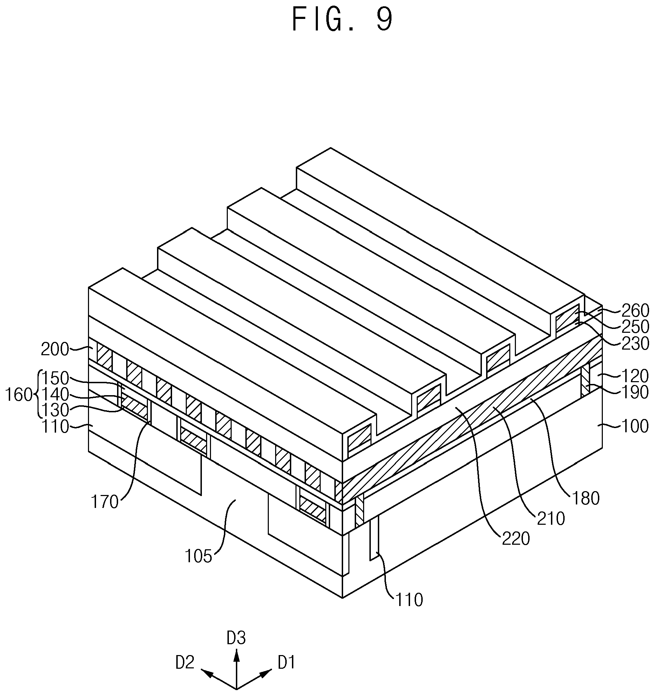

Referring to FIGS. 9 to 12, a fourth insulating interlayer 220 and a first insulation layer may be sequentially formed on the third insulating interlayer 200 and the first wiring 210, and a third contact plug 240 may be formed through the fourth insulating interlayer 220 to contact an upper surface of the first wiring 210.

In example embodiments, the fourth insulating interlayer 220 may include an oxide, e.g., silicon oxide, and the first insulation layer may include an insulating nitride, e.g., silicon nitride.

A second wiring layer may be formed on the first insulation layer and the third contact plug 240, and the second wiring layer and the first insulation layer may be patterned to form a second wiring 250 and a first insulation pattern 230, respectively. In example embodiments, the second wiring 250 may extend in the second direction D2, and a plurality of second wirings 250 may be spaced apart from each other in the first direction D1. Each of the second wirings 250 may contact an upper surface of the third contact plug 240.

A second insulation layer 260 may be formed to cover, overlap, or be on the second wiring 250 and the first insulation pattern 230. In example embodiments, the second insulation layer 260 may include an insulating nitride, and thus, in some cases, may be merged with the first insulation pattern 230.

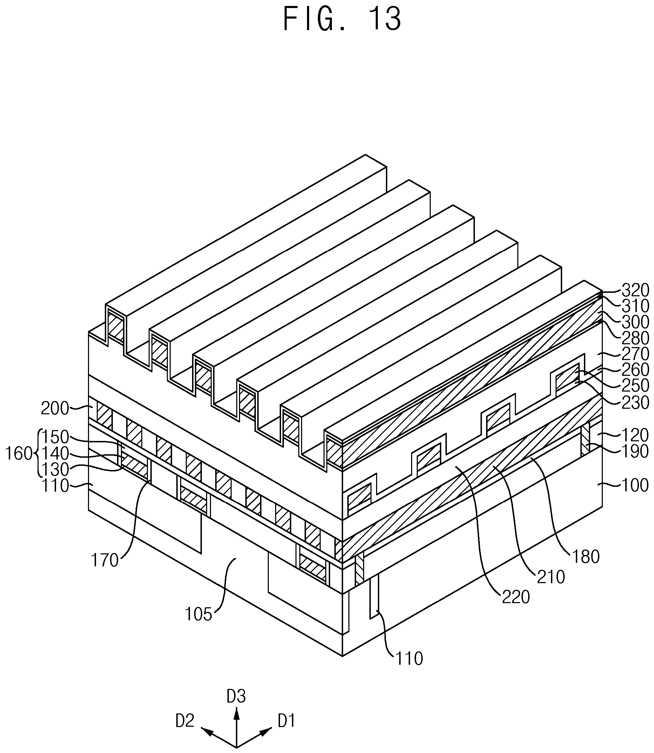

Referring to FIGS. 13 to 15, a fifth insulating interlayer 270 and a third insulation layer may be sequentially stacked on the second insulation layer 260, and a fourth contact plug 290 may be formed through the third insulation layer, an upper portion of the fifth insulating interlayer 270 and the second insulation layer 260 to contact an upper surface of the second wiring 250.

A third wiring layer and a fourth insulation layer may be sequentially stacked on the third insulation layer, and an etching process may be performed on the fourth insulation layer, the third wiring layer and the third insulation layer to form a fourth insulation pattern 310, a third wiring 300 and a third insulation pattern 280, respectively. During the etching process, an upper portion of the fifth insulating interlayer 270 may also be removed.

In example embodiments, the third wiring 300 may extend in the first direction D1, and a plurality of third wirings 300 may be spaced apart from each other in the second direction D2. Each of the third wirings 300 may be electrically connected to a corresponding one of the second wirings 250 through a corresponding fourth contact plug 290. In example embodiments, each of the third wirings 300 may serve as a bit line.

In example embodiments, the fifth insulating interlayer 270 may include an oxide, e.g., silicon oxide, and each of the third and fourth insulation patterns 280 and 310 may include an insulating nitride, e.g., silicon nitride.

A fifth insulation layer 320 may be formed on the fifth insulating interlayer 270, the third and fourth insulation patterns 280 and 310 and the third wiring 300. In example embodiments, the fifth insulation layer 320 may include an insulating nitride, e.g., silicon nitride, and thus, in some cases, may be merged with the third and/or fourth insulation patterns 280 and 310.

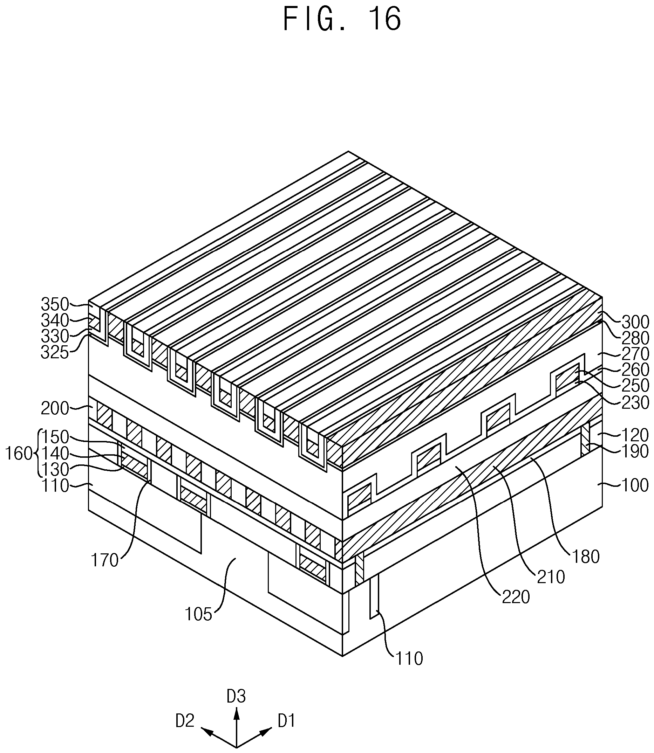

Referring to FIGS. 16 to 18, a sixth insulation layer and a fourth wiring layer may be sequentially formed on the fifth insulation layer 320 shown in FIGS. 13 to 15, and an upper portion of the fourth wiring layer may be removed by, e.g., an etch back process to form a fourth wiring 340.

A seventh insulation layer may be formed on the fourth wiring 340 and the sixth insulation layer, and a planarization process may be performed on the sixth and seventh insulation layers until an upper surface of the third wiring 300 is exposed to form sixth and seventh insulation patterns 330 and 350, respectively.

During the planarization process, an upper portion of the fifth insulation layer 320 may be removed to form a plurality of fifth insulation patterns 325 spaced apart from each other in the second direction D2, and the fourth insulation pattern 310 may be removed. Each of the sixth and seventh insulation patterns 330 and 350 and the fourth wiring 340 may extend in the first direction D1. A plurality of sixth insulation patterns 330 may be spaced apart from each other in the second direction D2, a plurality of seventh insulation patterns 350 may be spaced apart from each other in the second direction D2, and a plurality of fourth wirings 340 may be spaced apart from each other in the second direction D2. In example embodiments, the fourth wiring 340 may be disposed adjacent to the third wiring 300 serving as a bit line, and may serve as a bit line shield. A cross-section in the second direction D2 of each of the fifth and sixth insulation patterns 325 and 330 may have a shape of a cup, with a lower surface and sidewalls, or a U-shape.

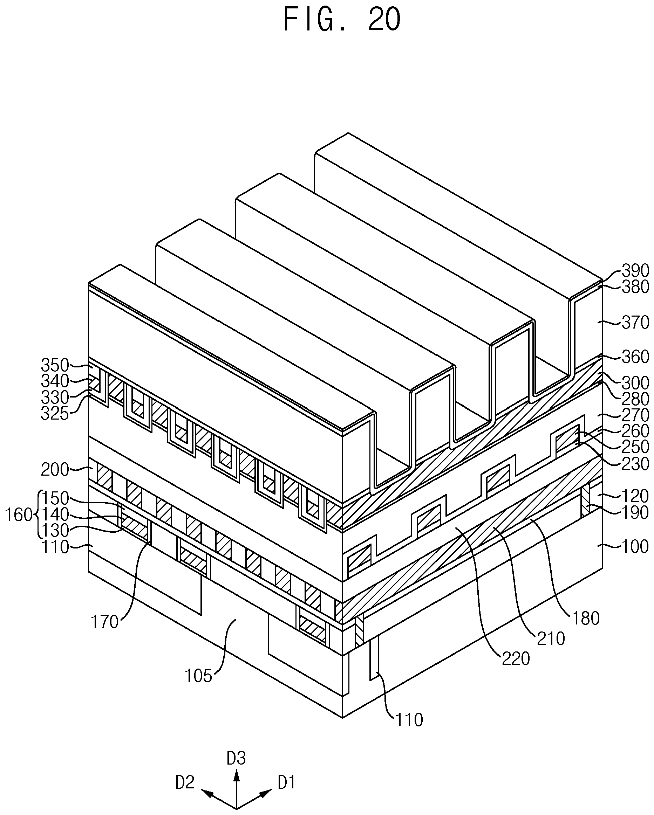

Referring to FIGS. 20 to 23, an eighth insulation layer and a first mold layer may be sequentially formed on the fifth, sixth and seventh insulation patterns 325, 330 and 350 and the third wiring 300, and the first mold layer and the eighth insulation layer may be patterned by an etching process to form a first mold 370 and an eighth insulation pattern 360, respectively, and during the etching process, upper portions of the fifth, sixth and seventh insulation patterns 325, 330 and 350 and the third wiring 300 may also be removed.

In example embodiments, each of the first mold 370 and the eighth insulation pattern 360 may extend in the second direction D2. A plurality of first molds 370 may be spaced apart from each other in the first direction D1, and a plurality of eighth insulation patterns 360 may be spaced apart from each other in the first direction D1.

A channel layer 380 may be formed to cover, overlap, or be on the first mold 370 and the eighth insulation pattern 360, and a first capping layer 390 may be formed on the channel layer 380.

In example embodiments, the channel layer 380 may include an oxide semiconductor material, e.g., indium gallium zinc oxide (IGZO), and the first capping layer 390 may include an insulating material, e.g., silicon nitride, silicon oxide, silicon oxycarbide, silicon oxycarbonitride, aluminum oxide, etc.

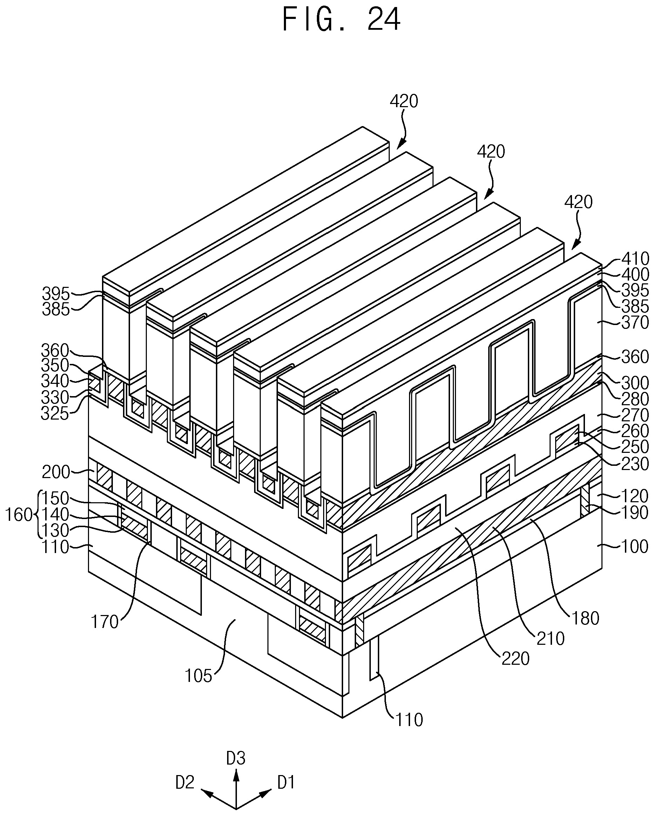

Referring to FIGS. 24 to 27, a second mold layer and a mask layer may be sequentially formed on the first capping layer 390, the mask layer may be patterned to form a plurality of masks 410, each of which may extend in the first direction D1, spaced apart from each other in the second direction D2, and a dry etching process may be performed using the mask 410 as an etching mask to pattern the second mold layer, the first capping layer 390, the channel layer 380, the first mold 370 and the eighth insulation pattern 360, so that an opening 420 may be formed to expose an upper surface of the seventh insulation pattern 350.

Thus, the second mold layer may be divided into a plurality of second molds 400, each of which may extend in the first direction D1, spaced apart from each other in the second direction D2. The first capping layer 390 may be divided into first capping patterns, each of which may extend in the first direction D1, spaced apart from each other in the second direction D2, and the channel layer 380 may be divided into channels, each of which may extend in the first direction D1, spaced apart from each other in the second direction D2. The first mold 370 extending in the second direction D2 may be divided into a plurality of parts spaced apart from each other in the second direction D2, and the eighth insulation pattern 360 extending in the second direction D2 may be divided into a plurality of parts spaced apart from each other in the second direction D2.

The second mold 400 may include, e.g., spin-on-hardmask (SOH) or amorphous carbon layer (ACL), and the mask 410 may include, e.g., silicon nitride.

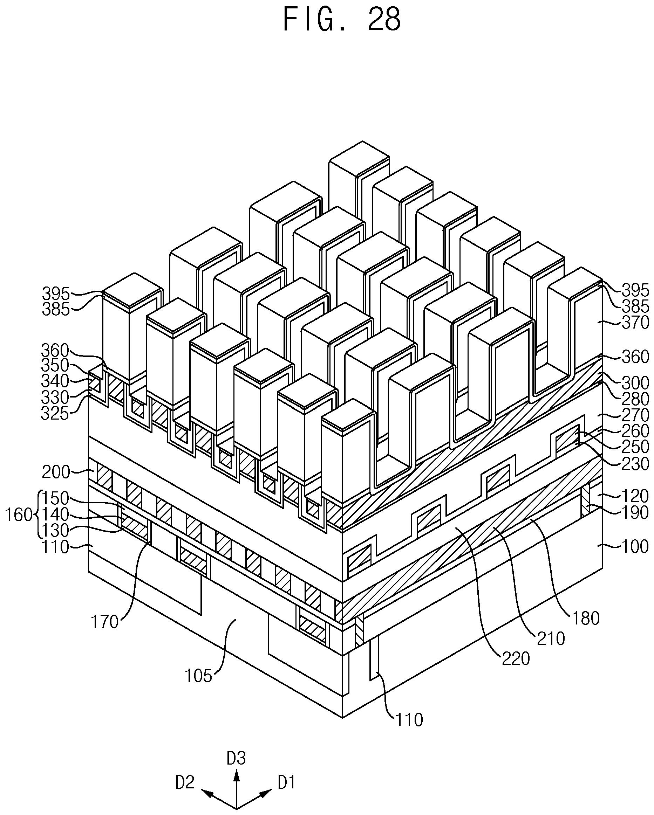

Referring to FIGS. 28 to 31, the mask 410 and the second mold 400 may be removed, and thus an upper surface of the first capping pattern 395 may be exposed.

In example embodiments, the mask 410 may be removed by an etching process, and the second mold 400 may be removed by, e.g., an ashing process and/or a stripping process. During the removal of the second mold 400, the channel 385 may be covered or overlapped by the first capping pattern 395, such that the channel 385 is not damaged.

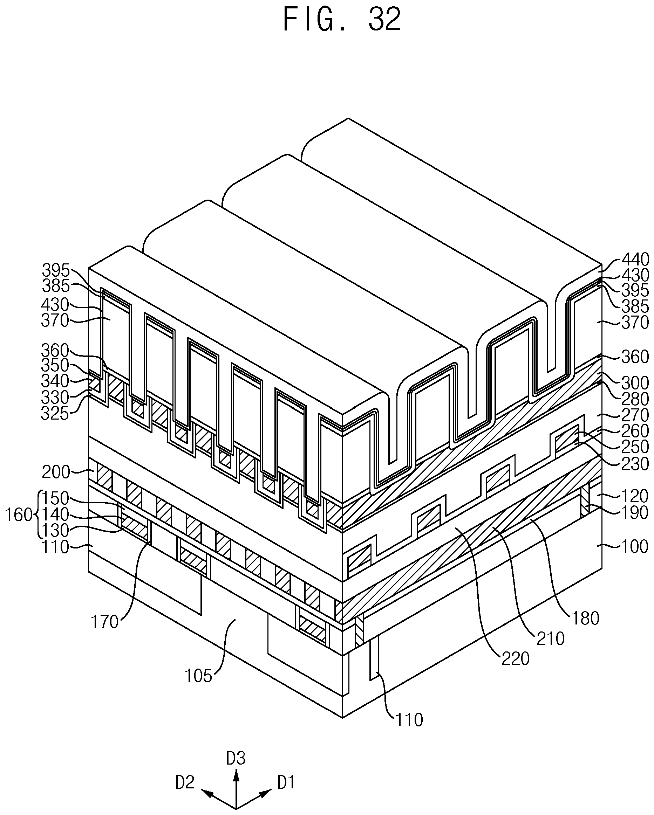

Referring to FIGS. 32 to 35, a second capping layer 430 may be formed on the first capping pattern 395, the channel 385, the first mold 370 and the seventh and eighth insulation patterns 350 and 360, and a sixth insulating interlayer 440 may be formed on the second capping layer 430.

The second capping layer 430 may include an insulating nitride, e.g., silicon nitride, silicon oxide, silicon oxycarbide, silicon oxycarbonitride, aluminum oxide, etc. In example embodiments, the second capping layer 430 may include substantially the same material as the first capping pattern 395, and thus may be merged with the first capping pattern 395.

In example embodiments, the sixth insulating interlayer 440 may partially or completely fill a portion of the opening 420 between stack structures, each of which may include the eighth insulation pattern 360, the first mold 370, the channel 385, the first capping pattern 395 and a portion of the second capping layer 430 on upper surfaces and sidewalls of the eighth insulation pattern 360, the first mold 370, the channel 385 and the first capping pattern 395, and may cover, overlap, or be on each of opposite sidewalls of the stack structure in the first direction D1. A plurality of second recesses 447, each of which may extend in the second direction D2, spaced apart from each other in the first direction D1 may be formed on a portion of the sixth insulating interlayer 440 between the stack structures spaced apart from each other in the first direction D1.

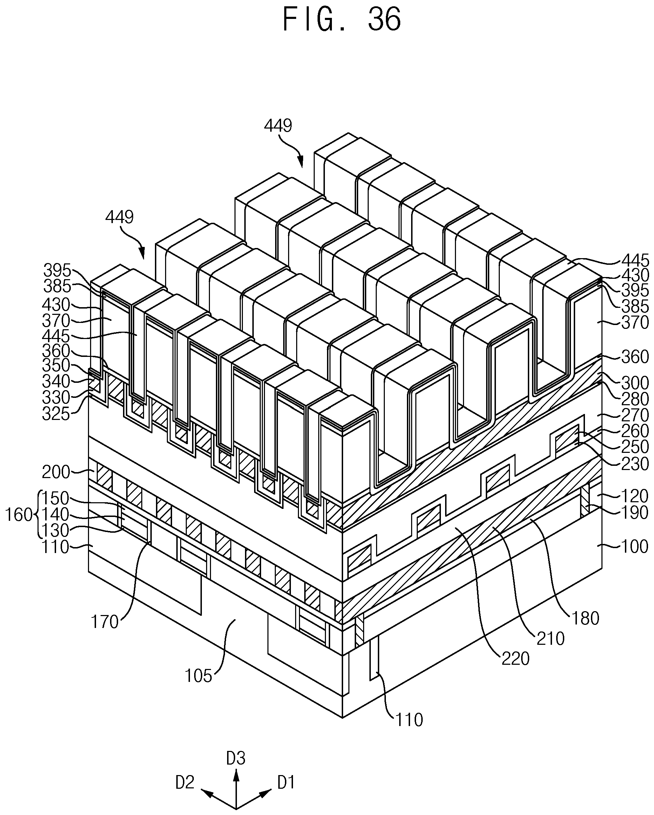

Referring to FIGS. 36 to 39, an isotropic etching process such as a wet etching process may be performed on the sixth insulating interlayer 440 to form a sixth insulating interlayer pattern 445.

In example embodiments, as the isotropic etching process is performed, an upper surface of the second capping layer 430 may be exposed, and most portions of the portion of the sixth insulating interlayer 440 between the stack structures spaced apart from each other in the first direction D1 may be removed, and an upper portion of a portion of the sixth insulating interlayer 440 between the stack structures spaced apart from each other in the second direction D2 may be removed.

Thus, in example embodiments, an upper surface of the sixth insulating interlayer pattern 445 may be lower than an upper surface of the channel 385 and higher than a lower surface of the channel 385, however, the inventive concept may not be limited thereto.

During the isotropic etching process, the channel 385 may be protected by the first capping pattern 395 and the second capping layer 430 and therefore may not be damaged.

The second recess 447 may be enlarged to a third recess 449 having width and depth greater than those of the second recess 447.

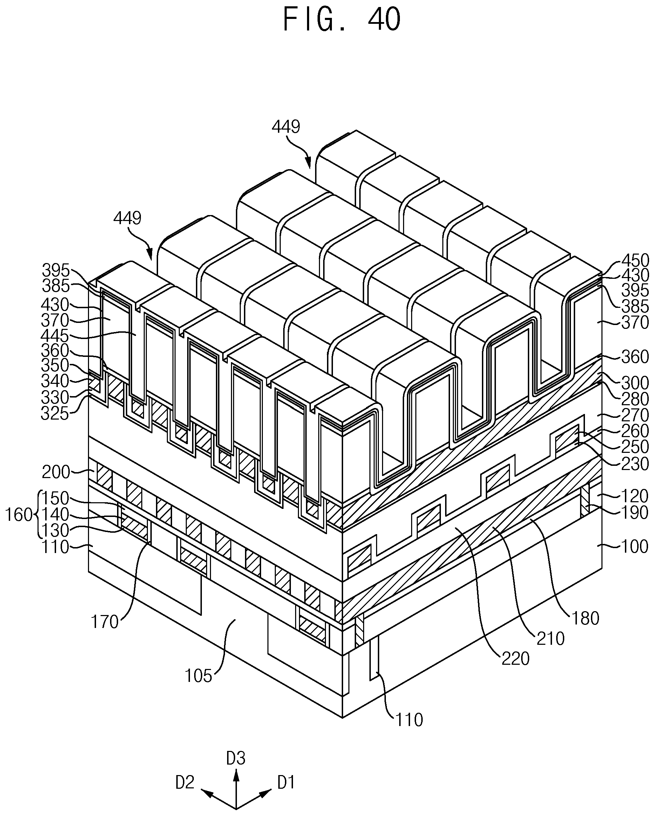

Referring to FIGS. 40 to 43, a second gate insulation layer 450 may be formed on the second capping layer 430 and the sixth insulating interlayer pattern 445.

The second gate insulation layer 450 may include an insulating nitride, e.g., silicon nitride, silicon oxide, silicon oxycarbide, silicon oxycarbonitride, aluminum oxide, etc. In example embodiments, the second gate insulation layer 450 may include substantially the same material as the second capping layer 430, and thus may be merged with the second capping layer 430.

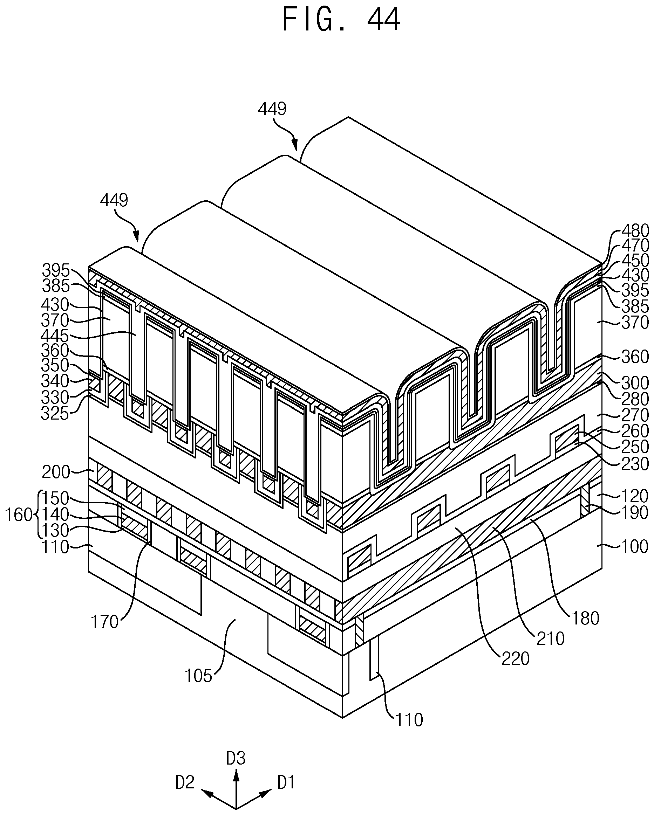

Referring to FIGS. 44 to 47, a second gate electrode layer 470 and a third capping layer 480 may be sequentially formed on the second gate insulation layer 450.

The third capping layer 480 may include an insulating nitride, e.g., silicon nitride.

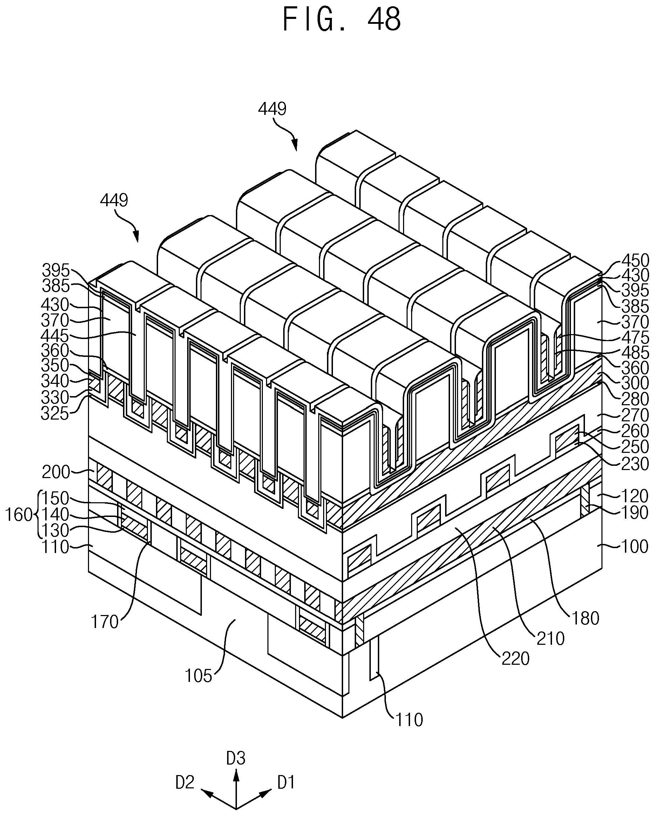

Referring to FIGS. 48 to 51, an anisotropic etching process may be performed on the third capping layer 480 and the second gate electrode layer 470 to form a third capping pattern 485 and a second gate electrode 475, respectively.

In example embodiments, each of the third capping pattern 485 and the second gate electrode 475 may extend in the second direction D2 on the second gate insulation layer 450. A plurality of third capping patterns 485 may be spaced apart from each other in the first direction D1, and a plurality of second gate electrodes 475 may be spaced apart from each other in the first direction D1.

Each of the second gate electrodes 475 may be formed on a portion of the second gate insulation layer 450 on a sidewall in the first direction D1 of each of the stack structures neighboring in the first direction D1, and the second gate electrodes 475 in the third recess 449 may face each other in the first direction D1. By the anisotropic etching process, an upper surface and a sidewall of an upper portion of the second gate insulation layer 450 and an upper surface of a portion of the second gate insulation layer 450 on a bottom of the third recess 449 may be exposed.

A sidewall and a lower surface of the third capping pattern 485 may be covered or overlapped by the second gate electrode 475.

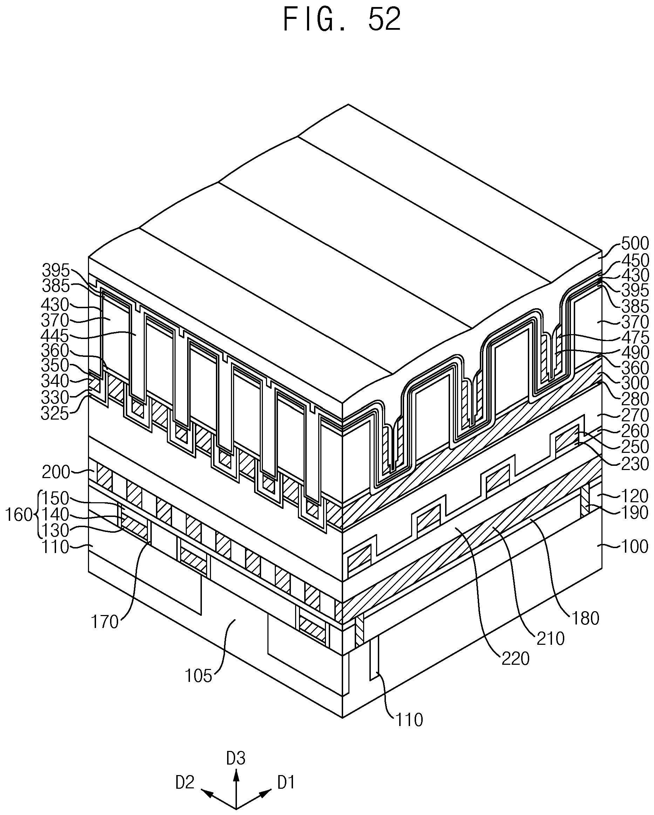

Referring to FIGS. 52 to 55, an etch stop layer 490 may be formed on the second gate insulation layer 450, the second gate electrode 475 and the third capping pattern 485, and a seventh insulating interlayer 500 may be formed on the etch stop layer 490 to partially or completely fill the third recess 449.

The etch stop layer 490 may include an insulating nitride, e.g., silicon nitride. In example embodiments, the etch stop layer 490 may include substantially the same material as the third capping pattern 485, and thus may be merged with the third capping pattern 485. The seventh insulating interlayer 500 may include an oxide, e.g., silicon oxide.

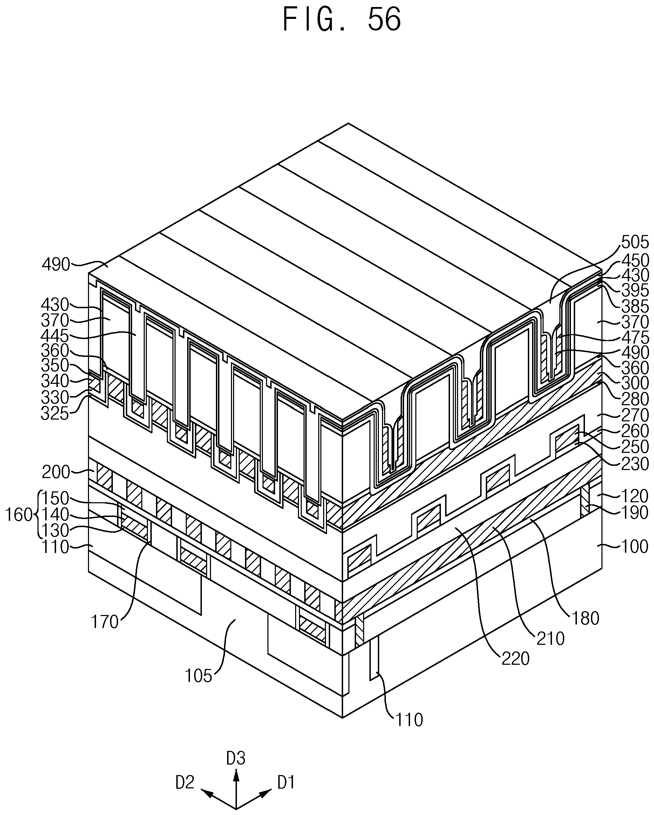

Referring to FIGS. 56 to 58, a planarization process, e.g., an etch back process may be performed on the seventh insulating interlayer 500 until an upper surface of the etch stop layer 490 is exposed to form a seventh insulating interlayer pattern 505.

In example embodiments, the seventh insulating interlayer pattern 505 may extend in the second direction D2, and a plurality of seventh insulating interlayer patterns 505 may be spaced apart from each other in the first direction D1.

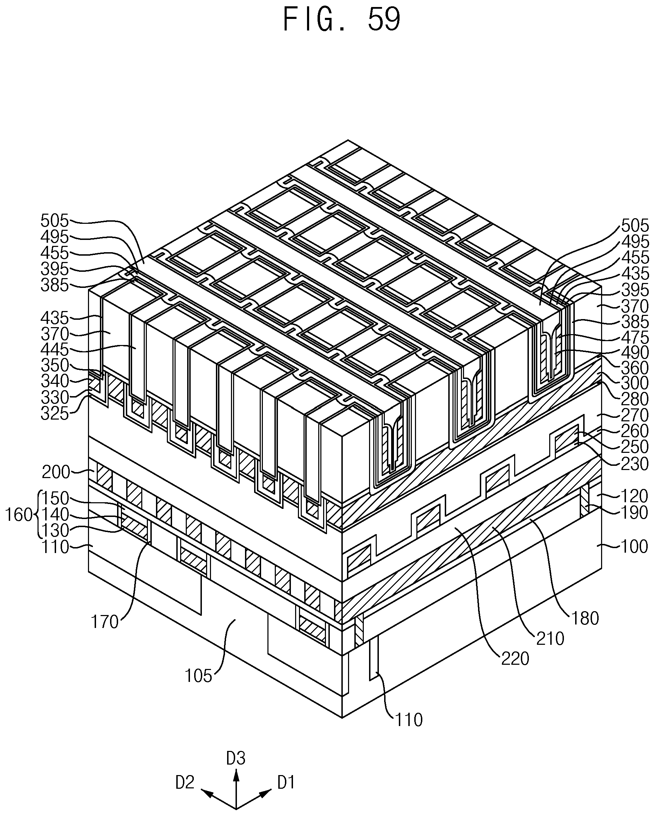

Referring to FIGS. 59 to 62, a planarization process may be performed on upper portions of the seventh insulating interlayer pattern 505, the etch stop layer 490, the second gate insulation layer 450, the second capping layer 430, the first capping pattern 395 and the channel 385.

The planarization process may include a chemical mechanical polishing (CMP) process and/or an etch back process.

By the planarization process, the etch stop layer 490, the second gate insulation layer 450 and the second capping layer 430 may be transformed into an etch stop pattern 495, a second gate insulation pattern 455 and a second capping pattern 435, respectively. Each of the etch stop pattern 495 and the second gate insulation pattern 455 may extend in the second direction D2. A plurality of etch stop patterns 495 may be spaced apart from each other in the first direction D1, and a plurality of second gate insulation patterns 455 may be spaced apart from each other in the first direction D1. The second gate electrode 475 and the second gate insulation pattern 455 may collectively form a second gate structure.

The channel 385 extending in the first direction D1 may be divided into a plurality of parts spaced apart from each other in the first direction D1.

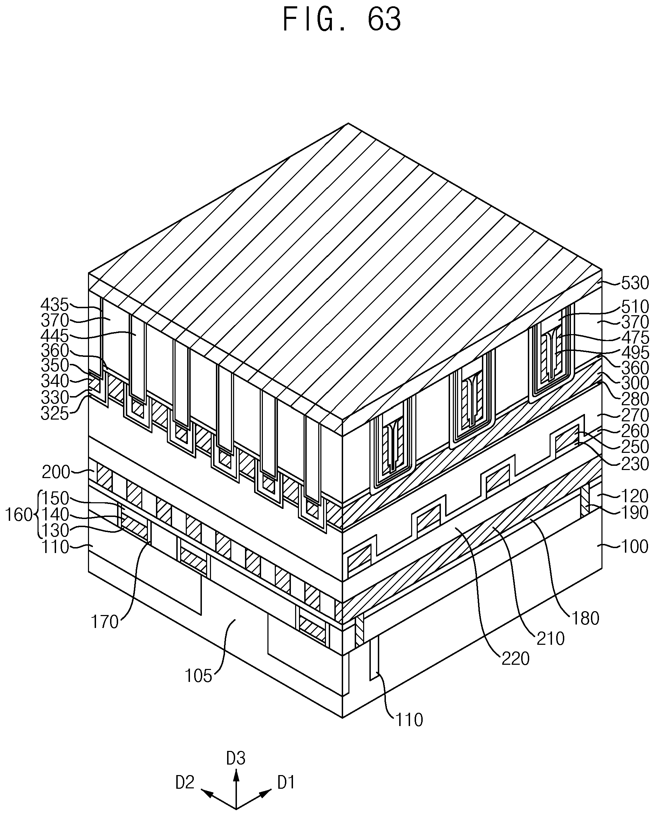

Referring to FIGS. 63 to 65, an etching process may be performed to remove an upper portion of the seventh insulating interlayer pattern 505 to form a fourth recess, and a fourth capping pattern 510 may be formed in the fourth recess.

In example embodiments, during the etching process, upper surfaces of the second gate electrode 475 and the etch stop pattern 495 may be exposed, or upper portions of the second gate electrode 475 and the etch stop pattern 495 may also be removed.

An upper portion of the channel 385 may be removed to form a fifth recess, and a landing pad layer 530 may be formed on the first mold 370, the channel 385, the first and second capping patterns 395 and 435, the second gate insulation pattern 455, the sixth and seventh insulating interlayer patterns 445 and 505, the second gate electrode 475, the etch stop pattern 495 and the fourth capping pattern 510 to partially or completely fill the fifth recess.

In example embodiments, a portion of the landing pad layer 530 in the fifth recess may contact an upper surface of the channel 385.

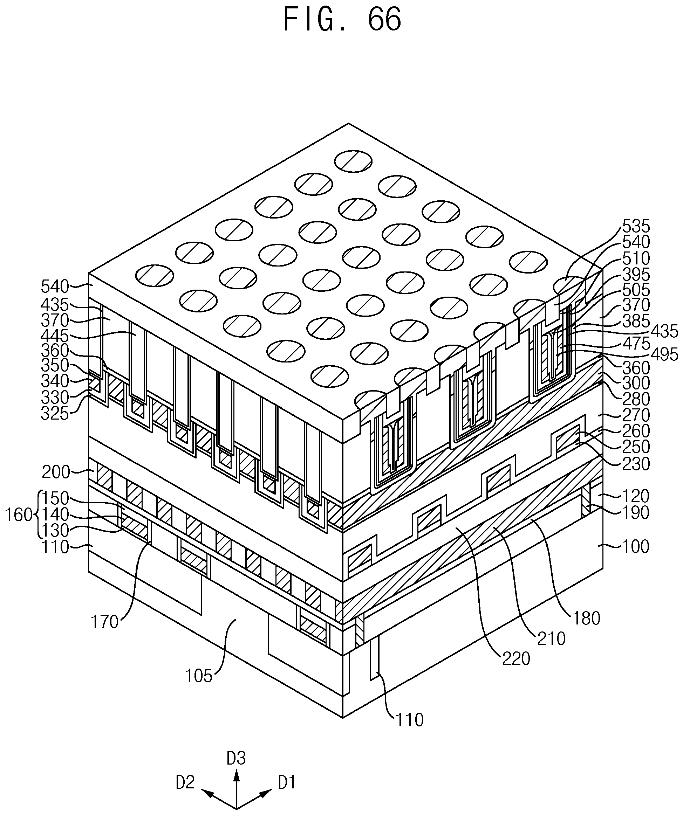

Referring to FIGS. 66 to 68, an etching process may be performed to form a sixth recess through the landing pad layer 530 and upper portions of the first mold 370, the channel 385, the first and second capping patterns 395 and 435, the second gate insulation pattern 455, the sixth insulating interlayer pattern 445 and the fourth capping pattern 510, and an eighth insulating interlayer pattern 540 may be formed in the sixth recess.

By the etching process, the landing pad layer 530 may be divided into a plurality of landing pads 535 spaced apart from each other in each of the first and second directions D1 and D2. In example embodiments, each of the landing pads 535 may have a shape of, e.g., a circle, an ellipse, a polygon, a polygon with rounded corners, etc., in a plan view, and may contact the upper surface of the channel 385 through a lower portion of the landing pad 535 in the fifth recess.

Referring back to FIGS. 1 to 3, first and second support layers 550 and 560 may be formed on the eighth insulating interlayer pattern 540 and the landing pad 535, and capacitors 570 may be formed through the first and second support layers 550 and 560 to contact upper surfaces of the landing pads 535, respectively, to complete the fabrication of the semiconductor device.

As illustrated above, the first capping layer 390 may be formed on the channel layer 380, the second mold layer may be formed on the first capping layer 390, the masks 410 may be formed on the second mold layer, a dry etching process may be performed using the masks 410 as an etching mask to pattern the second mold layer, the first capping layer 390 and the channel layer 380, so that the channel layer 380 may be divided into a plurality of channels 385, each of which may extend in the first direction D1, spaced apart from each other in the second direction D2.

Additionally, the second capping layer 430 may be formed on the channel 385, the sixth insulating interlayer 440 may be formed on the second capping layer 430, and an isotropic etching process such as a wet etching process may be performed on the sixth insulating interlayer 440 to form the sixth insulating interlayer pattern 445. During the isotropic etching process, the channel 385 may be protected by the first capping pattern 395 such that the second capping layer 430 is not damaged.

As a result, the channel 385 may be protected by the first capping pattern 395 and the second capping layer 430 during the formation of the channel 385 and subsequent processes, so that the semiconductor device including the channel 385 may have enhanced electrical characteristics.

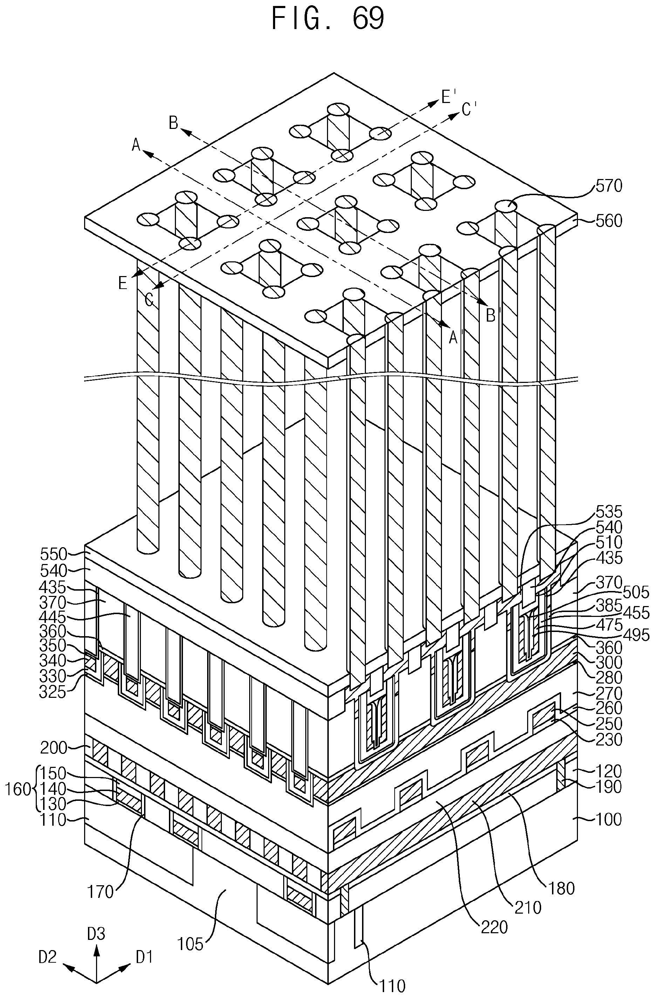

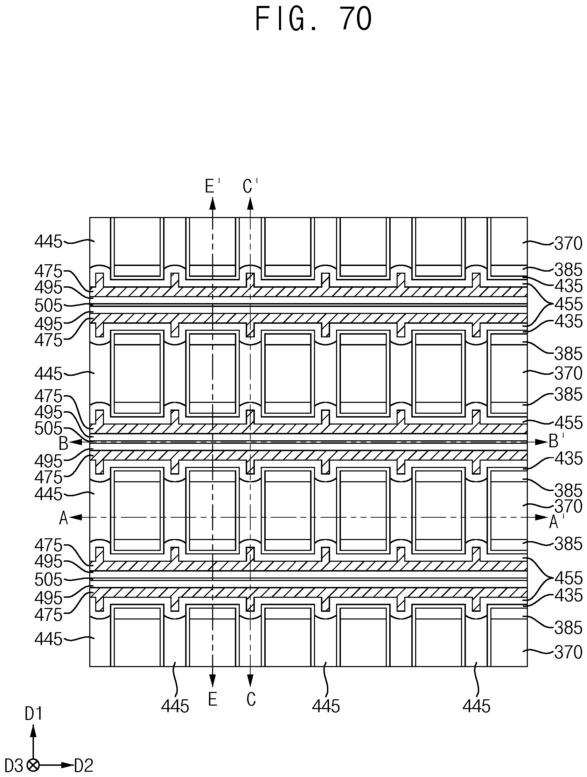

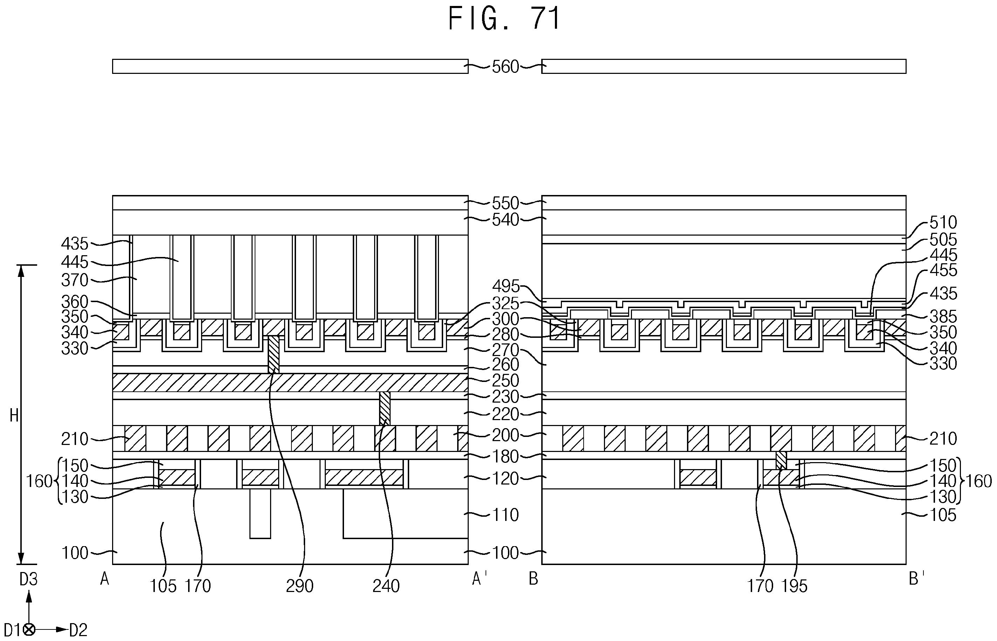

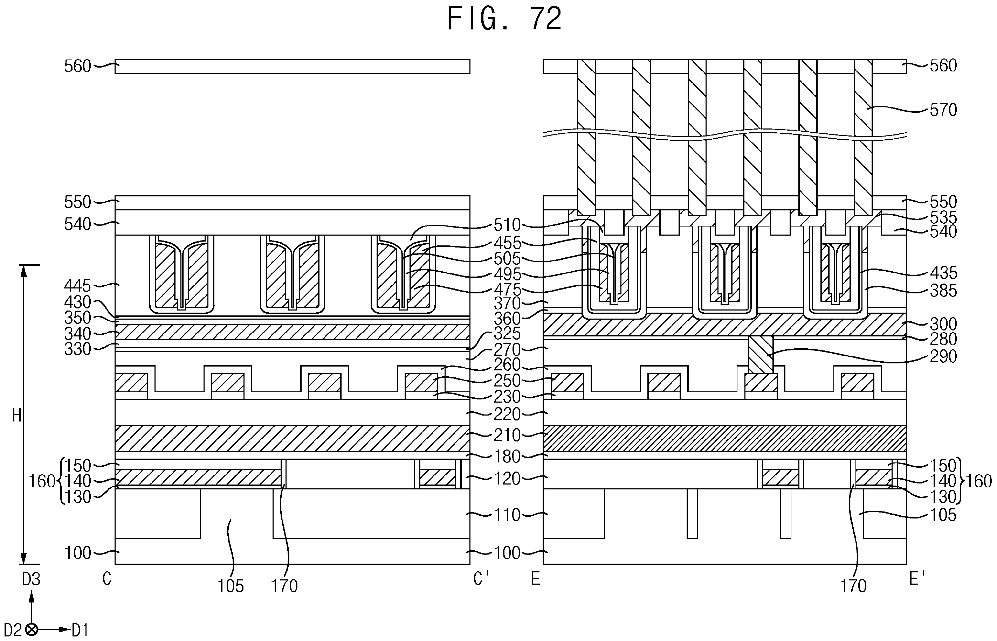

FIGS. 69 to 72 are a perspective view, a horizontal cross-sectional view and vertical cross-sectional views illustrating a semiconductor device in accordance with example embodiments, which may correspond to FIGS. 1 to 4, respectively.

This semiconductor device may be substantially the same as or similar to that of FIGS. 1 to 4, except for some elements, and thus repeated explanations are omitted herein.

Referring to FIGS. 69 to 72, the semiconductor device may not include the first capping pattern 395.

Thus, a sidewall of the channel 385 in the first direction D1 that does not contact the sidewall of the first mold 370 may be covered or overlapped by the second capping pattern 435 instead of the first capping pattern 395.

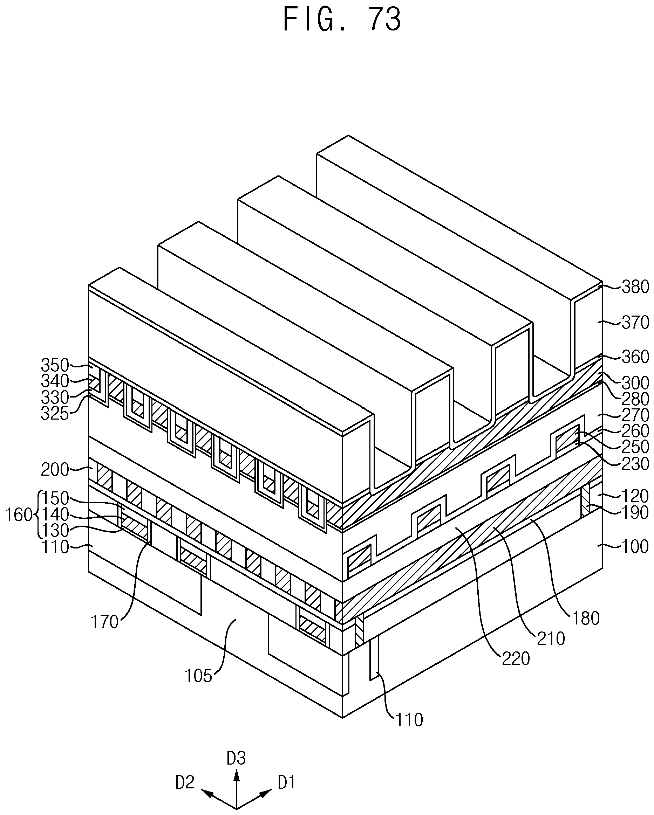

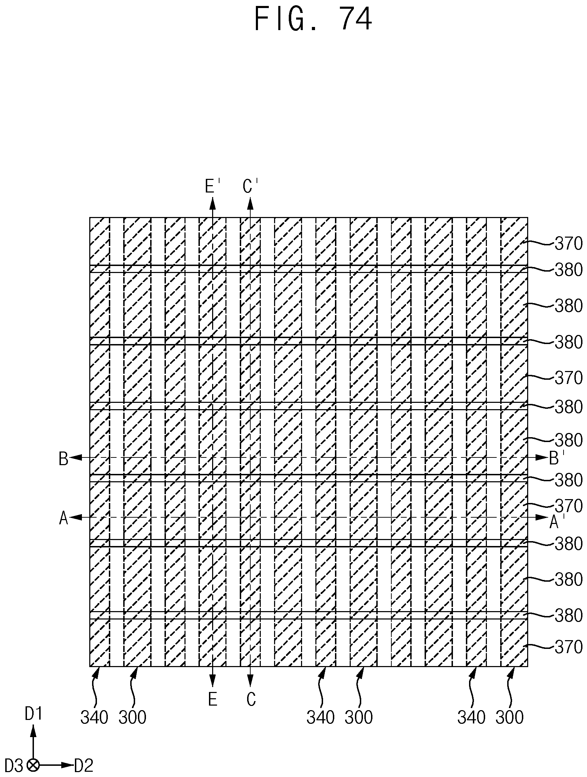

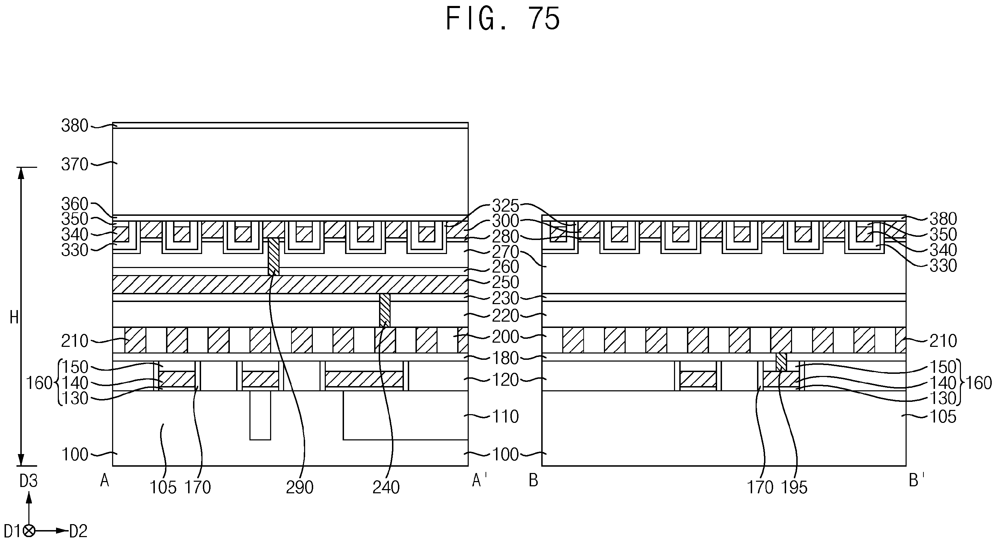

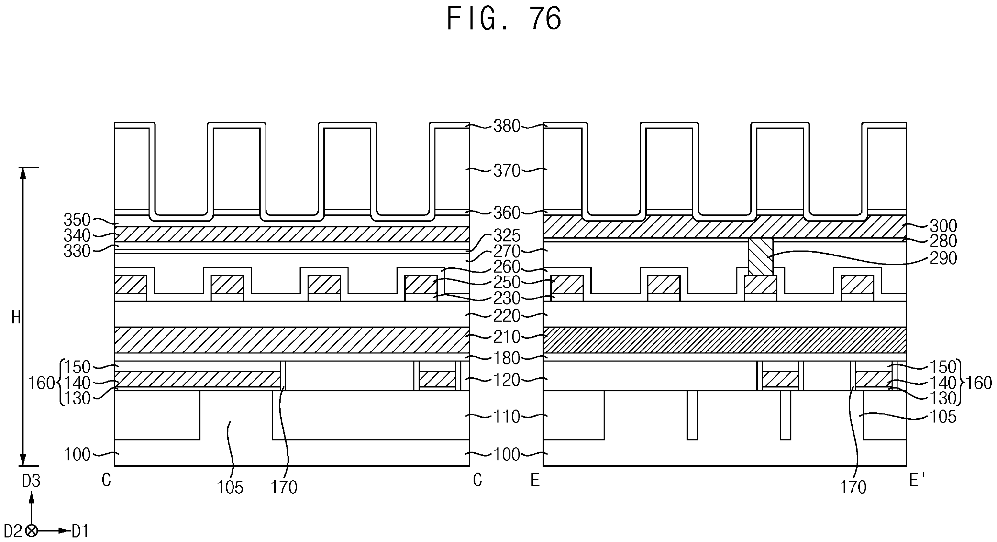

FIGS. 73 to 76 are a perspective view, a horizontal cross-sectional view and vertical cross-sectional views illustrating a method of manufacturing a semiconductor device in accordance with example embodiments.

This method may include processes substantially the same as or similar to those illustrated with respect to FIGS. 5 to 68 and FIGS. 1 to 4, and thus repeated explanations thereof are omitted herein.

Referring to FIGS. 73 to 76, processes substantially the same as or similar to those illustrated with respect to FIGS. 5 to 23 may be performed.

However, the first capping layer 390 may not be formed on the channel layer 380.

Processes substantially the same as or similar to those illustrated with respect to FIGS. 24 to 68 and FIGS. 1 to 4 may be performed to complete the fabrication of the semiconductor device.

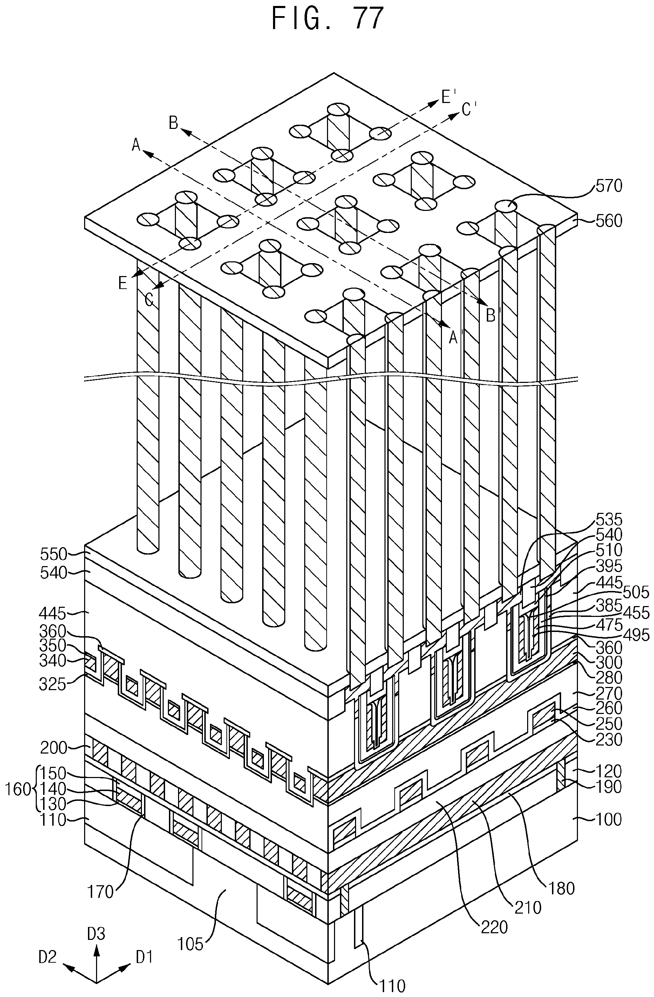

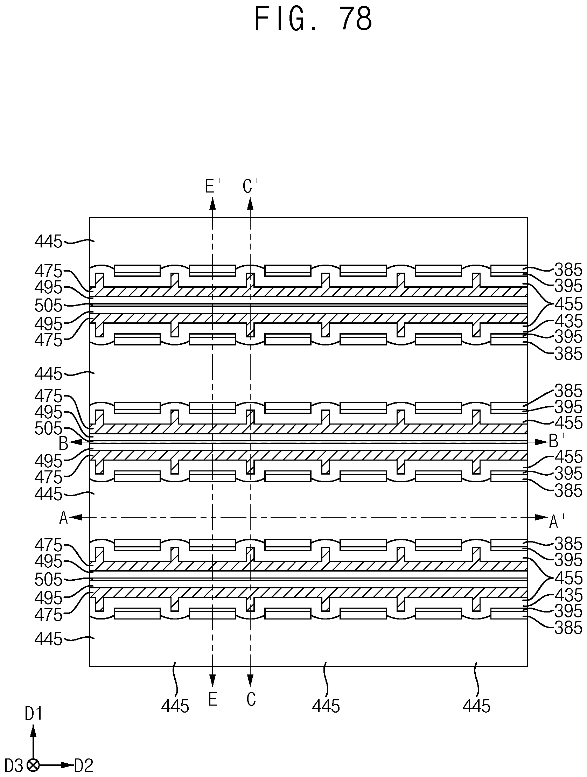

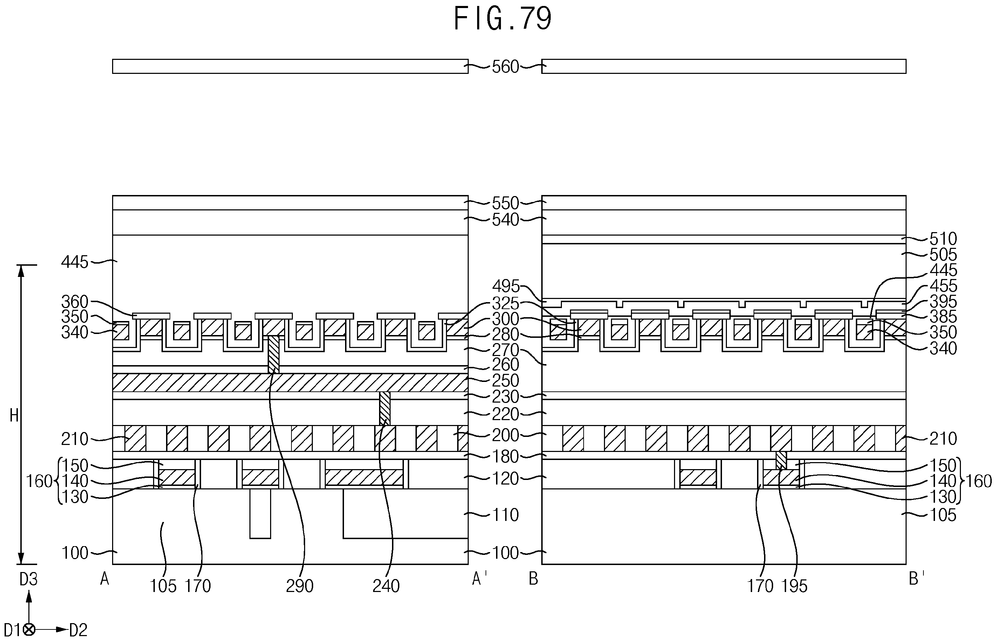

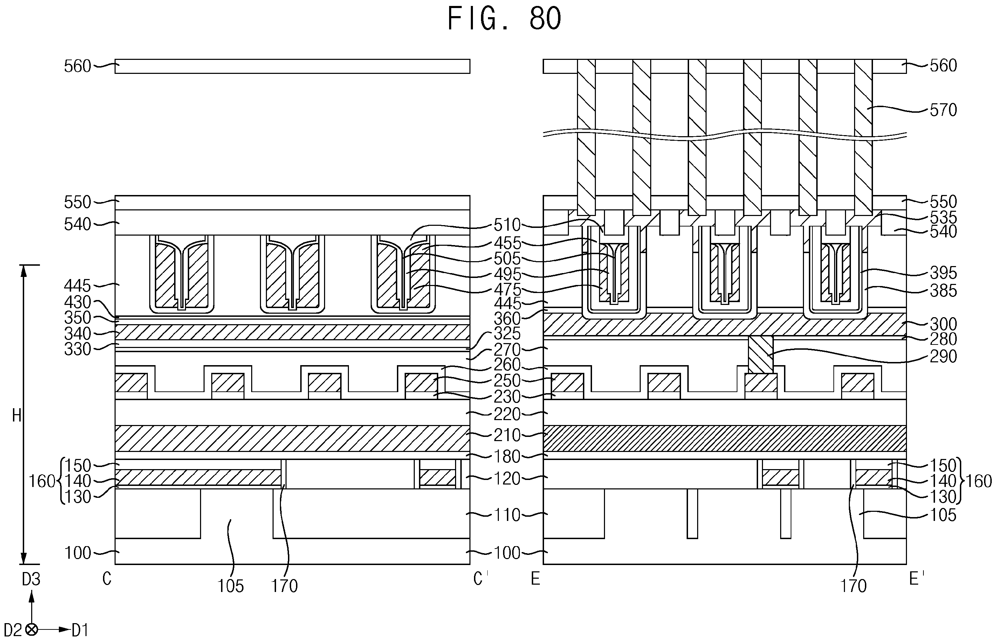

FIGS. 77 to 80 are a perspective view, a horizontal cross-sectional view and vertical cross-sectional views illustrating a semiconductor device in accordance with example embodiments, which may correspond to FIGS. 1 to 4, respectively.

This semiconductor device may be substantially the same as or similar to that of FIGS. 1 to 4, except for some elements, and thus repeated explanations are omitted herein.

Referring to FIGS. 77 to 80, the semiconductor device may include the second capping pattern 435.

The sixth insulating interlayer pattern 445 may include substantially the same material as that of the sixth insulation pattern 330 and the first mold 370, and thus the sixth insulating interlayer pattern 445, the sixth insulation pattern 330 and the first mold 370 may be merged with each other to form a single structure, that is, the sixth insulating interlayer pattern 445.

Thus, a first sidewall in the first direction D1 of the channel 385 may be covered or overlapped by the first capping pattern 395, and a second sidewall in the first direction D1 of the channel 385 and opposite sidewalls in the second direction D2 of the channel 385 may contact the sixth insulating interlayer pattern 445.

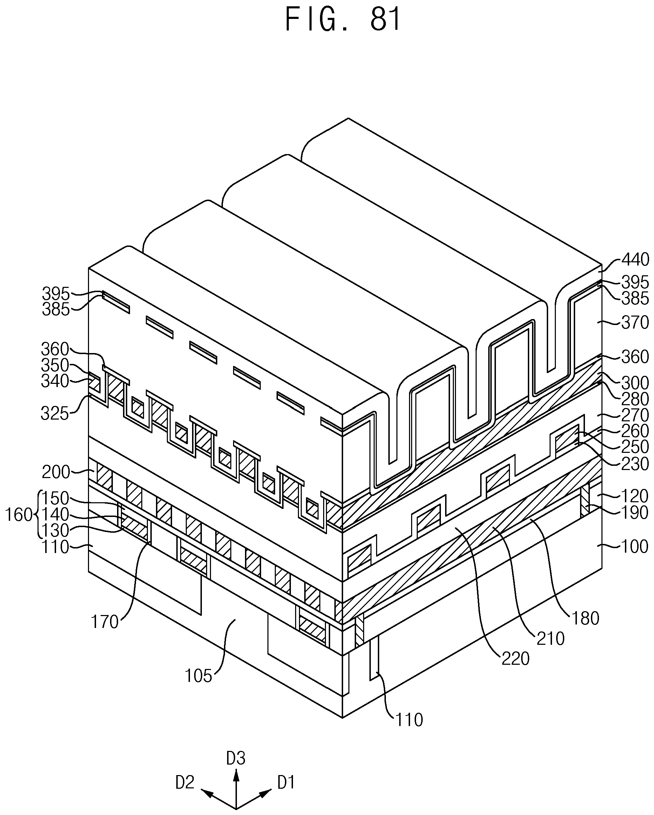

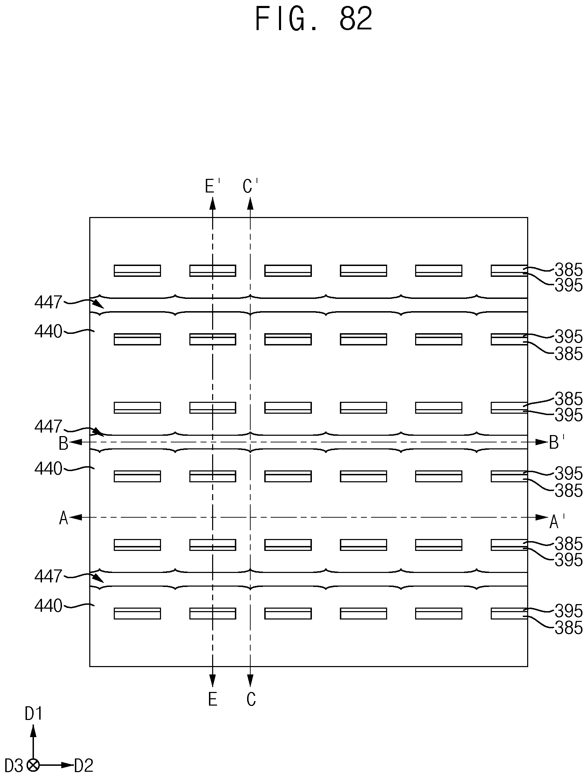

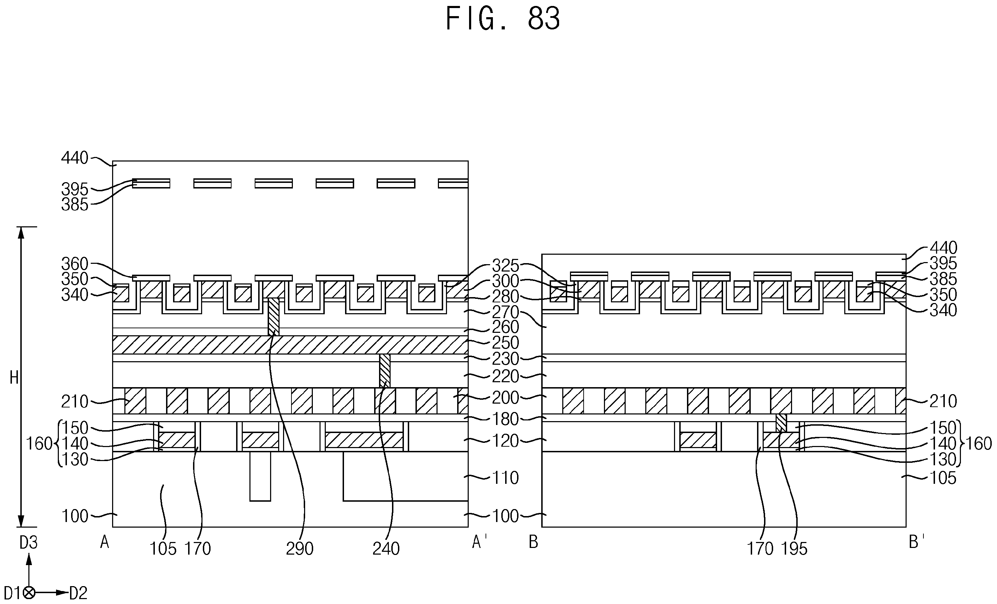

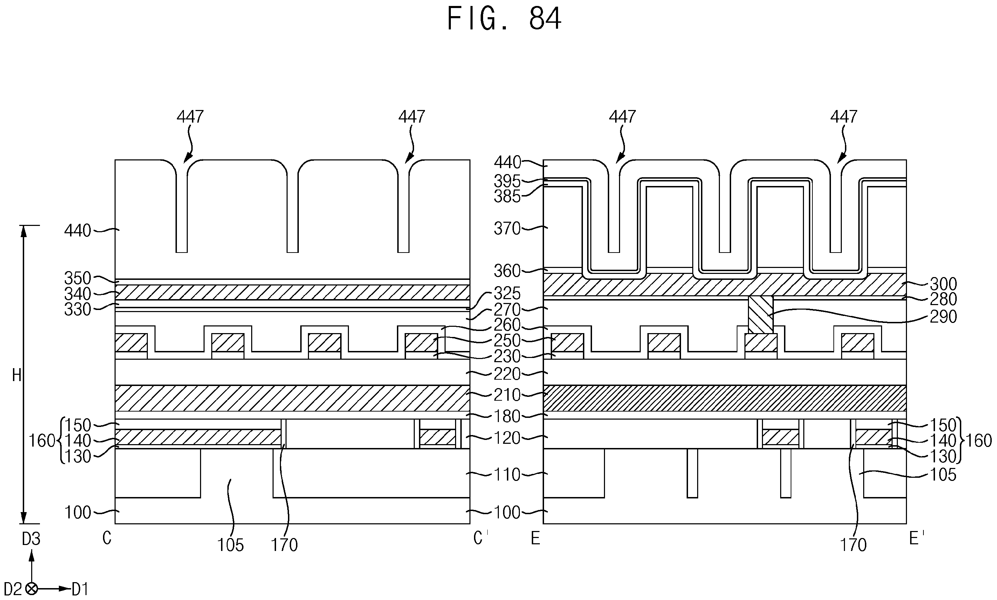

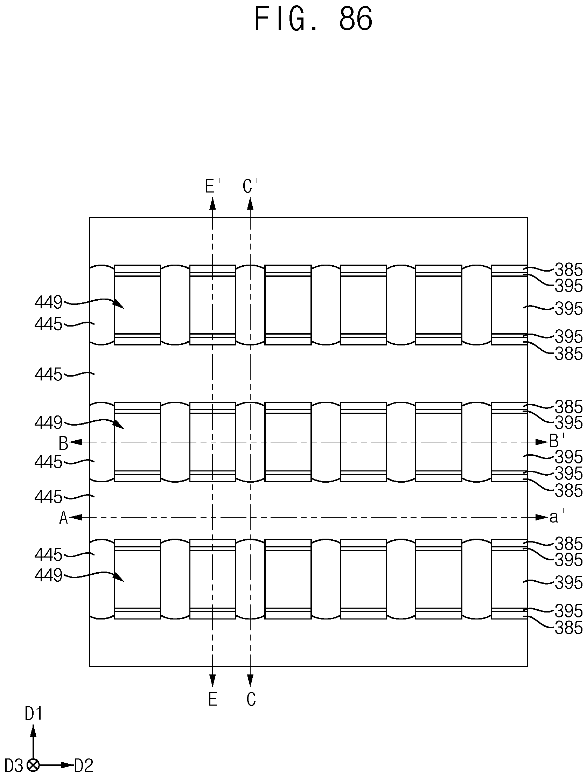

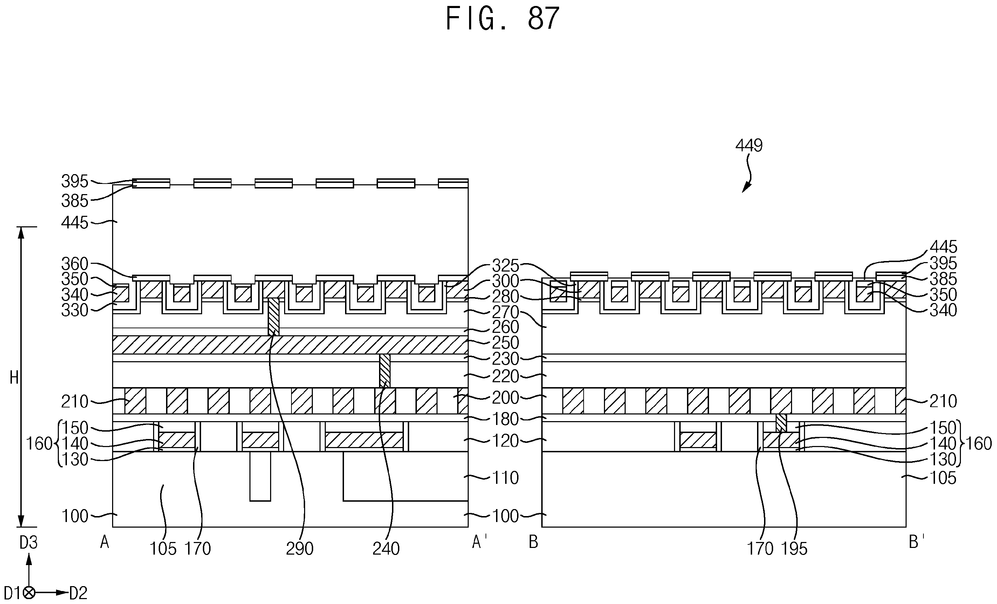

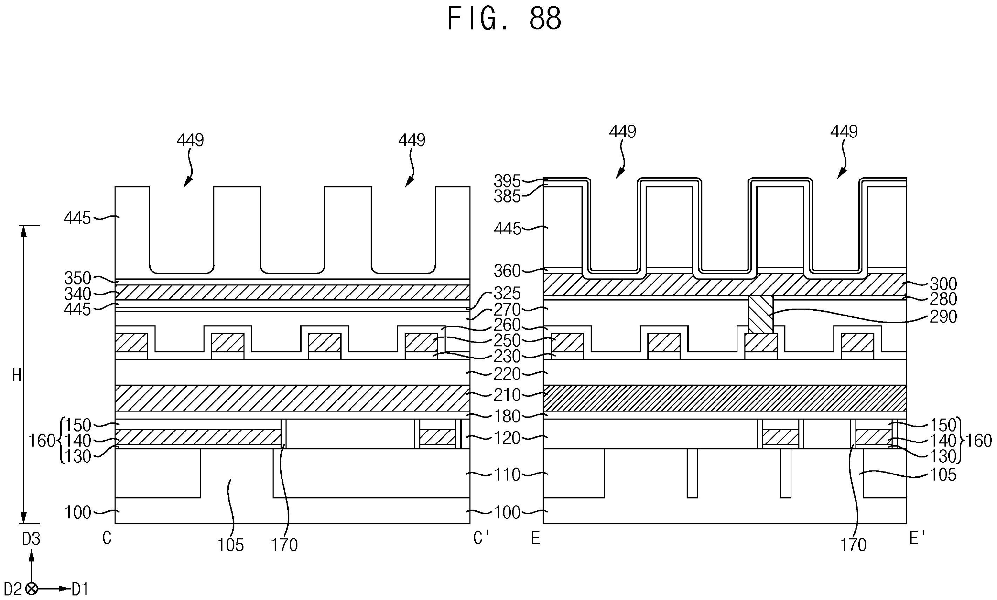

FIGS. 81 to 88 are a perspective view, a horizontal cross-sectional view and vertical cross-sectional views illustrating a method of manufacturing a semiconductor device in accordance with example embodiments.

This method may include processes substantially the same as or similar to those illustrated with respect to FIGS. 5 to 68 and FIGS. 1 to 4, and thus repeated explanations thereof are omitted herein.

Referring to FIGS. 81 to 84, processes substantially the same as or similar to those illustrated with respect to FIGS. 5 to 35 may be performed.

However, the second capping layer 430 may not be formed on the first capping pattern 395, the channel 385, the first mold 370 and the seventh and eighth insulation patterns 350 and 360, and the sixth insulating interlayer 440 may be formed thereon.

The sixth insulating interlayer 440 may include an oxide, e.g., silicon oxide. In example embodiments, the sixth insulating interlayer 440 may include substantially the same material as the sixth insulation pattern 330 and the first mold 370, and thus may be merged with each other to form a single structure. Hereinafter, the merged structure may be referred to as the sixth insulating interlayer 440.

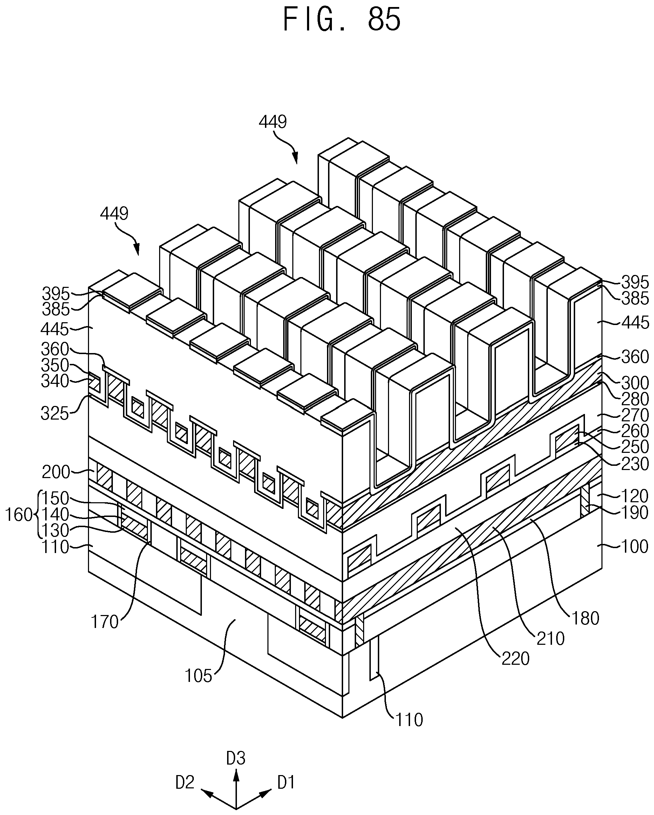

Referring to FIGS. 85 to 88, processes substantially the same as or similar to those illustrated with respect to FIGS. 36 to 39 may be performed, that is, an isotropic etching process may be performed to form a sixth insulating interlayer pattern 445.

During the isotropic etching process, the channel 385 may be protected by the first capping pattern 395 on the upper surface thereof.

Referring to FIGS. 77 to 80, processes substantially the same as or similar to those illustrated with respect to FIGS. 40 to 68 and FIGS. 1 to 6 may be performed to complete the fabrication of the semiconductor device.

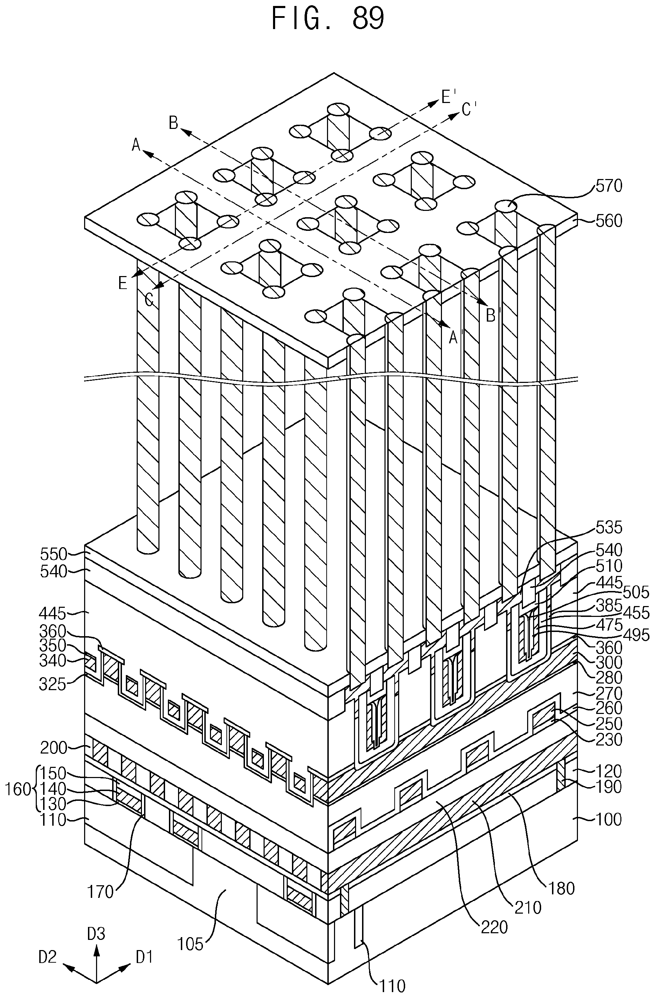

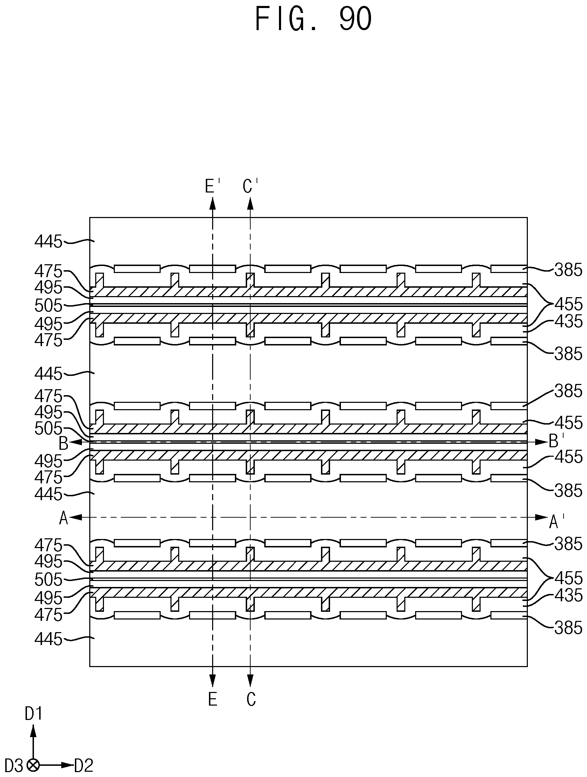

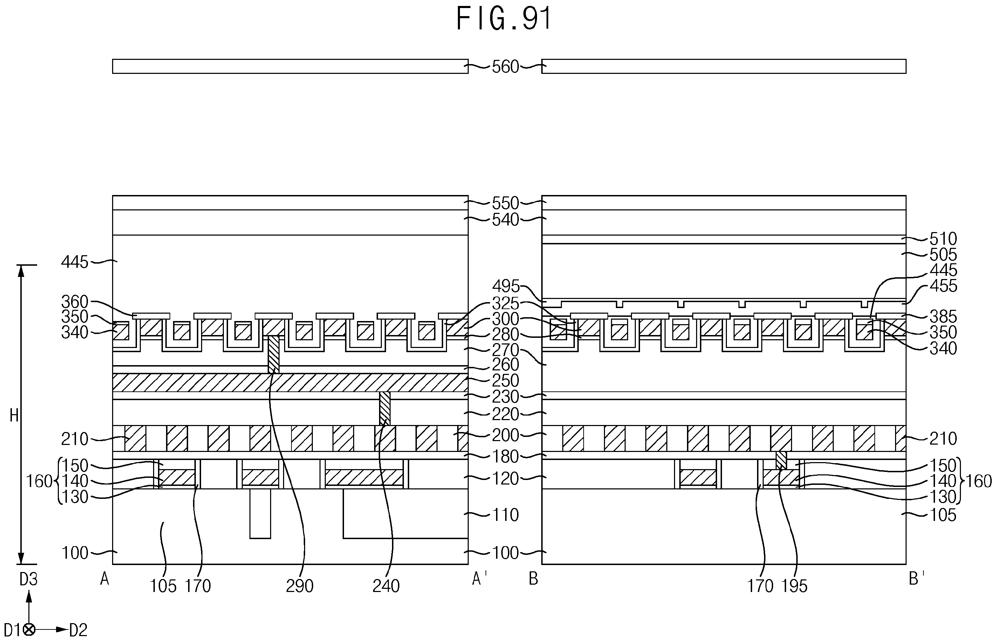

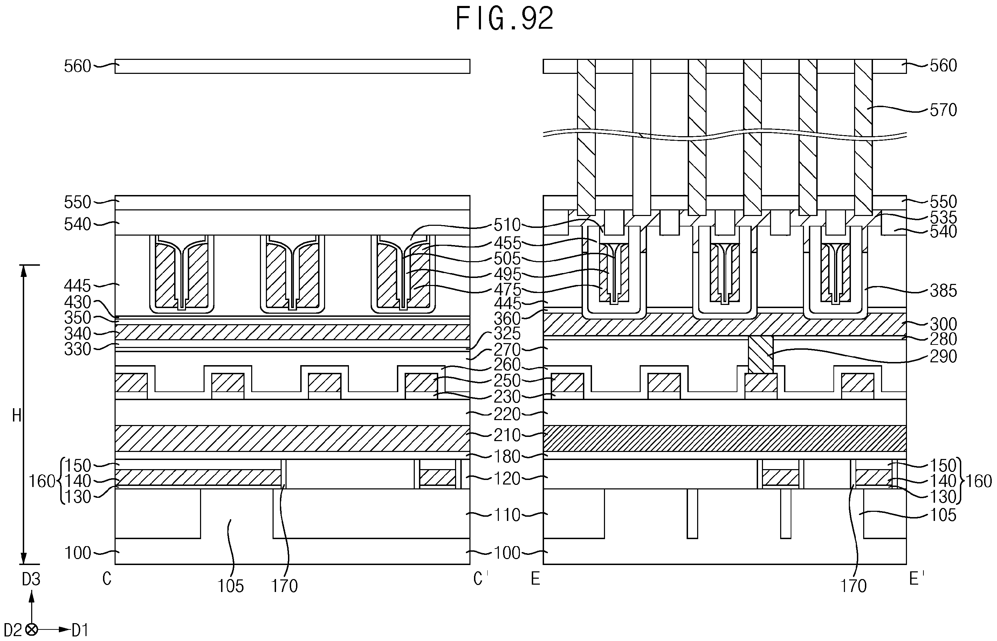

FIGS. 89 to 92 are a perspective view, a horizontal cross-sectional view and vertical cross-sectional views illustrating a semiconductor device in accordance with example embodiments, which may correspond to FIGS. 77 to 80, respectively.

This semiconductor device may be substantially the same as or similar to that of FIGS. 77 to 80, except for some elements, and thus repeated explanations are omitted herein.

Referring to FIGS. 89 to 92, the semiconductor device may not include the first capping pattern 395.

Thus, all of opposite sidewalls in the first direction D1 of the channel 385 and opposite sidewalls in the second direction D2 of the channel 385 may contact the sixth insulating interlayer pattern 445.

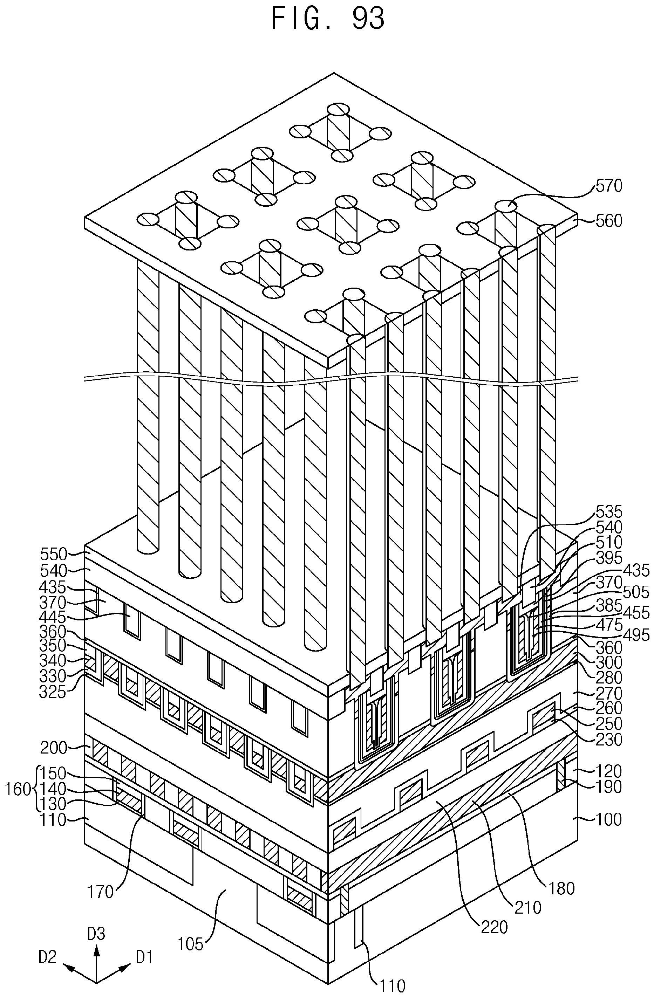

FIG. 93 is a perspective view illustrating a semiconductor device in accordance with example embodiments, which may correspond to FIG. 1.

This semiconductor device may be substantially the same as or similar to that of FIGS. 1 to 4, except for some elements, and thus repeated explanations are omitted herein.

Referring to FIG. 93, in the semiconductor device, a plurality of first molds 370 may be spaced apart from each other in the first direction D1, and each of the first molds 370 may include a lower portion extending in the second direction D2 and a plurality of upper portions spaced apart from each other in the second direction D2. The eighth insulation pattern 360 may also extend in the second direction D2 under the first mold 370, and an upper surface of the seventh insulation pattern 350 under the eighth insulation pattern 360 may not contact a lower surface of the first mold 370.

The semiconductor device of FIG. 93 may be a variation of the semiconductor device of FIGS. 1 to 4 by forming each of the first molds 370 to extend in the second direction D2, instead of forming a plurality of first molds 370 spaced apart from each other in each of the first and second directions D1 and D2, and the inventive concept may not be limited thereto. For example, a semiconductor device of a variation of any of the semiconductor device of FIGS. 69 to 72, FIG. 72, FIGS. 77 to 80 or FIGS. 89 to 92 may be in the scope of the present invention.

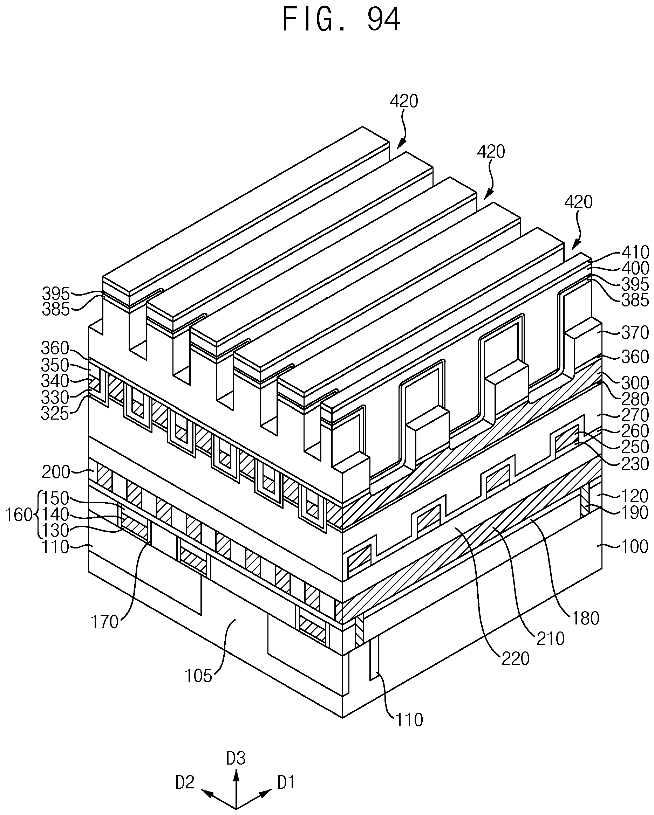

FIGS. 94 to 98 are perspective views illustrating a method of manufacturing a semiconductor device in accordance with example embodiments.

This method may include processes substantially the same as or similar to those illustrated with respect to FIGS. 5 to 68 and FIGS. 1 to 4, and thus repeated explanations thereof are omitted herein.

Referring to FIG. 94, processes substantially the same as or similar to those illustrated with respect to FIGS. 5 to 27 may be performed.

However, the opening 420 may extend through only an upper portion of the first mold 370, and thus only the upper portion of the first mold 370 may be divided into a plurality of parts spaced apart from each other in the second direction D2, and a lower portion of the first mold 370 may not be divided but may extend in the second direction D2. Thus, the opening 420 may not extend through the eighth insulation pattern 360, and may not expose an upper surface of a portion of the seventh insulation pattern 350 under the eighth insulation pattern 360.

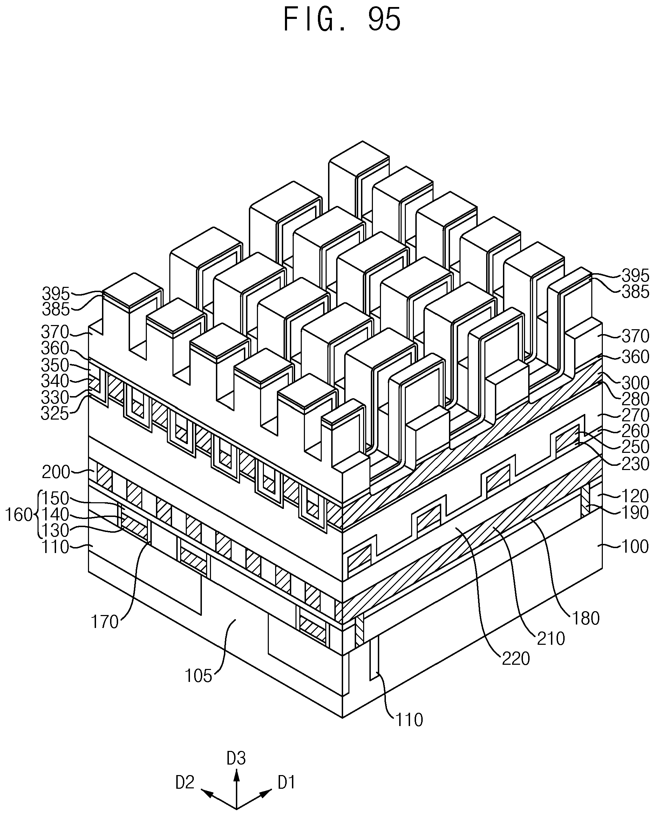

Referring to FIG. 95, processes substantially the same as or similar to those illustrated with respect to FIGS. 28 to 31 may be performed to expose an upper surface of the first capping pattern 395.

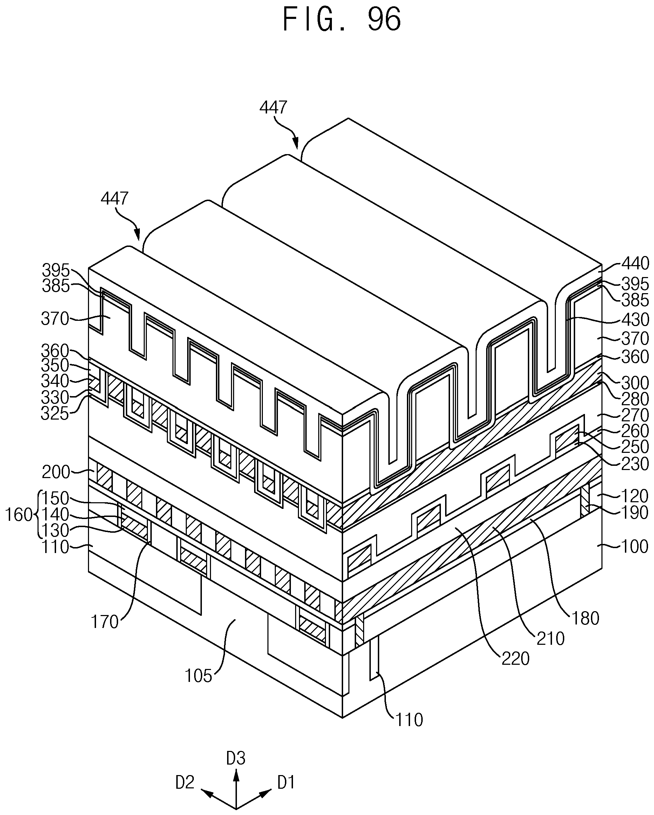

Referring to FIG. 96, processes substantially the same as or similar to those illustrated with respect to FIGS. 32 to 35 may be performed to form the second capping layer 430, and the sixth insulating interlayer 440 may be formed on the second capping layer 430.

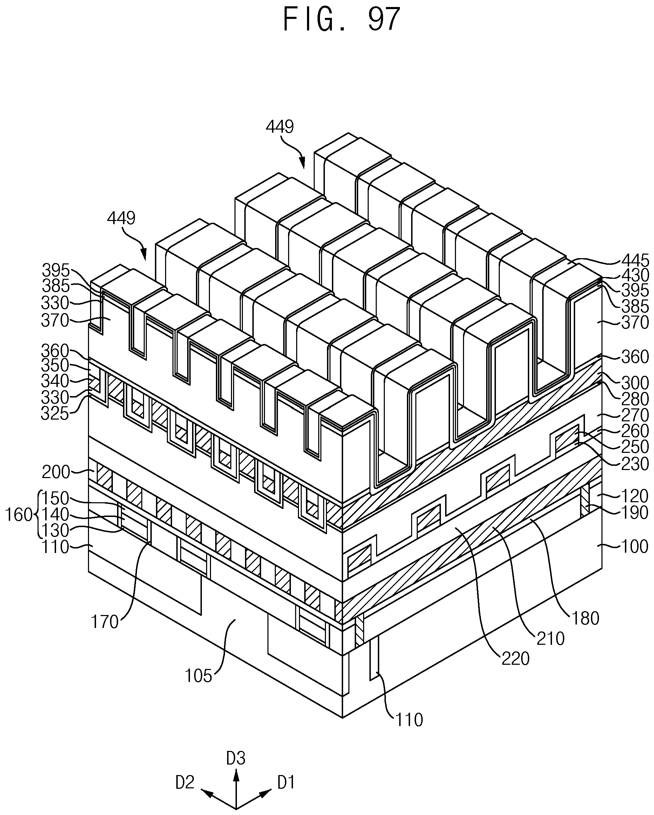

Referring to FIG. 97, processes substantially the same as or similar to those illustrated with respect to FIGS. 36 to 39 may be performed to form the sixth insulating interlayer pattern 445, and the second recess 447 may be enlarged to the third recess 449 having width and depth greater than those of the second recess 447.

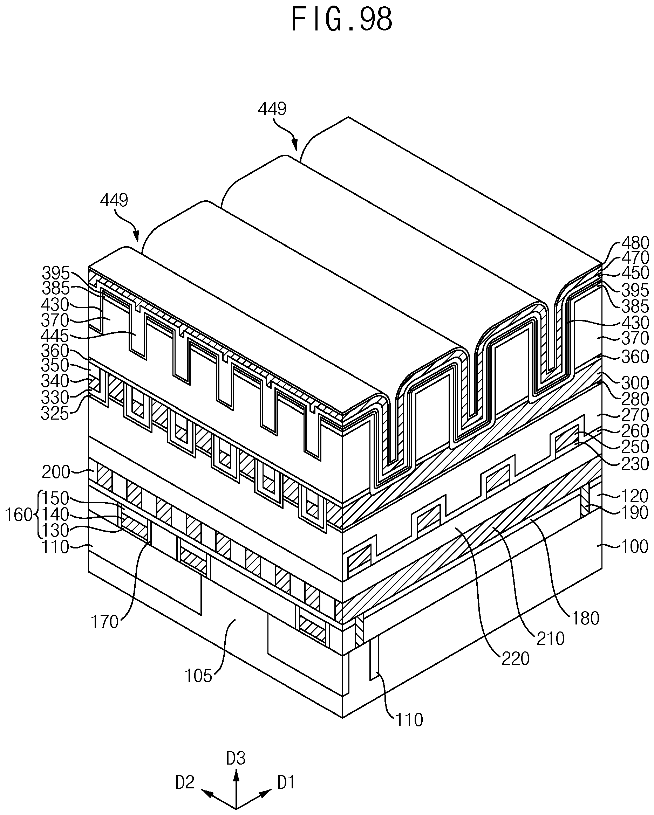

Referring to FIG. 98, processes substantially the same as or similar to those illustrated with respect to FIGS. 40 to 47 may be performed so that the second gate insulation layer 450, the second gate electrode layer 470 and the third capping layer 480 may be sequentially formed.

Referring back to FIG. 93, processes substantially the same as or similar to those illustrated with respect to FIGS. 48 to 68 and FIGS. 1 to 4 may be performed to complete the fabrication of the semiconductor device.

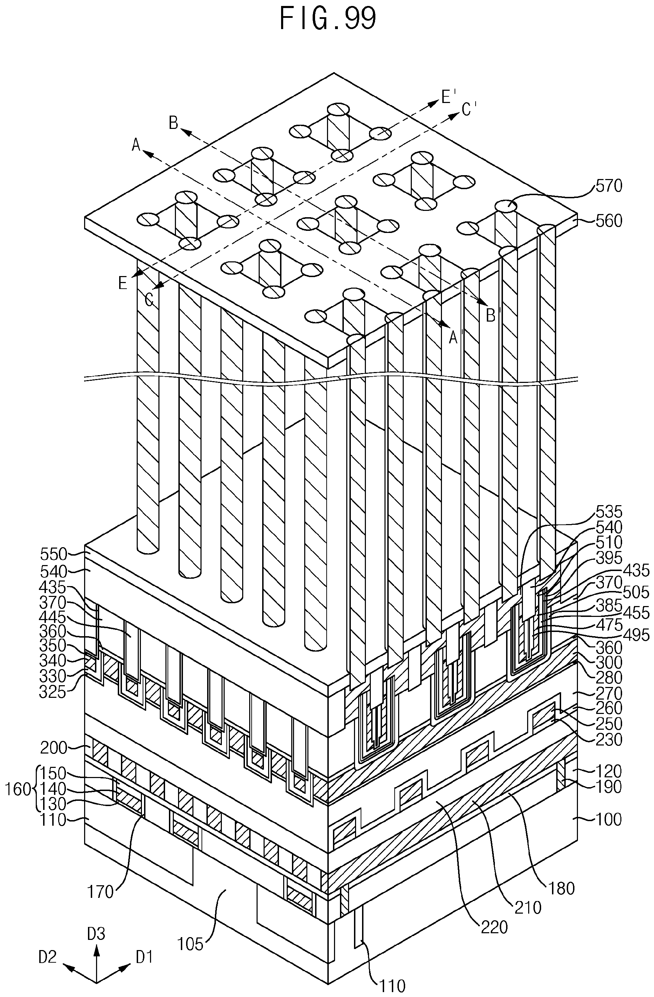

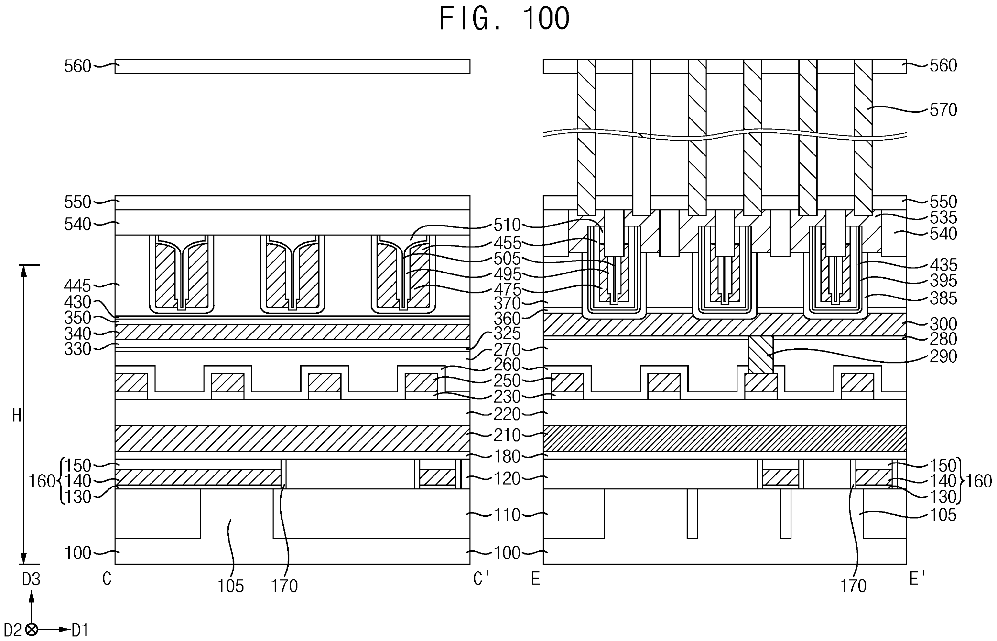

FIGS. 99 and 100 are a perspective view and a vertical cross-sectional view illustrating a semiconductor device in accordance with example embodiments, which may correspond to FIGS. 1 and 4.

This semiconductor device may be substantially the same as or similar to that of FIGS. 1 to 4, except for some elements, and thus repeated explanations are omitted herein.

Referring to FIGS. 99 and 100, an upper surface of the first mold 370 adjacent to the channel 385 and a lower surface of the landing pad 535 thereon may be substantially coplanar with an uppermost surface of the channel 385, and a lower surface of the eighth insulating interlayer pattern 540 may be lower than an uppermost surface of the channel 385.

Additionally, the eighth insulating interlayer pattern 540 may extend through the fourth capping pattern 510, and upper portions of the seventh insulating interlayer pattern 505 and the etch stop pattern 495.

The semiconductor device may be manufactured by removing an upper portion of the first mold 370 to form a seventh recess exposing an upper sidewall of the channel 385, before removing the upper portion of the channel 385 to form the fifth recess through the processes illustrated with reference to FIGS. 63 to 65, removing the upper sidewall of the channel 385 to enlarge the seventh recess, and forming the landing pad layer 530 in the enlarged seventh recess.

The eighth insulating interlayer pattern 540 may have a lower surface lower than that of the landing pad layer 530 so as to divide the landing pad layer 530, and the eighth insulating interlayer pattern 540 may extend through the fourth capping pattern 510 and upper portions of the seventh insulating interlayer pattern 505 and the etch stop pattern 495.

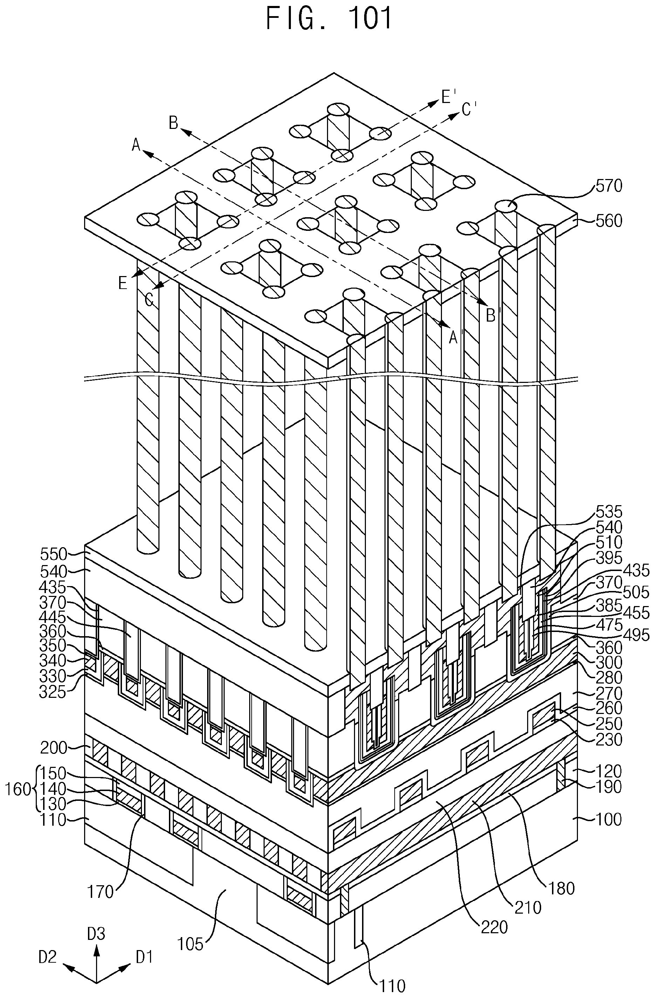

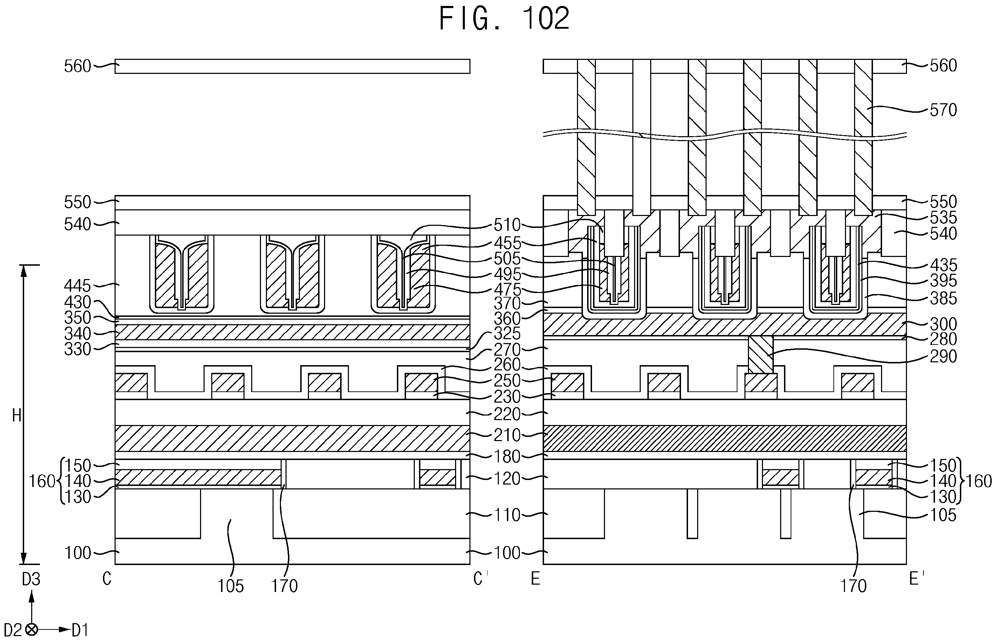

FIGS. 101 and 102 are a perspective view and a vertical cross-sectional view illustrating a semiconductor device in accordance with example embodiments, which may correspond to FIGS. 1 and 4.

This semiconductor device may be substantially the same as or similar to that of FIGS. 99 to 100, except for some elements, and thus repeated explanations are omitted herein.

Referring to FIGS. 101 and 102, a lower surface of a portion of the landing pad 535 contacting an upper surface of the first mold 370 may be higher than a lower surface of a portion of the landing pad 535 contacting an uppermost surface of the channel 385.

This semiconductor device may be manufactured by forming the channel 385 such that the uppermost surface of the channel 385 may be lower than the upper surface of the first mold 370, when the upper sidewall of the channel 385 exposed by the seventh recess is removed, after forming the seventh recess to expose the upper surface of the channel 385.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms first, second, etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
bit lines on a substrate, wherein each of the bit lines extends in a first direction substantially parallel to an upper surface of the substrate, and wherein the bit lines are spaced apart from each other in a second direction substantially parallel to the upper surface of the substrate and intersecting the first direction;
channels on each of the bit lines, wherein the channels are spaced apart from each other in the first direction;
a first capping pattern on a sidewall of each of the channels;
a gate insulation pattern on a sidewall of the first capping pattern;
a gate electrode on a sidewall of the gate insulation pattern; and
capacitors that are electrically connected to respective ones of the channels.

2. The semiconductor device according to claim 1, further comprising a second capping pattern on the first capping pattern.

3. The semiconductor device according to claim 2, wherein the second capping pattern is between the first capping pattern and the gate insulation pattern.

4. The semiconductor device according to claim 2 or claim 3, further comprising:
molds between ones of the channels,
wherein the molds are on the bit lines, and
wherein the second capping pattern contacts sidewalls of the molds and sidewalls of the channels.

5. The semiconductor device according to any of claims 2-4, further comprising:
bit line shields between the bit lines, wherein each of the bit line shields extends in the first direction; and
first insulation patterns between respective ones of the bit lines and respective ones of the bit line shields.

6. The semiconductor device according to claim 5, further comprising:
molds between ones of the channels, wherein the molds are on the bit lines; and
second insulation patterns on each of the bit line shields, wherein each of the second insulation patterns is between adjacent ones of the molds.

7. The semiconductor device according to claim 6, wherein the second capping pattern extends between the molds and adjacent ones of the second insulation patterns.

8. The semiconductor device according to any of claims 2-7, wherein the first and second capping patterns include substantially a same material.

9. A semiconductor device comprising:
bit lines on a substrate, wherein each of the bit lines extend in a first direction substantially parallel to an upper surface of the substrate, and wherein the bit lines are spaced apart from each other in a second direction substantially parallel to the upper surface of the substrate and intersecting the first direction;
channels on each of the bit lines, wherein the channels are spaced apart from each other in the first direction;
a gate insulation pattern on a first sidewall of each of the channels;
a gate electrode on a sidewall of the gate insulation pattern;
capacitors that are electrically connected to respective ones of the channels;
molds between ones of the channels, wherein the molds contact a respective second sidewall in the first direction of respective ones of the channels; and
a first capping pattern that contacts sidewalls of each of the molds,
wherein sidewalls of each of the channels contact respective ones of the molds.

10. The semiconductor device according to claim 9, further comprising a second capping pattern on the first sidewall of each of the channels,
wherein the second capping pattern contacts the gate insulation pattern.

11. The semiconductor device according to claim 10, wherein the first capping pattern is in contact with sidewalls of the second capping pattern.

12. The semiconductor device according to any of claims 9-11, further comprising:
bit line shields between the bit lines, wherein each of the bit line shields extend in the first direction;
first insulation patterns between respective ones of the bit lines and respective ones of the bit line shields; and
second insulation patterns on each of the bit line shields, wherein each of the second insulation patterns is between adjacent ones of the molds.

13. A semiconductor device according to claim 1,
wherein the first capping patterns contact a respective first side wall of each of the channels, and
wherein the semiconductor device further comprises:
bit line shields between the bit lines, wherein each of the bit line shields extends in the first direction;
molds between ones of the channels, wherein each of the molds contacts a second sidewall of respective ones of the channels;
second insulation patterns on each of the bit line shields, wherein each of the second insulation patterns is between adjacent ones of the molds; and
a second capping pattern on sidewalls of each of the molds, wherein sidewalls of each of the channels contact adjacent ones of the molds.

14. The semiconductor device according to claim 13, wherein the second capping pattern is in contact with sidewalls of the first capping pattern.

15. The semiconductor device according to claim 14, wherein the second capping pattern is in contact with a sidewall of the first capping pattern.
